(19) Europäisches Patentamt
European Patent Office
Office européen des brevets

(11) **EP 1 804 300 A1**

(12) **EUROPEAN PATENT APPLICATION**
published in accordance with Art. 158(3) EPC

(43) Date of publication:
04.07.2007 Bulletin 2007/27

(51) Int Cl.:
*H01L 31/045* (2006.01)   *H01L 51/10* (2006.01)
*H01L 21/8246* (2006.01)   *H01L 27/112* (2006.01)
*G11C 13/00* (2006.01)

(21) Application number: 05783692.6

(22) Date of filing: 08.09.2005

(86) International application number:
PCT/JP2005/017003

(87) International publication number:
WO 2006/035610 (06.04.2006 Gazette 2006/14)

(84) Designated Contracting States:
DE ES FR GB NL

(30) Priority: 09.09.2004 JP 2004262040
24.12.2004 JP 2004375089

(71) Applicant: National University Corporation
Hokkaido University
Sapporo-shi, Hokkaido 0600808 (JP)

(72) Inventor: ISHIBASHI, Akira

(JP)

(74) Representative: Turner, James Arthur
D Young & Co
120 Holborn
London EC1N 2DY (GB)

(54) **FUNCTION ELEMENT, STORAGE ELEMENT, MAGNETIC RECORDING ELEMENT, SOLAR CELL, PHOTOELECTRIC CONVERSION ELEMENT, LIGHT EMITTING ELEMENT, CATALYST REACTION DEVICE, AND CLEAN UNIT**

(57) Memory device is made based upon a structure comprising a lamination of at least two thin pieces each having a periodically laminated configuration of conductive layers (preferably metals) each having a thickness in the range from 0.2 nm to 60 nm, and dielectric layers, each having a thickness larger than the thickness of each the conductive layer, such that the layers cross each other and edges of the conductive layers are opposed to each other. The thickness of said conductive layer is preferably in the range from 0.2 nm to 30 nm, and the thickness of said dielectric is typically in the range from 2 nm to 200/$\mu$m. The recording medium is insulator layer or nano-bridge structure.

Fig. 43

EP 1 804 300 A1

**Description**

TECHNICAL FIELD

This invention relates to a functional device, memory device, magnetic memory device, solar cell, photoelectric conversion device, light emitting device, catalytic device, and clean unit, being, for example, concerned with union or unification of top-down systems with bottom-up systems.

BACKGROUND OF ART

Conventional mainstream functional devices are those manufactured by a top-down approach based upon micro-fabrication, as represented by semiconductor integrated circuits. Especially regarding semiconductor devices, huge semiconductor electronics industry has been established, via inventions of transistors by Bardeen, et al. and inventions of semiconductor integrated circuits by Noyce et al and/or Kilby, et al.

On the other hand, the top-down approach begins to see delimitation in various points. As a technique that breaks the limit, a bottom-up approach by self-organization, etc. has been remarked and studied actively.

Both cell systems and neuron systems have been reported to continuously expand and grow by autonomous dispersion at individual sites (R.R. Llinas, The Biology of the Brain, p.94, W.H. Freeman & Company, NY, 1989). This is classified to bottom-up systems.

In bottom-up systems, individual portions independently build structures according to local rules or interactions that lead to autonomous decentralized systems. It has been demonstrated by using cellular automaton that there are four different types of structure-building schemes (constant, periodically laminated (nested), functionally structured, and random) with respect to time (S. Wolfram, A New Kind of Science, pp. 51-81, Wolfram Media Inc., IL, USA, 2002).

Also with respect to time, especially, based upon the concept of time projection the Inventor, et al. reported an improvement of a time projection chamber (TPC) as an elementary particle detector using secondary electrons continuously moving with time (electrons generated along trajectories of elementary particles), based on constancy of the drift velocity (P. Nemethy, P. Oddone, N. Toge, and A. Ishibashi, Nuclear Instruments and Methods 212 (1983) 273-280).

Useful and interesting physical phenomena have been observed, such as surface strengthening effect by plasmon excitation observed in a nanospace formed by metal interfaces, especially in a local space between a two-dimensional sample plane and an opposed probe (Futamata, et al., Spectroscopical Society of Japan, Lecture Symposium 2002 Spring "The Forefront of Microscopic Vibration Spectroscopy" Lecture Papers, pp.20-23).

The Inventor, et al. has also reported that resolution of a one-atomic layer in the growth direction is obtained in growth of a semiconductor using metal organic chemical vapor deposition (MOCVD) (A. Ishibashi, MOCVD-grown Atomic Layer Superlattices, Spectroscopy of Semiconductor Microstructures, eds. G. Fasol, A. Fasolino, P. Lugli, Plenum Press, NY, 1989).

In electrochemical growth as well, details of the growth mechanism have been known (Shiro Haruyama, Electrochemistry for Surface Engineers, p. 112, Maruzen, Tokyo, 2001).

In the field of electrochemistry, it has been known that macromolecular electrolyte can be deposited on a work by immersing the work and a counter electrode into water containing neutralized polymeric electrolyte and applying d.c. current across the work and the counter electrode (edited by Tsuguo Yamaoka, "New Development of Practical Polymeric Resist Materials, Their Applications as Photopolymers", Chapter 6, CMC Shuppan, 1996).

Also reported has been a structure inserting a molecular element at a crossing point of approximately 40 nm wide metal wires put crosswise (Y. Chen, D.A.A. Ohlberg, X. Li, D.R. Stewart, R.S. Williams, J.O. Jeppesen, K.A. Nielsen, J.F. Stoddart, D.L. Olynick, and E. Anderson, Nanoscale Molecular Switch Devices Fabricated by Imprint Lithography, Appl. Phys. Lett. 82 (2003) 1610).

Further, as another example of bottom-up schemes, there have been proposed a method of building structures by self-organized progressive hierarchical acquisition (SOPHIA) and a method of growing neurons (Japanese Patent Laid-open Publication No. JP2000-216499, Pamphlet of International Publication No. WO02/35616). In addition, there is gene-governed expression of configurations (gene-derived structures) universal to life and biological systems. On the other hand, as other examples of the top-down systems, there are MEMS systems (micro electromechanical systems), microchemical reactors, and building of structures by human brains (brain-derived structures) as homo faber, in general (for example, Takeshi Yoro, "Yuinoron", Seidosha, 1989).

Also, known is nano-bridge structures making use of nano-metal-bridges based upon the migration of metal-atoms in solid-state-electrites (Internet <URL: http://www.nec.co.jp/press/ja/0402/1801-01.htm> [as of 18 Feb. 2004]).

Reports are made on frequency-dependence of magnetic impedance in spin tunnel junctions (Jpn. J. Appl. Phys. Vol.42 (2003)pp.1246-1249).

Also, reported was magnetic memory device that utilizes magnetic sensor as the magnetic head (Jpn Pat. 3557442). A spin -tunnel-junction device is connected to a part of the feedback loop of the transistors and oscillator made of LC-circuits. This device has a switching means. Reading-out speed of magnetic data is determined by the switching frequency of the switches means.

More over, reported are many types of solar cells in which the sun light are shed normally to the pn-junction plane (see for example, D. J. Friedman, J. F. Geisz, S. R. Kurtz, and J. M. Olson, July 1998 · NREL/CP-520-23874).

If we could integrate those top-down systems and bottom-up systems can be integrated, united, or unified it would have been possible to make the best use of both advantages and realize new functional devices not existing heretofore. However, no effective techniques have been proposed actually to the Inventor's knowledge.

It is therefore an object of the present invention to provide a functional device and a magnetic memory device having a high property to make the union of bottom-up systems and top-down systems represented by silicon LSI.

Another object of the present invention is to provide new solar cells, photoelectric conversion devices, light-emitting devices, and catalytic systems, based upon the same elemental structure utilized in the afore-mentioned functional and magnetic memory devices.

Another object of the present invention is, in general, to provide new functional devices, including aforementioned memory device, magnetic memory device, solar cell, photoelectric conversion devices, light-emitting devices, and catalytic systems.

Further objects of the present Invention are to provide a clean unit system and a clean unit which can avoid using conventional clean rooms that, being huge and bulky, needs huge investments to build and large expense to maintain. The clean unit system and clean unit are preferably used to manufacture the aforementioned various functional devices. The clean unit system and clean unit make it possible to solve poor efficiency in space exploitation of the convention clean unit which can be connected in one line to maximize total performance in terms of investments, operation efficiency and effective utilization of area of rooms to perform processes, in correspondence to the total process flow, with high flexibility in low costs and easily.

Aforementioned objects as well as other objects of the present Invention are to be clearly shown using figures and further descriptions in the bellow.

DISCLOSURE OF THE INVENTION

The Inventor has been engaged in earnest studies to solve the above problems involved in the conventional techniques. Summary of the studies is shown below.

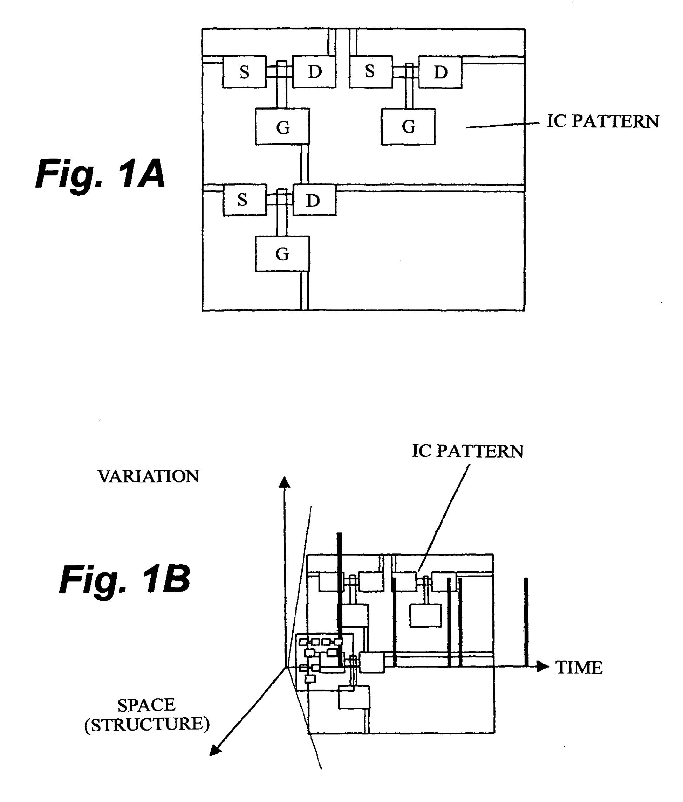

As widely known, two-dimensional patterning by photolithography is often used in the manufacture of semiconductor devices by the top-down approach. Fig. 1A shows MOSLSI (memory, for example) as an example of a semiconductor device. As shown in Fig. 1A, two-dimensional patterning is usually conducted by using UV (ultraviolet) or EUV (extreme ultraviolet) photolithography, or electron beam lithography, at one time at each point of time (instantaneously at each time of each elementary process such as batch exposure, development, etching, and so on, i.e. at individual points on a time axis) under no exchange of information in spatially lateral direction in the surface of the semiconductor substrates. That is, one of large characteristics of two-dimensional patterning is to weave the time into structures discontinuously and sporadically.

In two-dimensional patterning, for example, configuration of a structure is determined by photo-lithography through batch exposure of a photoresist using a photo mask. Therefore, upon building a structure, there is no exchange of information in lateral directions among the in-plane structures. More specifically, causality mainly exists in interaction in the vertical direction relative to a plane (we can call this out-of-plane causality) and not in the in-plane direction. In the two-dimensional patterning, block structures are produced under a global rule provided by photo-lithography as shown in Fig. 1B, and there is a particular directionality for each block. Therefore, the spatial configuration is anisotropic in general from both microscopic and macroscopic viewpoints. In other words, configuration of the structure is determined by extrinsic factors, and it is a just real-spatial expression of a circuit design generated in human-brain. In addition, structural changes on the substrate become a series of pulses in form of a $\delta$ function relative to the time.

Thus, the top-down systems are characterized as an anisotropic (directional) structures which time is projected. Let a system be expressed by t when having time continuous projectivity or spatial isotropy, and let a system be expressed by $\downarrow$ when having time discontinuous projectivity or spatial anisotropy. Then the top-down system can be characterized by (time projectivity, spatial directionality) = $(\uparrow,\uparrow)$, i.e., the system is continuous in time-wise and isotropic in space-wise. In other words, since in a top-down system the time is discontinuously projected and there exists the spatial anisotropy in general, it is well-approximated as (time projectivity, spatial directionality) = $(\downarrow,\downarrow)$.

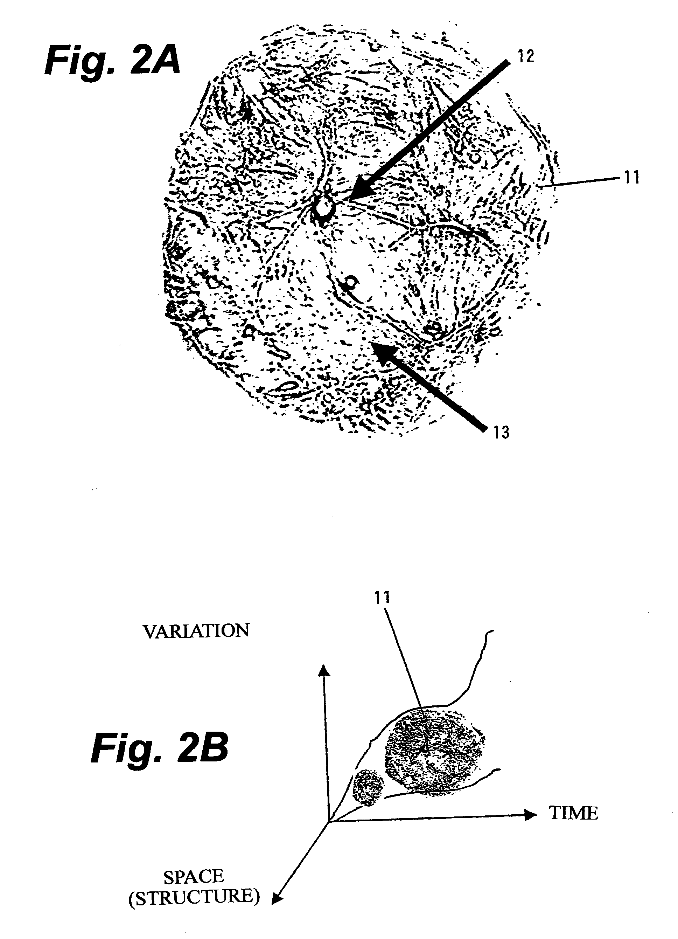

On the other hand, another stream whose importance has been remarked recently is so-called bottom-up systems. The systems include self-organized systems, for example, composed of inorganic substances, such as those represented by semiconductor quantum dots. Growth of cells and neuron systems as shown in Fig. 2A is another example of bottom-up systems in culture of cells of biosystems. In Fig. 2A, reference numeral 11 refers to a living tissue, 12 to a neuron, and 13 to a cell. It has already been well-known that both cell systems and neuron systems continuously enlarge and grow at the each position with time by autonomous dispersion ( R.R. Llinas, The Biology of the Brain, p. 94, W.H.

Freeman & Company, NY, 1989).

As shown in Fig. 2B, in bottom-up structures characterized by the nature of autonomous decentralized systems, the individual subsystems/portions automatically form structures according to the local rules/interactions. Therefore, time is projected (or woven) into the structure continuously. In this case, in a bottom-up structure like vesical epidemic cells having a two-dimensional extension similar to that of Fig. 1A, causality exists in the plane (we call this in-plane causality). As S. Wolfram has shown by using a cellular automaton, there are four different types I to IV (constant, periodically laminated (nested), functionally structured and random) as formation of structures (S. Wolfram, A New Kind of Science, pp. 51-81, Wolfram Media Inc., IL, USA, 2002). In the bottom-up systems, since formation of structures follows local rules/interactions and has no particular directions from the global viewpoint, the spatial configurations usually become, in general, isotropic. In this case, the entire structure is determined by intrinsic factors according to the generation rule. Changes of structures exhibit a smooth continuous line relative to time, i.e., time is projected continuously into structure.

Thus, bottom-up systems are in general at least within an intermediate range isotropic (undirectional) structures to which time is projected continuously. Therefore, according to the above notation, they can be expressed as (time projectivity, spatial directionality) = ($\uparrow$,$\uparrow$).

In general, living organism or life forms adequately combine the bottom-up property based upon the body systemizing property governed by genes and the top-down property based upon governability by brains to realize their integration as a whole. More specifically, the living organism integrate the bottom-up capability in formation of body tissues and the top-down capability by brains by attaching neuron system to cells in the growth of individuals from fertilized eggs through the long course of evolution.

That is, as shown in Fig. 2B, an aggregation of cells experiencing a bottom-up growth enables access to every sites because of the existence of the network, i.e. the neuron system, and commands, controls and information extraction from the brain are executed through the neuron system. It is essential for the living organism as self-organized bodies to have associated neuron systems.

On the other hand, to operate systems effectively, control systems must effect information transfer and controls with much smaller "volumes" than controlled systems. Biosystems can be regarded to attach neuron systems, which are $1+\alpha$ (where $1<\alpha<1$) fractal-dimensional strings, to three-dimensional cell systems. The dimension of transfer and control systems must be always smaller than the dimension of cell systems. The neuron systems are distributed in a three-dimensional development in living matters.

Thus, the living organism integrate different kinds of three-dimensional bottom-up systems called cell systems by so-called minimum set-up through bottom-up, self-similar, lower-dimensional structures called neuron systems to which the lapsed time from generation of fertilize eggs is projected continuously.

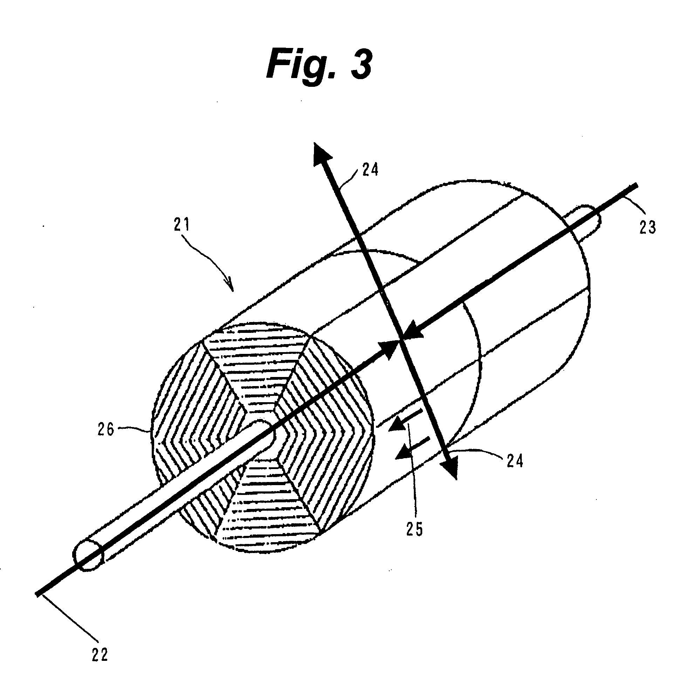

In an artificial system other than the aforementioned living organism, there is a TPC shown in Fig. 3 as a system using continuous projection of the lapsed time on spatial coordinates determining spatial address in three dimensions in the minimum setup including a drum-like container and a gas filling the container, although it is not a rigid solid system. Its development and excellent performance have been reported by the Inventor, et al. (P. Nemethy, P. Oddone, N. Toge, and A. Ishibashi, Nuclear Instruments and Methods 212 (1983)273-280).

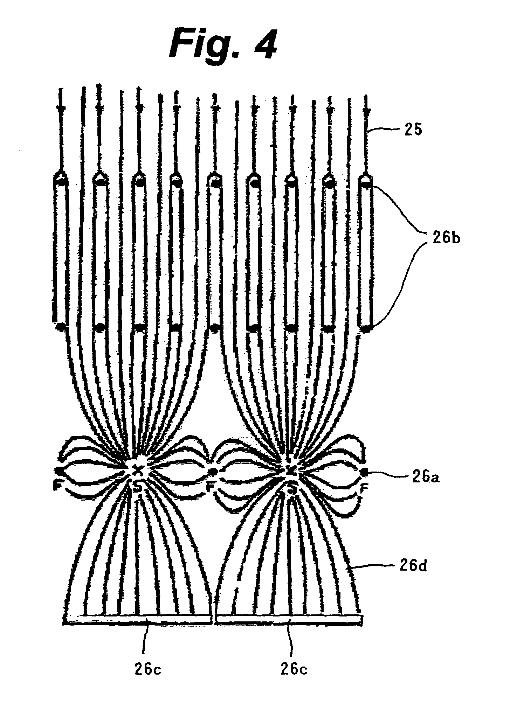

This TPC is explained here in greater detail. As shown in Fig. 3, electron beam 22 and positron beam 23 entering from opposite ends of a gas-contained cylindrical TPC 21 collide with each other and generate a jet of new elementary particles 24. Electrons 25 generated along trajectories of the elementary particles 24 reach two-dimensional detectors called sectors 26 at opposite ends of the TPC 21 at a constant drift velocity in the axial direction. Therefore, positions in the axial direction, i.e. in the z direction, are known from lapsed time to arrival at the sectors 26 from the time of collision. Fig. 4 is an enlarged view of the sector 26. Reference numeral 26a refers to sense wires, 26b to grids, 26c to pads and 26d to lines of electric force. As shown in Fig. 4, electrons induce avalanche at the portion of sense wires 26a, and thereby apply electric signals to the sense wires 26a and the underlying pads 26c. Thus, the positions in the x and y directions are determined. As for the three-dimensional position thus determined, in the position in the z direction projects time information to the space as explained before due to the drift velocity of electrons being constant. Because of this feature, the system is called time projection chamber, and makes an example demonstrating usefulness of the concept of time projection into space.

In the sector 26, states between the sense wires 26a and the pads 26c are read out. That is, a kind of information read is conducted, and it can be regarded as local addressing. The same operation takes place even when wires are placed in a close crossing relation, for example, instead of the pads 26c. Fig. 4 clearly demonstrates how the electric field concentrates near minute electrodes in form of sense wires 26a. The use of thin sense wires 26a is desirable to generate intensive electric field. Thus, TPC has two important features, projection of time to space and concentration of electric field (and accompanied signal amplification) at crossing points of thin structures.

Silicon LSI demonstrating a development along a road map represented by the Moore's law is one of representative of so-called top-down devices and systems, and its limits in size, operation power (environmental temperature) and investment to manufacturing facilities are being talked about. However, while no fundamental solutions are found, the device is anticipated to encounter such limits in a near future.

Bottom-up schemes are being remarked as the antithesis of top-down schemes, but their most serious difficulty is impossibility of or severe difficulty in individual addressing.

In nanoscale, both a function derived from living matters and a function not derived from living matters can be reduced to a common interactive mechanism (ultimately to an electromagnetic interaction). Therefore, nanotechnologies making remarkable progress contains latent importance of integrating non-living matters and living matters, but they have not yet been brought into full-scale practical unification or union.

Manufacturing methods of microstructures on the extension of conventional techniques include those using EUV or electron beam lithography and so-called bottom-up schemes using molecules, for example. However, there are no devices and systems that can couple them and try to find out synergy by the coupling. This is because, according to the above-introduced notation regarding the time-wise and space-wise characteristics, the bottom-up systems expressed by (time projectivity, spatial directionality) = ($\uparrow$,$\uparrow$) and the top-down systems expressed by (time projectivity, spatial directionality) = ($\downarrow$,$\downarrow$) have opposite natures, $\uparrow$ versus $\downarrow$, and it is difficult to find a contact point between them when just straightforwardly put side-by-side, just like incompatibility of oil and water.

Coupling of the nanoscale world and the macroscopic world is the barrier that engineers must break through to couple new effects or functions that will be obtained in future in the field of nanotechnologies to existing silicon-based IT infrastructures and educing synergies. However, it is believed that no one could make satisfactory success in coupling them.

Bottom-up material systems expected to exhibit high potency through nanotechnologies have no scheme enabling individual addressing in such nanoscale, and they have not been brought into systematic practical use.

In artificial bottom-up systems, no one made success in providing a control line accompanying the main body of a bottom-up system, which corresponds to neurons connecting the brain and body tissues. This might have made it difficult heretofore to couple the top-down and bottom-up systems.

The above-explained TPC is a system similar to the neuron system of a living organism in that it has time continuously projected and partly satisfying its feature of growing with time to distribute its structure in a three-dimensional development and making access. It has two important features, namely, continuous time projectivity based upon a constant drift velocity of electrons and three-dimensional access to the entire system, based on signal amplification at crossing points of thin conductive structures. However, since this TPC contains gas inside, it has not been made up as a complete solid device.

As already explained, for the conventional manufacture of two-dimensional structures such as semiconductor integrated circuits (such as memory devices) in the group of top-down systems, patterning by photo-lithography through batch exposure as shown in Fig. 1A is used. In this case, resolution is required in both x and y directions. The accuracy is about 70 nm in the manufacturing level and several nm in the laboratory champion data even in the case of the currently maximum resolution. Furthermore, this accuracy has not been attained for the entire bulk size.

Further, useful and interesting physical phenomena have been observed, such as surface enhancement effect by plasmon excitation observed in a local space between a two-dimensional sample plane and an opposed probe (Futamata, et al., Spectroscopical Society of Japan, Lecture Symposium 2002 Spring "The Forefront of Microscopic Vibration Spectroscopy" Lecture Papers, pp.20-23). There are no systems arranging nanostructures capable of taking charge of such physical phenomena in multiply parallel throughout the bulk size of mm~cm. That is, there are no substances forming nano-discrete bulk-sized structures having dense architectures of nanoscale and enabling individual access.

The above problems can be solved by preparing a coupling intermediate layer or a coupling platform having a nature corresponding to the nature of soap that couples oil and water (amphiphilic property) or a neuron system that couples a cell system and a brain system, and more particularly, by making a configuration in which a bottom-up system and a top-down system are coupled by an artificial neuron-equivalent system.

More specifically, the problems can be solved by inserting a system having the nature of (time projectivity, spatial directionality) = ($\uparrow$,$\downarrow$) as the third structure between a bottom-up system of (time projectivity, spatial directionality) = ($\uparrow$,$\uparrow$) and a top-down system of (time projectivity, spatial directionality) = ($\downarrow$,$\downarrow$). For this purpose, an accompanying line corresponding to a neuron system is provided in an artificial bottom-up system. Alternatively, a self-organized system is grown near an accompanying system prepared beforehand.

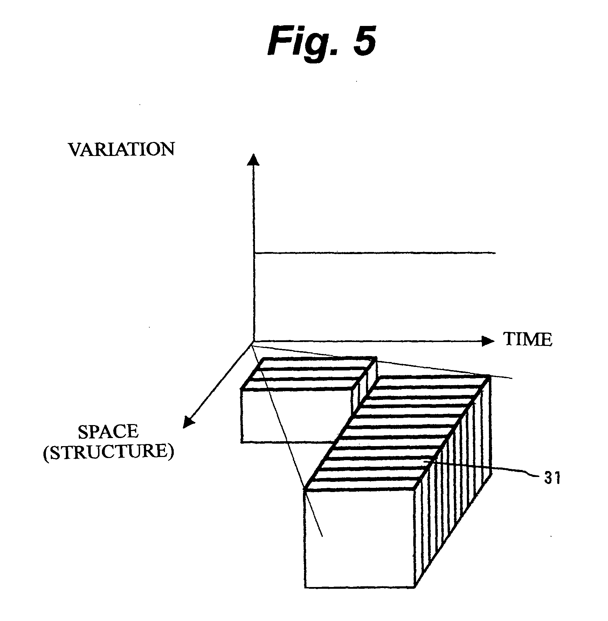

As shown in Fig. 5, growth of a one-dimensional superlattice 31 is brought about with time projected. Since the spatial coordinate in the growth direction of the one-dimensional superlattice 31 exhibits the flow of time directly, this can be regarded as a system in which time is projected continuously to the spatial structure along the growth direction. By using a controlled growth rate, or more preferably, a constant growth rate, the spatial structure is controlled continuously by time (coordinate). In addition, the spatial structure is anisotropic in that there are alternating hetero-layers along the growth direction.

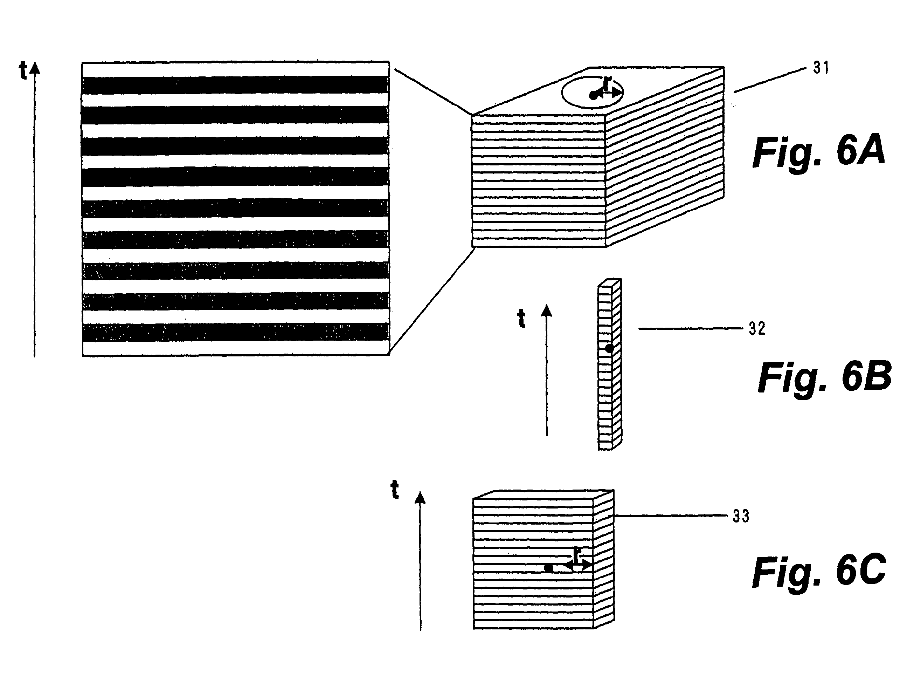

The one-dimensional superlattice 31 grown in this manner is processed into thin pieces. Its significance lies in the following points. Fig. 6A shows the one-dimensional superlattice 31. Fig. 6B shows a superlattice wire 32 processed from the one-dimensional superlattice 31. Fig. 6C shows a superlattice thin piece 33 processed from the one-dimensional superlattice 31. As shown in Figs. 6A, 6B and 6C, the one-dimensional superlattice 31 certainly has a structure weaving time t therein into the growth direction. However, to access time (equals a point on the axis in the growth direction), even with designation of distance r, there are infinite in-plane coordinates (Fig. 6A). In the case where the one-dimensional superlattice 31 is processed into a wire, when time (equals a point on an axis in the growth direction) is designated, the portion, which is a quantum dot, cannot be accessed from other points (Fig. 6B). In contrast, in the case where the one-dimensional superlattice 31 is processed into a thin piece, the position can be determined definitely, and another point (spot) distant by r is determined definitely and can be accessed from there through the lateral line (Fig. 6C). Thus, by processing the one-dimensional superlattice 31 into a thin piece, a system having the nature of $(\uparrow,\downarrow)$ can be realized.

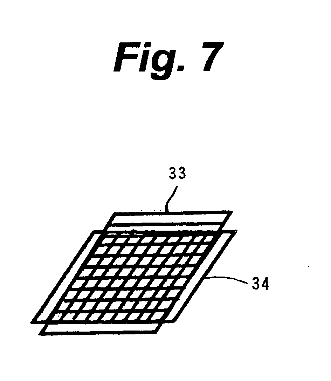

Further, as shown in Fig. 7, the two-dimensional superlattice thin piece 33 is superposed on another similar superlattice thin film 34, or vice versa, with a difference in orientation by an angle, for example, 90 degrees. By stacking two superlattice thin pieces, quasi (discrete) isotropy is recovered, and a cartesian coordinate is formed simultaneously. Thereby obtained is a scheme permitting access to a space discretely as well as densely in nanoscale. With this, a mechanism corresponding to a neuron system that individually addresses an entirely continuous arbitrary(2-dimensional) bottom-up system can be made artificially.

While the bottom-up system shown in Figs. 2A and 2B has an isotropic (non-directional) structure on which time is continuously projected (let it be a first structure) and the top-down system shown in Figs. 1A and 1B has an anisotropic (directional) structure on which time is projected discontinuously (let it be a second structure), the structure shown in Fig. 7 has their in-between nature, and exhibits an anisotropic configuration on which time is projected continuously (let it be a third structure) . That is, the third structure shares the time continuity with the bottom-up system and shares the spatial anisotropy with the top-down system. Therefore, the third structure has good affinity to both the bottom-up system and the top-down system, and can couple or unite the two structures (which have therefore not been coupled heretofore), one having time continuous projectivity and spatial isotropy, i.e. the nature of $(\uparrow,\uparrow)$ and the other having time discontinuous projectivity and spatial anisotropy, i.e. the nature of $(\downarrow,\downarrow)$.

Moreover, as shown in Fig. 7, the third structure by piling/overlaying two thin superlattice pieces can recover discrete isotropy (quasi-isotropy) and can fully access to a bottom-up system in a two dimensional mode.

Furthermore, as already explained, although two-dimensional structures in the category of the top-down systems, such as semiconductor integrated circuits, which rely on patterning by batch exposure, are required to satisfy a good resolution in both x and y directions, and the accuracy remains several nm even in the current maximum resolution, the portion of the third structure can have the resolution of an atomic layer because it is formed by the technique that projects time to space as manifested in vacuum evaporation technique. Therefore, even when the bottom-up portion is composed of units of a molecular level size, individual access to them is possible in the present invention.

As a technique for overcoming the limit of resolution in the conventional lithography, the use of self-organization is being examined. For example, in two-dimensional memory using quantum dots and simple molecules made by self-organization, layout with accuracy in the order of several angstroms is possible. However, there are no ways to independently access to these self-organized microstructures. Trial to external access by metal wire, for example, which is made by lithography, will not satisfy the requirement of resolution as already explained.

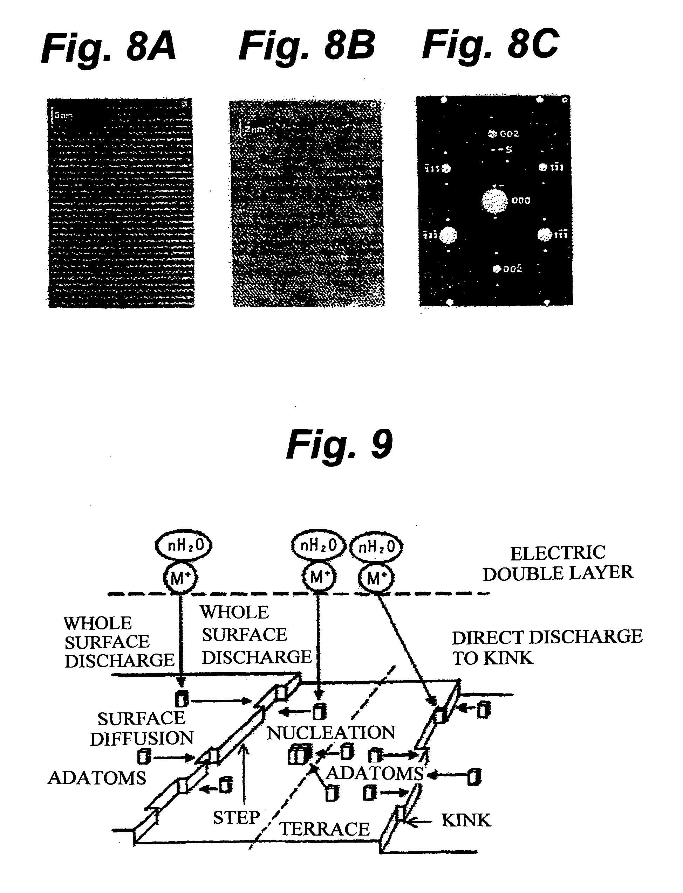

That is, conventional lithography used in top-down systems cannot attain resolution in the order of one atomic layer, and independent access is impossible by the use of bottom-up systems alone (even though resolution might be acceptable). However, by using a structure prepared by forming a block structure controlled in growth rate of one-dimensional superlattice and projecting time to space, then processing it into thin pieces and minimizing the freedom of directionality, like the aforementioned superlattice thin piece 33, it is possible to complementarily couple top-down systems and bottom-up systems and thereby accomplish both resolution in the order of inter-atomic spacing and independent one-to-one access. As already reviewed, the Inventor formerly reported that resolution of one atomic layer can be obtained in the growth direction in growth of AlAs/GaAs two-atomic layer superlattice by MOCVD method as shown in Figs. 8A through 8C (A. Ishibashi, MOCVD-grown Atomic Layer Superlattices, Spectroscopy of Semiconductor Microstructures, eds. G. Fasol, A. Fasolino, P. Lugli, Plenum Press, NY, 1989). Figs. 8A, 8B and 8C show a dark field image, lattice image and diffraction pattern by transmission electron microscope (TEM), respectively.

As already discussed, growth mechanism by MOCVD essentially comprises surface diffusion and kink growth like electrochemical growth mechanism shown in Fig. 9 (Shiro Haruyama, Electrochemistry for Surface Engineers, p. 112, Maruzen, Tokyo, 2001). Therefore, it is possible to grow one-dimensional superlattice as a function of time by using the electrochemical technique as well. That is, the one-dimensional superlattice directly expressing a continuous flow of time as shown in Fig. 6A can be grown by using the electrochemical technique, and spatial structure can be controlled by continuous time coordinates. As compared with the control of spatial structure at discrete points on a time axis, such as batch exposure, development and etching shown in Figs. 1A and 1B, improvement of resolution by one or more digits is possible.

Therefore, the above method can form a fine, discrete and dense repeated structure, such as a repeated structure of metal or other conductor strips and dielectric elements, with atomic layer accuracy.

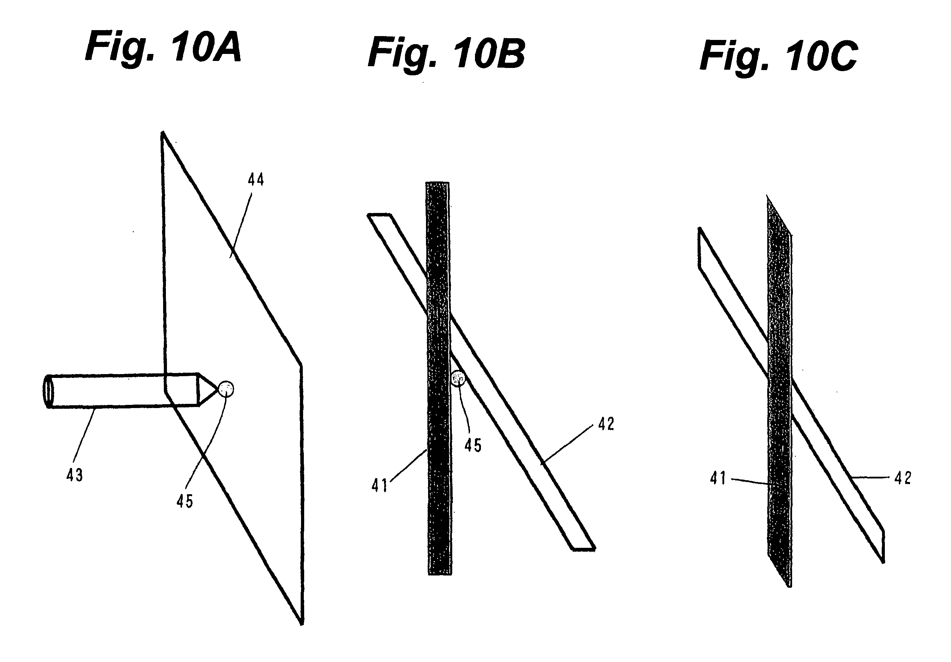

In the case of forming the third structure in form of such a repeated structure of conductor strips and dielectric elements, it is desirable that the conductor strips 41, 42 intersect to oppose their knife edges to each other and make a very small area at the intersection (edge-to-edge configuration) as shown in Fig. 10B rather than opposing their planes to each other to make a large area at the intersection (face-to-face configuration) as shown in Fig. 10C. In case of Fig. 10B, thickness of the conductor strips 41, 42 is in the order of 1~10 nm, for example. In this case, thickness of the dielectric element isolating the conductor strips 41 or conductor strips 42 is in the order of 10~100 nm, for example. In Fig. 10B, reference numeral 45 denotes a pseudo zero-dimensional space (quantum cross) in the order of 1~10nm, for example.

Why the configuration of Fig. 10B is desirable is explained below.

Fig. 10A shows a layout of SPM (surface probe microscope) proved to exhibit surface strengthening effect by a local electric field, in which the tip of a probe 43 is positioned close to the surface 44 (two-dimensional plane) of a sample. Spatial distributions of potential in a nanospace is calculated for different cases of Fig. 10A and Fig. 10B, respectively.

In case of Fig. 10A, can be calculated by regarding that probes are opposed to each other, while taking mirroring effect into account. In this setup, distance between probes equals the distance between the conductor strips 41 and the conductor strip 42 in Fig. 10B at their intersection for comparison purposes. Assuming here that a metallic structure exists in a vacuum and the potential of the metal portion is set from outside, then spatial electric charge is zero, and the Poisson equation to be solved here is simplified to the Laplace equation,

$$(\partial^2/\partial x^2 + \partial^2/\partial y^2 + \partial^2/\partial z^2)\phi(x,y,z) = 0 \qquad (1)$$

When the space is divided to meshes (distance $\Delta$) and expressed by a difference equation, for the potential $\phi(i,j,k)$, calculation progresses as follows.

$$\partial\phi(i,j,k)/\partial x = (\phi(i,j,k)-\phi(i-1,j,k))/\Delta$$

$$\partial\phi(i,j,k)/\partial y = (\phi(i,j,k)-\phi(i,j-1,k))/\Delta$$

$$\partial\phi(i,j,k)/\partial z = (\phi(i,j,k)-\phi(i,j,k-1))/\Delta$$

For example, regarding x, calculation progresses as follows.

$$\partial^2\phi/\partial x^2 = (\phi'(i+1,j,k)-\phi'(i,j,k))/\Delta$$
$$= ((\phi(i+1,j,k)-\phi(i,j,k))/\Delta-(\phi(i,j,k)-\phi(i-1,j,k))/\Delta)/\Delta$$
$$= (\phi(i+1,j,k)+\phi(i-1,j,k)-2\phi(i,j,k))/\Delta^2$$

Similarly, when $\partial^2\phi/\partial y^2$ and $\partial^2\phi/\partial z^2$ are calculated and introduced for substitution into Equation (1), it is rewritten to:

$$0= (\phi(i+1,j,k)+\phi(i-1,j,k)-2\phi(i,j,k))/\Delta^2$$
$$+ (\phi(i,j+1,k)+\phi(i,j-1,k)-2\phi(i,j,k))/\Delta^2$$
$$+ (\phi(i,j,k+1)+\phi(i,j,k-1)-2\phi(i,j,k))/\Delta^2$$

From the above, solution of the Laplace equation is obtained by revolving the following recurrence formula.

$$\phi(i,j,k)=(\phi(i+1,j,k)+(\phi(i-1,j,k)$$
$$+\ (\phi(i,j+1,k)+\ \phi(i,j-1,k)+\ \phi(i,j,k+1)+\ \phi(i,j,k-1))/6$$

$$(2)$$

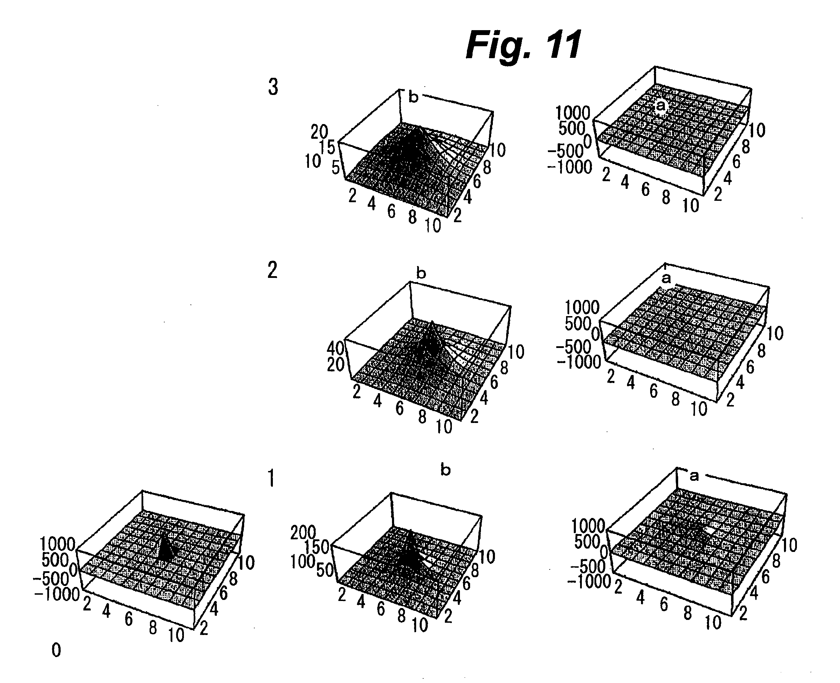

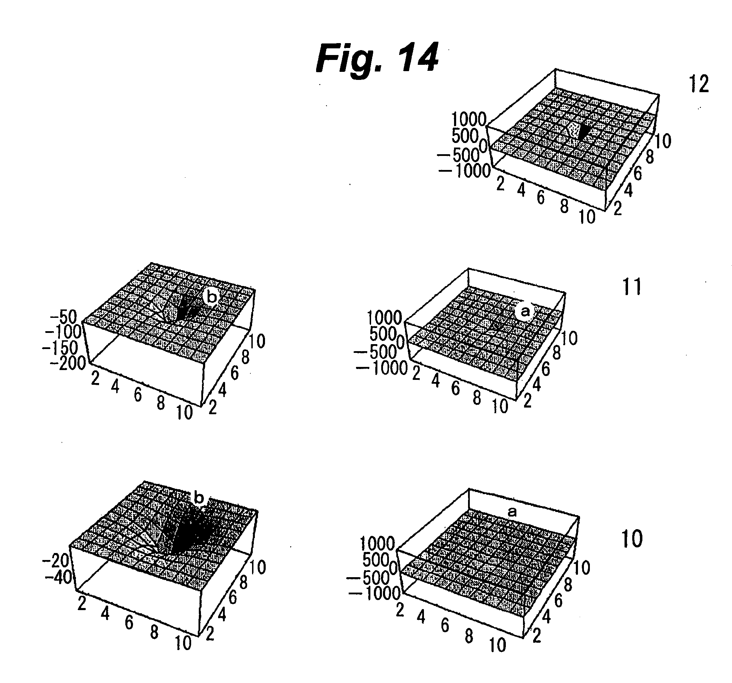

By progressing the calculation by using Equation (2) and introducing the boundary conditions for the configuration of Fig. 10A, potential distributions shown in Figs. 11 through 14 are obtained. In Figs. 11 through 14, numerals 1 through 12 represent spatial coordinates between the tips of the probes, among which 0 and 12 are positions of the probe tips. In Figs. a of Figs. 11 through 14, the z-axis is fixed in the full scale 1000 (arbitrary unit). In Figs. b, the vertical axis is drawn by conducting scaling depending upon the potential level.

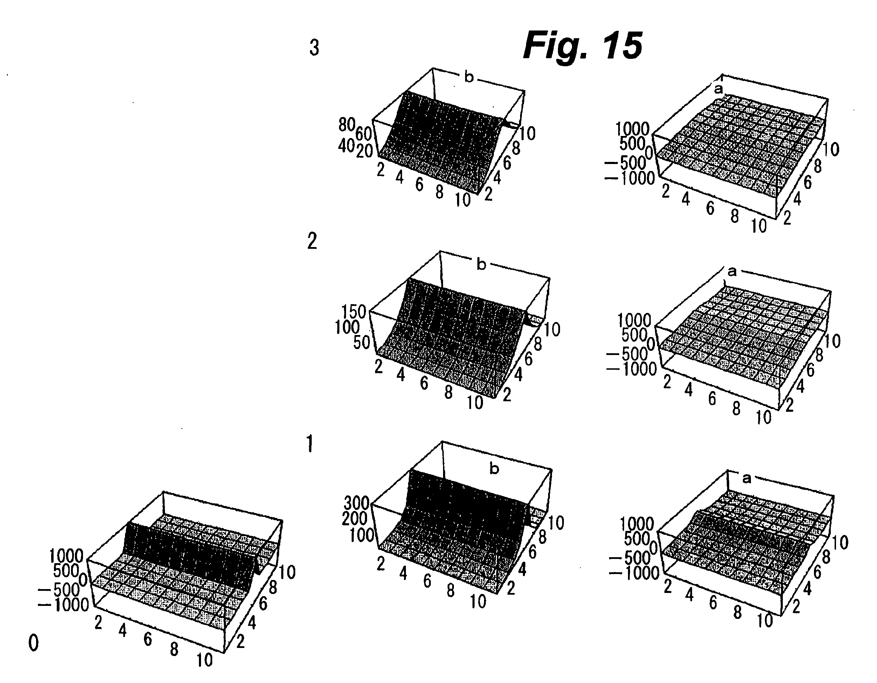

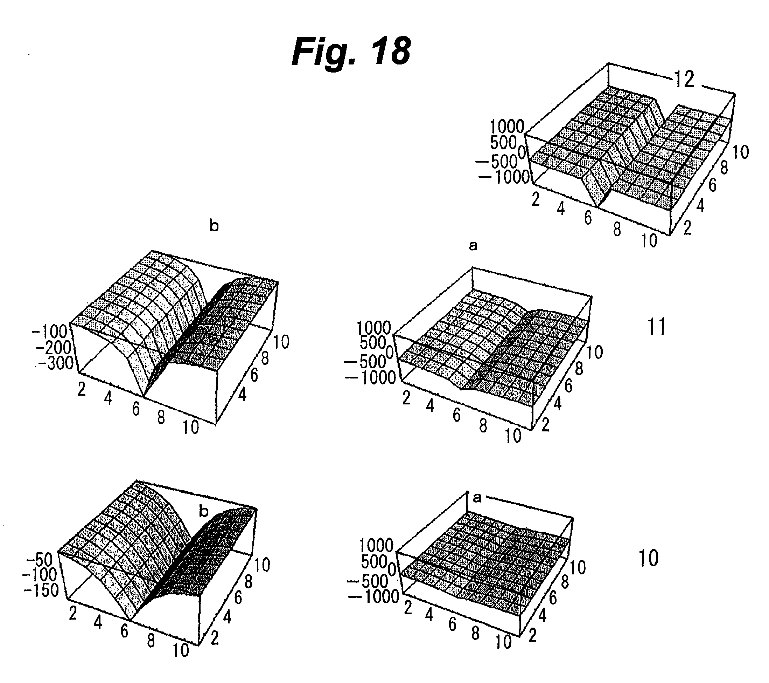

Similarly, calculation is conducted for the case of Fig. 10B where knife edges of the conductor strips 41, 42 are opposed to each other, potential distributions shown in Figs. 15 through 18 are obtained. In Figs. 15 through 18 as well, numerals represent spatial coordinates between knife-edges of the conductor strips 41, 42, and numerals 0 and 12 are positions of the tips of the knife-edges. In addition, like the above explanation, the z axis is fixed in the full scale 1000 (arbitrary unit) in Figs. a of Figs. 15 through 18, In Figs. b, the vertical axis is drawn by conducting scaling depending upon the potential level.

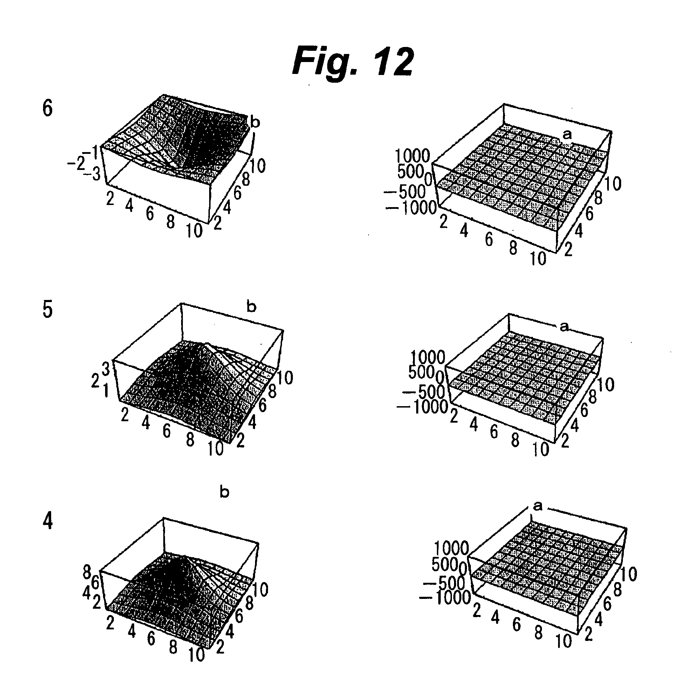

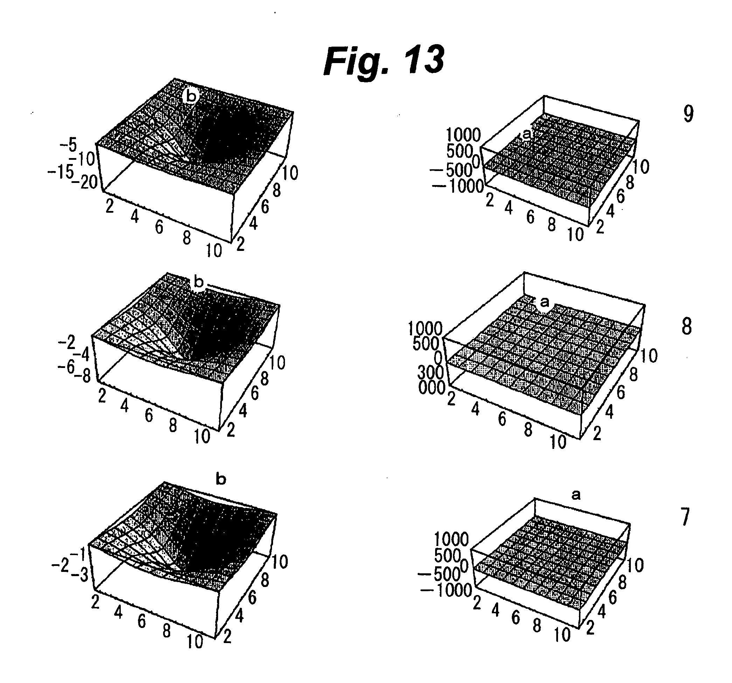

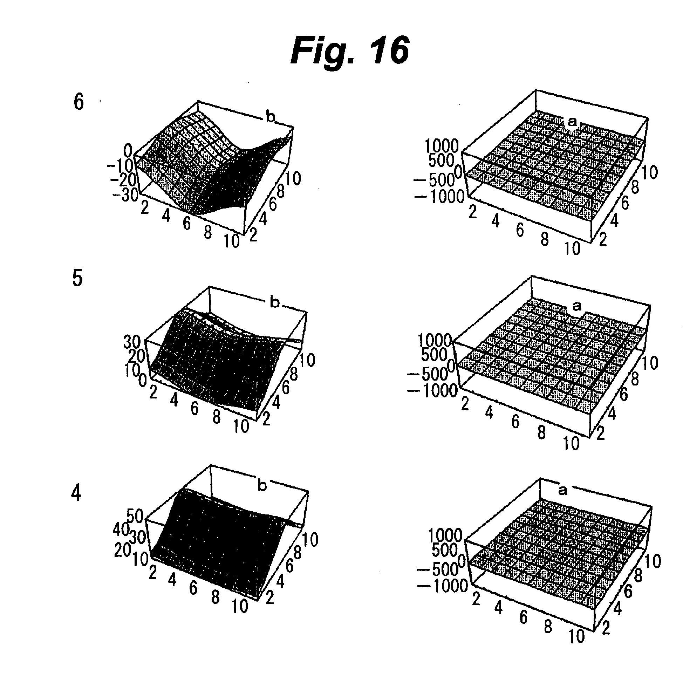

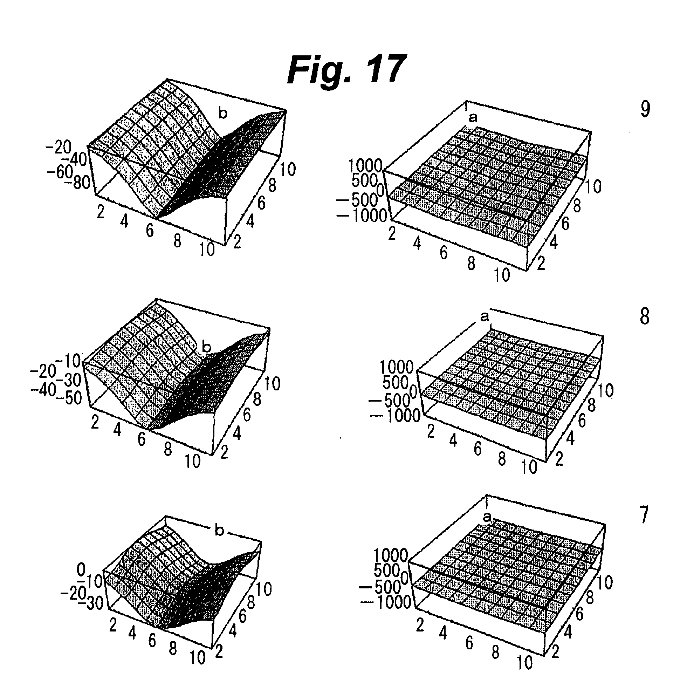

By comparison between Figs. 11 through 14 and Figs. 15 through 18, analogous potential changes, i.e. sharp changes in electric field, are recognized near intermediate points both in the case shown in Fig. 10A and in the case shown in Fig. 10B, reflecting that the cross-sectional area of the intersection is zero dimension. However, through comparison between the amount of change from No. 5 of Fig. 12 to No. 7 of Fig. 13 and the amount of change from No. 5 of Fig. 16 to No. 7 of Fig. 17, it is suggested that the change in electric field per unit length is larger and more quantum effect can be induced even by application of a common potential in the configuration where knife-edges of the conductor strips 41, 42 are opposed to and crosswise intersecting with each other than in the configuration where the probe tips are opposed to each other.

As shown in Figs. 11 through 14, the potential between the opposed probes is symmetrical along the axis connecting the tips of the probes (in the vertical direction in the drawings), and rotationally symmetrical about the axis. In contrast, in the crosswise intersecting configuration of the knife-edges, the potential exhibits a unique shape similar to a saddle point at around middle point as shown in Figs. 16 and 17. That is, the potential is asymmetric vertically, and has both a two-fold symmetry and constancy against symmetrical operation of $\pi/4$ revolution plus up and down reversal. In other words, the potential has $D_{2d}$ symmetry. These features can be used as good tools for inducing new quantum functions by controlling the configuration of molecules inserted at crosswise intersections and the charging symmetry. Additionally, if the intersection angle is shifted from 90 degrees, breakdown to $D_2$ symmetry is possible.

Further, in the structure shown in Fig. 6C or Fig. 7, if the one-dimensional superlattice 31 is a periodically laminated structure of conductive layers and dielectric layers, and sufficiently reduced in thickness of the conductive layers, the structure shown in Fig. 10B and potential distributions shown in Figs. 15 through 18 can be obtained apparently.

As a result, in the third structure mentioned above, the sites that will induce surface enhancement effect can be aligned in super-densely parallel. One of the greatest merits of this configuration lies in using no movable portions, absolutely unlike a configuration with densely parallel surface probes making a structure with an array of a number of heads of surface probe microscopes. In addition, by using thin superlattice pieces as thin as 1~100 $\mu$m, it is possible to make the conductor strips 41, 42 extremely narrow and to maintain both high conductivity of the conductor strips 41, 42 and surface evenness of the thin pieces.

For example, if a piece of bottom-up substance is provided at the pseudo zero-dimensional space 45 at the intersection between the conductor strips 41, 42 shown in Fig. 10B, it is also possible to obtain new functions by using the conductor strips 41, 42 making the x and y crossing system in the third structure as an artificial neuron-equivalent system and coupling a conventional silicon LSI system, for example, located outside the third structure and the bottom-up substance (for example, Japanese Patent Laid-open Publication No. JP2000-216499 and Pamphlet of International Publication No. WO02/35616).

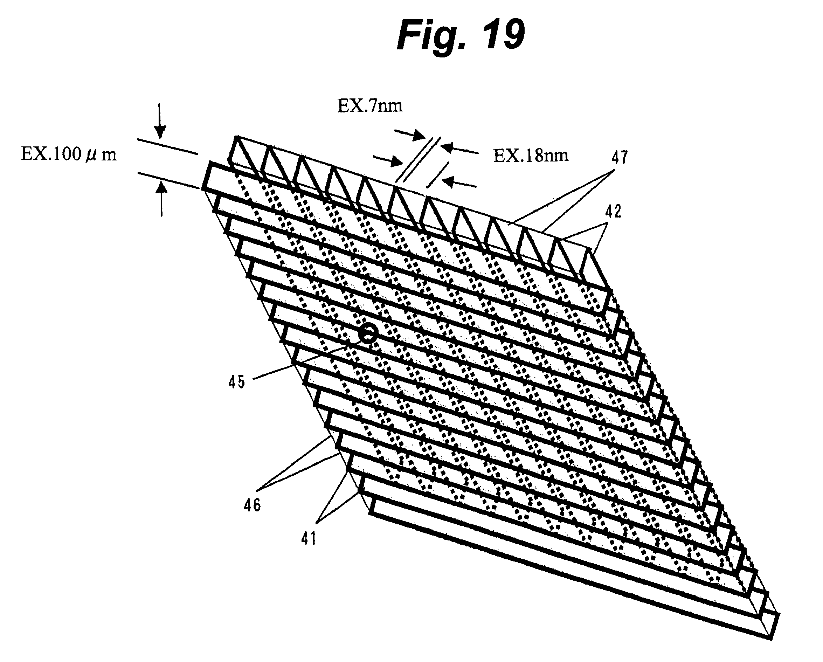

Conductor strips/ribbons 41, 42, and conductor lines in general, use electrons as the medium. Therefore, interaction is transmitted very quickly. On the other hand, the speed of changes in the bottom-up region, and more particularly, the speed of the change in configuration of atoms (such as changes in position of functional groups) are considerably slow because of a large inertial mass. Usually, there is a difference by one or more orders of magnitudes (in general, by several orders of magnitudes) between the speeds of those both. Therefore, the structure shown in Fig. 19, which is an example realizing the configuration conceptually shown in Fig. 7 by using real substances, is a bulk-sized space-time system dispersed in nanoscale, and can deal with atoms and molecules sandwiched at intersections of individual conductive lines as well as electrons (or holes) flowing in the lines in a adiabatic approximation scheme. That is, the structure of Fig. 19 is a combination of two superlattice thin pieces composed of alternating heterlayers of metals and dielectric materials. The two pieces/slices are stacked together to be different in orientation by 90 degrees, and a bottom-up system is provided in pseudo zero-demensional space 45 at the intersection of the conductor strips 41, 42 of metals. The conductor strips 41, 42 are isolated by dielectric layers 46, and the conductor strips 42 are isolated by dielectric layer 47. Fig. 19 shows exemplary sizes of respective portions corresponding to storage density 1Tb/in$^2$ in case the system is used as memory.

Interaction of atomic groups and molecular groups normally propagates like ripples through nearest neighbor groups in nearest neighbor interaction. In the system of Fig. 19, however, atoms and molecules exchange interactions instantaneously through the conductive lines, with a good approximation as if it were the interaction at distance. Since it is one of essentials of the critical state that the system "knows" every inch thereof, the system of Fig. 19 may be appreciated as a new substance akin to the "critical state" unlike conventional substances (such as, for example, cellular automaton that is a discrete system in contrast to a continuous system (see, for example, S. Wolfram, A New Kind of Science, pp. 51-81, Wolfram Media Inc., IL, USA, 2002). Thus, new aspects of nanostructural physics can be brought out through modified self-organized critical phenomena and break of spontaneous symmetry, which are expected to appear in this system. That is, it would be possible not only to couple the microscopic world and the macroscopic world but also to create new quantum functions as well as critical phenomena by aforementioned bulk-sized nanostructures capable of local and individual addressing in a bulk size.

The present invention has been made through the study explained above, and it is supported by the foregoing study and embodiments of the invention explained hereafter.

According to the first aspect of the invention,
there is provided a functional device comprising a slice having a periodic structure including a conductor layer and a non-metallic layer larger in thickness than the conductor layer, and upon which light is incident from a direction intersecting the slice.

Said functional device is one example of functional devices in which access is made from a vertical direction to the direction in which the time is continuously woven into.

In the above, preferably, the photons are injected from a perpendicular direction to said direction in which the time is continuously woven into. Said conductive layer is preferably made of metals, and are of the form of strip or ribbon. When said functional device is, for example, a solar cell, said metal layer is anode electrode or cathode electrode, and said non-metalic layer is made of semiconductor

According to the second aspect of the invention,
there is provided a functional device comprising a slice having a periodic structure including a conductor layer and a non-metallic layer larger in thickness than the conductor layer, and to at least part of which electrons are supplied in a direction intersecting the slice.

In the above, typically, the current flows along the width direction of said conductive layer. Said conductive layer is most preferably made of metals, and are of the form of strip or ribbon.

According to the third aspect of the invention,
there is provided a functional device formed from two slices each having a periodic structure including a conductor layer and a non-metallic layer larger in thickness than the conductor layer, wherein the two slices are superposed on each other so that the layers intersect each other; and edges of the conductor layer are opposite to each other with a predetermined functional material being laid between the edges.

In the above, said conductive layer is most preferably made of metals, and are of the form of strip or ribbon.

According to the fourth aspect of the invention,
there is provided a functional device comprising a structure in which a plurality of conductor layers intersect each other with their edges being laid opposite to each other with a predetermined functional material being laid between them.

In the aspects of the first through the fourth invention, said conductive layer is most preferably made of metals, and are of the form of strip or ribbon. The thickness of said conductive layer is, typically, more than 0.2 nm and less than 100nm or more than 1nm and less than 100nm, or more than 0.2nm and less than 60nm, and preferably more than 0.2nm and less than 30nm. The width of non-metallic layer is, typically, more than 0.2nm and less than 200um, and typically more than 0.2nm and less than 50um.

According to the fifth aspect of the invention,
there is provided a storage device formed from two slices each having a periodic structure including a conductor layer of over 0.2 nm and under 100 nm in thickness and a dielectric layer larger in thickness than the conductor layer, wherein the two slices are superposed on each other so that the layers intersect each other; and
edges of the conductor layer are opposite to each other with a predetermined functional material being laid between the edges.

In the above, said conductive layer is most preferably of the form of strip or ribbon. The thickness of said conductive layer is, typically, more than 1nm and less than 100nm, or more than 0.2nm and less than 60nm, and preferably more than 0.2nm and less than 30nm. The width of dielectric layer is, in general, more than 0.2nm and less than 200um, typically, more than 0.2nm and less than 50um. The recording media is, for example, insulating layer or having nano-bridge structure. Said memory device is, typically, a read-only-memory (ROM). The information (datum) stored at the crossing point is read across a diagonal line (not only the longest diagonal line but also folded or kinked diagonal lines), parallel and simultaneously read-out and access, which leads to fast read-out.

According to the sixth aspect of the invention,
there is provided a magnetic storage device comprising at least two slices having a periodic structure formed from an insulator layer and ferromagnetic layer, wherein the two slices are superposed on each other so that the layers intersect each other; and edges of the conductor layer are opposite to each other with a tunnel insulator layer of over 0.2 nm and under 10 nm in thickness being laid between them.

In the above, tunneling insulating layer and ferromagnetic layer can be various materials, and said tunneling insulating layer is for example Al2O3, said ferroelectric layer Co film. Said dielectric layer and ferroelectric layer is, typically, of a form of strip or ribbon.

According to the seventh aspect of the invention,
there is provided a solar cell comprising an anode and cathode shaped to have a spiral form and a semiconductor layer laid between them and which has a generally plate form.

In the above, said semiconductor layer is capable of photoelectric conversion, and can be various materials as long as it is possible to be rolled up to have a spiral structure. Typically, it is inorganic materials such as an amorphous silicon or organic materials. Said solar cell can be of any form, but typically, it is circular, triangle, or hexagonal. Anode and cathode of said device are of a form of strip or ribbon.

According to the eighth aspect of the invention,
there is provided a catalytic device comprising at least a slice having a periodic structure formed from a metallic layer of over 0.5 nm and under 10 nm in thickness and a dielectric layer.

In the above, said metal layer is made of Au, Pd, or Pt, and said dielectric layer is oxides such as $TiO_2$ and $SiO_2$. Said metallic layer is most preferably of the form of strip or ribbon. Said thin film is deposited in plural with spacing to increase the area to be exposed to reaction gas and to enhance the catalytic characteristic.

According the ninth aspect of the present invention, there is provided a photoelectric conversion device comprising a photoelectric conversion layer formed spiral or concentric to have the general form of a plate and upon which light is incident from a direction intersecting the plate,
wherein the incident light that can be photoelectrically converted by the photoelectric conversion layer varies in wavelength stepwise and/or continuously in the direction of the plate thickness.

Typically, first and second electrodes are formed spiral or concentric with a photoelectric conversion layer laid between them. Also, typically, at least one of the first and second electrodes, normally, at least the anode, is formed from a plurality of electrodes provided separately from each other in the direction of plate thickness. Also, typically, incident light that can be photoelectrically converted by the photoelectric conversion layer is stepwise larger in wavelength from the light-incident surface of the plate in the direction of plate thickness and at least one of the first and second electrodes is formed from a plurality of electrodes provided in positions corresponding to the steps of wavelength increase separately from each other in the direction of plate thickness. Typically, the photoelectric conversion layer is a p-n junction of a p-type semiconductor film and n-type semiconductor film. The p- and n-type semiconductor films may be of either an inorganic or organic semiconductor. Typically, they are formed from an inorganic or organic semiconductor whose composition is graded in the direction of plate thickness. Typically, the bandgap between the p- and n-type semiconductors decreases stepwise and/or continuously from the light-incident surface of the plate in the plate-thickness. The thickness of the first and second electrodes is selected as appropriate but it is typically selected within a range over 0.2 nm and under 100 nm. Also, the thickness of the photoelectric conversion layer is also selected as appropriate but it is typically selected within a range over 10 nm and under 100 nm. The photoelectric conversion layer may be formed from a dye-carrying semiconductor photoelectrode, electrolyte layer being in contact with the semiconductor photoelectrode and a counter-electrode being in contact with the electrolyte layer similarly to the well-known dye sensitizing wet solar cell. The electrolyte layer should preferably be a solid electrolyte layer. The solid electrolyte layer may be formed by printing, coating or the like. The semiconductor photoelectrode should typically be formed from a metal oxide (anatase-type titanium oxide, for example). Typically, the dye carried by the semiconductor photoelectrode is varied in type direction from the light-incident surface of the plate in the direction of plate thickness to stepwise increase the wavelength of the light absorbed by the dye. More specifically, the dye carried by the semiconductor photoelectrode is varied stepwise from a dye which absorbs light of a short wavelength to a dye which absorbs light of a long wavelength in the direction of plate thickness from the light-incident surface of the plate. The photoelectric conversion device may be in any form, but it is typically circular, triangular or hexagonal.

According to the tenth aspect of the invention, there is provided a luminous device in which said light emitting layer is of spiral structure or of concentric circles.

Said light emitting device has shape of plate, typically, has shape of circular, triangular, or hexagonal plate. To make said device emit monochromatic light, light-emitting-material that has single band gap is used. On the other hand, to make said device emit white light or multi-color light, band gap of said device is changed along the direction perpendicular to (the principal plane of) said plate, continuously or digitally, step by step. Typically, the first electrode and the second electrode sandwiching said light-emitting-layer have a form of spiral or concentric circles. Also, typically, at least one of said first or second electrode is made of split electrodes formed along the width direction or the direction perpendicular to (the principal plane of) said plate. Typically, the wavelength of the light from said light-emitting-layer changes gradually or step by step along the direction perpendicular to (the principal plane of) said plate, where at least one of said first or second electrode being made of split electrodes corresponds to said light-emitting-layer having different band-gap along the width direction or the direction perpendicular to (the principal plane of) said plate. Typically, said light-emitting-layer is made of pn junction composed of p-type and n-type semiconductors. Said p- and n-type semiconductor can be either inorganic or organic in thickness direction of the plate, and typically, having different band-gap along the width direction or the direction perpendicular to said plate. Typically, said band-gap of said p-, and n-type semiconductor changes continuously or digitally step by step along the width direction or the direction perpendicular to (the principal plane of) the plate. The thickness of said first and second electrode is determined with respect to the needs, and typically, it is more than 0.2nm and less than 100nm. The thickness of said light-emitting-layer is determined with respect to needs, also, and the thickness is typically, more than 10nm and less than 100nm.

Problems described above can be solved, in general, in the way shown bellow.

According to the eleventh aspect of the invention,
there is provided a functional device comprising: a first structure formed by local interaction; a second structure formed by a predetermined global rule; and a third structure having an anisotropic configuration and coupling or uniting the first and second structures.

According to the twelfth aspect of the invention,
there is provided a method of manufacturing a functional device including a first structure and a second structure which are coupled or united via a third structure, comprising:

forming the third structure to have an anisotropic configuration;
forming the second structure to have an anisotropic configuration according to a predetermined global rule; and
forming the first structure by local interaction.

According to the thirteenth aspect of the invention,
there is provided a functional system using a functional device which includes: a first structure formed by local interaction with in-plane causality; an anisotropic second structure formed by a predetermined global rule with out-of-plane causality; and a third structure having an anisotropic configuration and coupling the first and second structures.

In the eleventh, twelfth, and the thirteenth aspects of the invention, the first structure, for example, is formed by autonomous dispersion type interaction, the second structure is formed according to a predetermined global design rule, and the third structure comprises a flat plane or a spherical plane having a periodically laminated anisotropic configuration, i.e. having alternating heterolayers. Alternatively, the first structure is made of autonomous dispersion type interaction, the second structure is formed according to a predetermined global design rule, and the third structure comprises a plurality of planes stacked in a crossing relation.

According to the fourteenth aspect of the invention, there is provided a functional device comprising: an isotropic first structure in which time is projected in the structure continuously; an anisotropic second structure in which time is projected in the structure discontinuously; and a third structure having a periodically laminated anisotropic configuration or alternating heterolayers and coupling the first and second structures.

According to the fifteenth aspect of the invention,
there is provided a method of manufacturing a functional device including a first structure and a second structure which are coupled via a third structure, comprising:

forming the third structure to have an anisotropic configuration;
forming the second structure to have an anisotropic configuration in which time is projected in the configuration discontinuously; and
forming the first structure to have an isotropic configuration in which time is projected in the configuration continuously.

According to the sixteenth aspect of the invention,
there is provided a functional system using a functional device which includes: an isotropic first structure in which time is projected continuously; an anisotropic second structure in which time is projected discontinuously; and a third structure having a periodically laminated anisotropic configuration or alternating heterolayers and coupling the first and second structures.

In the fourteenth, fifteenth and sixteenth aspects of the invention, the third structure, for example, comprises a plurality of planes stacked in a crossing relation, each having a periodically laminated anisotropic configuration and projecting time continuously in the in-plane direction.

According to the seventeenth aspect of the invention,

there is provided a functional device comprising: an isotropic first structure in which time is projected in the structure continuously; an anisotropic second structure in which time is projected discontinuously; and an anisotropic third structure in which time is projected continuously and coupling the first and second structures.

According to the eighteenth aspect of the invention,

there is provided a method of manufacturing a functional device including a first structure and a second structure which are coupled via a third structure, comprising:

forming the third structure to have an anisotropic configuration in which time is projected in the configuration continuously;

forming the second structure to have an anisotropic configuration in which time is projected in the configuration discontinuously; and

forming the first structure to have an isotropic configuration in which time is projected in the configuration continuously.

According to the nineteenth aspect of the invention, there is provided a functional system using a functional device which includes: an isotropic first structure in which time is projected in the structure continuously; an anisotropic second structure in which time is projected in the structure discontinuously; and an anisotropic third structure in which time is projected in the structure continuously, coupling the first and second structures.

In the seventeenth, eighteenth and nineteenth aspects of the invention, the third structure, for example, is composed of at least two anisotropic two-dimensional structures in which time is projected continuously in the in-plane direction, and thereby recovers pseudo isotropy.

According to the twentieth aspect of the invention,

there is provided a functional device comprising: a first structure formed by a bottom-up process; a second structure formed by a top-down process; and a periodically laminated anisotropic third structure coupling the first and second structures.

According to the twenty-first aspect of the invention,

there is provided a method of manufacturing a functional device including a first structure and a second structure which are coupled via a third structure, comprising:

forming the third structure to have alternative heterolayers;

forming the second structure to have an anisotropic by a top-down process; and

forming the first structure by a bottom-up process.

According to the twenty-second aspect of the invention, there is provided a functional system using a functional device which includes a first structure formed by a bottom-up process; an anisotropic second structure formed by a top-down process in which time is projected in the structure discontinuously; and alternatingly heterolayered third structure coupling the first and second structures.

In the twentieth, twenty-first and twenty-second aspects of the invention, the first structure, for example, is formed by a bottom-up process relying on self-organization, the second structure is an integrated circuit (such as semiconductor integrated circuits or the like) formed by a top-down process, and the third structure is composed of a plurality of anisotropic two-dimensional structures in which time is projected in the structure continuously in the in-plane direction, and thereby recovers pseudo isotropy.

According to the twenty-third aspect of the invention, there is provided a functional device comprising: a first structure having self-similarity or a fractal structure; a second structure in form of an integrated circuit formed by a top-down process; and a third structure having alternatingly heterolayered anisotropic configuration and coupling the first and second structures.

According to the twenty-fourth aspect of the invention,

there is provided a method of manufacturing a functional device including a first structure and a second structure that are coupled via a third structure, comprising:

forming the third structure to have a periodically laminated anisotropic configuration;

forming the second structure to have an integrated circuit by a top-down process; and

forming the first structure to have self-similarity or a fractal structure.

According to the twenty-fifth aspect of the invention,

there is provided a functional system using a functional device which includes: a first structure having self-similarity or a fractal structure; a second structure in form of an integrated circuit formed by a top-down process; and a third structure having an alternatingly heterolayered anisotropic configuration and coupling the first and second structures.

In the twenty-third, twenty-fourth and twenty-fifth aspects of the invention, the third structure, for example, comprises a plurality of planes stacked in a crossing relation, each having an alternatingly heterolayered anisotropic configuration. The integrated circuit may be a semiconductor integrated circuit, for example.

In the eleventh to twenty-fifth aspects of the invention, the third structure may have a configuration laminating at least two thin pieces each having an alternatingly heterolayered configuration of conductive layers, each having a thickness in the range from 0.2 nm to 60 nm, more preferably in the range from 0.2 nm to 30 nm, and typically in the order of 1~10 nm, and dielectric layers, each having a thickness in the range from 0.2 nm to 50 $\mu$m, typically in the range from 0.2 nm to 600 nm, and more typically in the order of 10~100 nm, such that the layers cross each other.

The anisotropic structures may have either a single spatial frequency or a plurality of spatial frequencies. Further, each anisotropic structure is a system of substance including different kinds of carriers that are different in characteristic time for propagation of interaction by at least one digit, for example, and take charge of a plurality of interactions or physical phenomena different in nature from each other, and serving as a host concerning a remarked interaction or physical phenomenon, in which a second host substance corresponding to carriers (such as atoms or molecules) characterized in slow interaction or physical phenomenon is dispersed discrete by a first host substance corresponding to carriers (such as electrons) characterized in quick interaction time or physical phenomenon time in the order of 1 nm to 100 nm scale (for example, from 0.2 nm to 600 nm). In this case, at least one portion of the first host substance, for example, coupled to an arbitrary position inside the entire system exists on a one-dimensional line or curve encircling the system, or it is exposed.

In case of using a repetitive lamination of conductive layers and dielectric layers as the third structure, dielectric layers in contact with conductive layers at opposite ends may be either identical or different in nature.

In a typical example, a second structure in form of an integrated circuit (like a semiconductor integrated circuit) manufactured by a top-down process couples to a combination of a first structure and a third structure with a linear or curved one-dimensional structure existing along an edge of the combination as an interface region.

According to the twenty-sixth aspect of the invention,
there is provided a functional material made by stacking at least three layers of third structures defined in the eleventh, fourteenth, seventeenth, twentieth and twenty-third aspects of the invention.

According to the twenty-seventh aspect of the invention,
there is provided a functional material made by stacking at least two layers of laminations each including a first structure and a third structure defined in the eleventh, fourteenth, seventeenth, twentieth and twenty-third aspects of the invention.

According to the twenty-eighth aspect of the invention, there is provided a functional device comprising a structure made by stacking at least two thin pieces each being a periodical lamination or alternating heterolayers of strip-shaped conductive layers and dielectric layers such that the layers cross each other and edges of the conductive layers are opposed to each other.

According to the twenty-ninth aspect of the invention, there is provided a functional material comprising a structure made by stacking at least two thin pieces each being a periodical lamination of strip-shaped conductive layers and dielectric layers such that the layers cross each other and edges of the conductive layers are opposed to each other.

According to the thirtieth aspect of the invention, there is provided a functional device comprising a lamination of at least two thin pieces each having a periodically laminated configuration of conductive layers, each having a thickness in the range from 0.2 nm to 60 nm, and dielectric layers, each having a thickness larger than the thickness of each said conductive layer, such that the layers cross each other and edges of the conductive layers are opposed to each other.

According to the thirty-first aspect of the invention, there is provided a functional material comprising a lamination of at least two thin pieces each having a periodically laminated configuration of conductive layers, each having a thickness in the range from 0.2 nm to 60 nm, and dielectric layers, each having a thickness larger than the thickness of each said conductive layer, such that the layers cross each other and edges of the conductive layers are opposed to each other.

In the thirtieth and thirty-first aspects of the invention, thickness of each conductive layer is preferably in the range from 0.2 nm to 30 nm, and thickness of each dielectric layer is generally in the range from 0.2 nm to 200 $\mu$m and typically in the range from 0.2 nm to 50 $\mu$m.

According to the thirty-second aspect of the invention,
there is provided a functional device comprising an anisotropic structure which is a system of substance including different kinds of carriers which are different in characteristic time for propagation of interaction by at least one digit, for example, and take charge of a plurality of interactions or physical phenomena different in nature from each other, and serving as a host concerning a remarked interaction or physical phenomenon, in whcih a second host substance characterized in slow interaction or physical phenomenon is dispersed discrete by a first host substance characterized in quick interaction time or physical phenomenon time in the order of 1 nm to 100 nm scale to make a bulk size.

According to the thirty-third aspect of the invention,
there is provided a method of manufacturing a functional device including an anisotropic structure which is a system of substance including different kinds of carriers which are different in characteristic time for propagation of interaction by at least one order of magnitudes, for example, and take charge of a plurality of interactions or physical phenomena different in nature from each other, and serving as a host concerning a remarked interaction or physical phenomenon, in which a second host substance characterized in slow interaction or physical phenomenon is dispersed discrete by a first host substance characterized in quick interaction time or physical phenomenon time in the order of 1 nm to 100 nm scale to make a bulk size.

According to the thirty-fourth aspect of the invention, there is provided a functional system using a functional device including an anisotropic structure which is a system of substance including different kinds of carriers which are different in characteristic time for propagation of interaction by at least one order of magnitudes, for example, and take charge of a plurality of interactions or physical phenomena different in nature from each other, and serving as a host concerning a remarked interaction or physical phenomenon, in which a second host substance characterized in slow interaction or physical phenomenon is dispersed discrete by a first host substance characterized in quick interaction time or physical phenomenon time in the order of 1 nm to 100 nm scale to make a bulk size.

In the twenty-sixth to thirty-fourth aspects of the invention, the description made in conjunction with the eleventh to twenty-fifth aspects of the invention is also applicable to the extent consistent with their natures.

Further, in the eleventh to thirty-fourth aspects of the invention, the description made in conjunction with the first to tenth aspects of the invention is also applicable to the extent consistent with their natures.

According to the invention having the configuration summarized above, it is possible to easily integrate a top-down system and a bottom-up system, which have been difficult to integrate heretofore, by coupling a first structure formed by local interaction and a second structure formed according to a predetermined global rule with a third structure having an anisotropic configuration.

The above various devices can be produced with a high yield using only a novel clean unit or clean unit system according to the present invention which will be described below. Namely, they can be produced without using any conventional large-scale clean chamber requiring a large capital investment.

Also, according to the thirty-fifth aspect of the present invention,

there is provided a clean unit including:

a work chamber that can be kept as a clean environment; and
connectors provided at at least the back, top and bottom of the work chamber and at at least one of opposite lateral sides of the work chamber, respectively.

Where the connectors of the work chamber are to be provided, at the back, top or bottom and at one of two lateral sides is appropriately selected depending upon how the clean units are to be disposed two- or three-dimensionally. For example, in case the clean units are disposed in a horizontal plane, the connectors should preferably be provided at the back and both lateral sides of the work chamber to increase the freedom of connection for an improved flexibility of a clean unit system. In this case, a total of three clean units can be connected to the back and both lateral sides of one clean unit. Also, in case the clean units are disposed in a vertical plane, the connectors should preferably be provided at the top or bottom and both lateral sides, respectively, of the work chamber to increase the freedom of connection for an improved flexibility of a clean unit system. In this case, a total of three clean units can be connected to the top or bottom and both lateral sides of one clean unit. Generally, the connector has an opening formed in the wall of the work chamber and a shield plate provided to open and close the opening. The shield plate may basically be any one as long as it can open and close the opening but it is typically a sliding door or hinged door. The shield plate may be adapted for manual operation or for automatic operation. In the latter case, a sensor such as a photosensor may be installed inside the work chamber to detect access of the operator's hand or a workpiece and a shield plate operating mechanism also be provided. When the sensor detects when the hand or workpiece comes close thereto, it puts the shield plate operating mechanism into action to open or close the shield plate. Also in this case, a conveyance mechanism such as a belt conveyor may further be provided inside the work chamber to carry a workpiece between the entrance and exit of the work chamber. When the sensor detects when the workpiece is carried by the conveyance mechanism to near the exit, it puts the shield plate operating mechanism into action to operate the shield plate. Also, a sealing material such as a gasket may be provided on the shield plate or work chamber wall to increase the airtightness of the work chamber when shielded by the shield plate.

In case a chemical process, chemical reaction, crystal growth, bio process, etc. are to be carried out in a clean environment, the work chamber is typically provided with an exhaust duct and a passive dust filter with no blower, which however depends upon what work or process is to be done in the work chamber. The exhaust duct and dust filter are typically installed in an upper portion of the work chamber. In this case, the clean unit is normally of an enclosed type to which however the present invention is not limited. On the other hand, in case a non-chemical process (physical measurement with the use of a surface probe microscope, inspection or assembling, for example) is carried out in the work chamber, the latter is typically provided with a pressure-control ventilator and an active dust filter with a blower (HEPA filter or ULPA filter, for example). Typically, the dust filter is provided in the upper portion of the work chamber, while the ventilator is in a lower portion of the side wall of the work chamber. In this case, the clean unit is normally of an open type in which the pressure inside the work chamber is controlled by the ventilator, to which however the present invention is not limited. In
addition to the pressure-control ventilator, there are provided in the work chamber more than one or two holes through which electric wires or the like are to be led in or out as the case may be. The work chamber is adapted to guide a gas flowing out from there to an adsorber or remover using activated carbon or to both, and then to the inlet of the active dust filter. Further, an exhaust duct communicating with the outside
atmosphere should preferably be connected to the adsorber
and/or remover to adsorb harmful particles or to remove harmful
gas included in the atmosphere, and then release the atmosphere thus cleaned to outside. Thus, the work chamber can be used for a bio process (cell culture, cell fusion, gene recombination, plant breeding, transformation or the like), chemical process or the like accompanied by generation of harmful particles or harmful gas. Also, the work chamber may be adapted to guide the gas flowing out through the ventilator to the inlet of the active dust filter, whereby the same dust filter can
considerably improve the cleanliness of the work chamber. Most preferably for the improved cleanliness of the work chamber, the work chamber is adapted for guiding all the gas flowing out (100%) from the ventilator of the work chamber to the inlet of the active dust filter, which however is not always required. The cleanliness of the work chamber can effectively be improved even by designing the work chamber to guide part of the flowing-out gas to the inlet of the active dust filter. Typically, an airtight tube is connected directly to the work chamber and also to the inlet of the active dust filter to circulate the gas and assure the airtightness of the work chamber (turbo system) . The work chamber is provided with work gloves as appropriate. The work gloves are normally provided in the front portion of the work chamber.

The clean unit is, for example, a nano-technology process unit or biotechnology process unit, which are usable for various processes.

Also, the clean unit is, for example, a draft, clean bench, glove box or the like, to which however the present invention is not limited.

The work chamber of a clean unit may be in any one selected from various forms as appropriate. More specifically, the form may be a rectangular parallelopiped or cube, modified rectangular parallelopiped or cube, sphere, hemisphere, ellipse, cylinder or the like. Basically, the internal volume of the work chamber is appropriately designed to meet an intended purpose. For the operator to be able to effect various kinds of work (carrying out a process, making maintenance such as cleaning, etc.) inside the work chamber with a pair of gloves on, for example, the work-chamber internal volume should desirably be such that the operator' s hand inserted from outside the work can desirably reach almost all corners of the entire working space in the work chamber. Generally, a dimension of less than 1 m and larger than 30 cm is selected for all the width, height and depth of the work chamber. Normally, a selected size of the work chamber, if too small, will possibly prevent the operator from making any work smoothly. In case work can be done without having to insert the hand from outside the work chamber, for example, in case the work can be effected automatically, or in case a workpiece is carried while being contained in the clean unit, the work chamber may be designed smaller.

The work chamber may be formed from a plate-shaped hard material or a balloon-shaped soft material.

Depending upon an intended purpose, a compact apparatus may be accommodated inside the clean unit. More particularly, the apparatus is, for example, any one of various process units which will be described in detail later, lapping apparatus, analyzer (optical microscope, scanning probe microscope (SPM) such as a scanning electron microscope (SEM) or atomic force microscope (AFM)), reactor apparatus, microchemical system, microchemical reactor, exposure apparatus, etching apparatus, growth apparatus, working apparatus, sterilizer, particle filter, artificial light source, bio apparatus, food processor, inspection apparatus, drive or the like. For bleeding a cell or plant, the artificial light source should preferably be a light-emitting diode or semiconductor laser of which the spectrum half-value width is less than 30 nm. Especially, a pulse-driven semiconductor laser is used as the artificial light source.

Also, according to the thirty-sixth aspect of the present invention,
there is provided a clean unit system formed from a plurality of clean units each having a work chamber that can be kept as a clean environment and which are connected to each other, at least one of the plurality of clean units including:

a work chamber that can be kept as a clean environment; and
connectors provided at at least one of the back, top and bottom of the work chamber and at at least one of the lateral sides of the work chamber, respectively.

In the above clean unit system, each of the plurality of clean units may include a work chamber that can be kept as a clean environment and connectors provided at at least one of the back, top and bottom of the work chamber and at at least one of the lateral sides of the work chamber, respectively, or the plurality of clean units may include together the clean units of the above-mentioned type and conventional clean units which can be connected only horizontally to each other.

The clean unit system is connected, for example, along a line that is a non-single line, zigzag line, vertical or horizontal zigzag line, of branch, of loop, and/or mix of aforementioned configuration. A part of the clean unit system or the whole system has the aforementioned configuration. In the above the configuration of zigzag line has at least one bend, and preferably more than two bends. If it has one bend, it is not only L-shaped, but also a bend not at right angle. Thus, for example, when it has two bends, it can have a shape like "U". The description on the zigzag configuration stated above holds for the zigzag configuration described below.

The explanation of the clean unit according to the thirty-fifth aspect of the present invention is also true with the above clean unit including a work chamber that can be kept as a clean environment and connectors provided at at least one of the back, top and bottom of the work chamber and at at least one of the lateral sides of the work chamber, respectively.

Also, according to the thirty-seventh aspect of the present invention,
there is provided a clean unit system formed from a plurality of clean units each having a work chamber that can be kept as a clean environment and which are connected to each other, the plurality of clean units being connected in the configuration of such line that is a non-single line, zigzag line, or in the configuration of zigzag line.

According to the thirty-eighth aspect of the present invention,
there is provided a clean unit system formed from a plurality of clean units each having a work chamber that can be kept as a clean environment and which are connected to each other, at least one of the plurality of clean units having: plurality of connectors that connects said clean units of which workpieces go in and come out at a right angle or an angle not equal to zero nor one-hundred eighty degrees.

According to the thirty-ninth aspect of the present invention,
there is provided a clean unit system formed from a plurality of clean units each having a work chamber that can be kept as a clean environment and which are connected to each other, at least one of the plurality of clean units including: at least one adjacent pair units of which samples go in and come out at angle of ninety degree or at an angle that is not equal to zero nor one-hundred eighty degrees.

According to the fortieth aspect of the present invention,
there is provided a clean unit system formed from a plurality of clean units each having a work chamber that can be kept as a clean environment and which are connected to each other, the plurality of clean units being connected in zigzag configuration so that the whole system can be constructed in a certain finite small area.

According to the forty-first aspect of the present invention,
there is provided a clean unit system formed from a plurality of clean units each having a work chamber that can be kept as a clean environment and which are connected to each other, at least one part of the plurality of clean units being connected in a loop.

According to the forty-second aspect of the present invention,
there is provided a clean unit system formed from a plurality of clean units each having a work chamber that can be kept as a clean environment and which are connected to each other, the plurality of clean units having plural kinds of units being connected in a mosaic configuration.

The plurality of clean units includes, for example, a draft, clean bench, glove box and the like. When attention is focused on a process to be effected, the plurality of clean units includes a chemical process unit, non-chemical process unit, bio process unit and the like. Some of the plurality of clean units included in the clean unit system may be disposed to form a loop, for example.

According to the forty-third aspect of the present invention,
there is provided a clean unit system formed from a plurality of clean units each having a work chamber that can be kept as a clean environment and which are connected to each other, at least one part of the plurality of clean units being connected in a loop so that repeated process in a total process flow can be handled in the loop repeatedly.

According to the forty-fourth aspect of the present invention,
there is provided a device fabrication method using clean unit system formed from a plurality of clean units each having a work chamber that can be kept as a clean environment and which are connected to each other, at least one part of the plurality of clean units, having compact equipments/machines inside themselves, being connected in zigzag and/or a loop configuration so that repeated process in a total process flow can be handled in the loop enabling main part or whole of the process flow to be done in a self-contained manner.

In the above, the devices are, for example, semiconductor devices, bio-devices, bio-electronics devices, and aforementioned various devices.

In the thirty-seventh through the forty-fourth aspect of the invention, as for the plurality of clean units each having a work chamber that can be kept as a clean environment and which are connected to each other, at least one of the plurality of clean units is, preferably, provided with connectors at, at least, one of the back, top and bottom of the work chamber and at, at least, one of the lateral sides of the work chamber, respectively. All of the the plurality of clean units can be provided with connectors at, at least, one of the back, top and bottom of the work chamber and at, at least, one of the lateral sides of the work chamber, respectively. What is described for the thirty-fifth aspect of the invention is applicable for the clean unit.

According to the forty-fifth aspect of the present invention,
there is provided a clean unit system formed from a clean unit having a work chamber that can be kept as a clean environment, exhaust duct, and a passive dust filter.

In the above the clean unit may be provided with or without connectors at, at least, one of the back, top and bottom of the work chamber and at, at least, one of the lateral sides of the work chamber, respectively. In that case, the description made in conjunction with the thirty-fifth aspect of the invention is also applicable to the extent consistent with its nature. The same is true for the forty-sixth aspect of the invention described below. Typically, the work chamber has chemical process equipment inside, but not restricted to it.

According to the forty-sixth aspect of the present invention,
there is provided clean unit system formed from a plurality of clean units each having a work chamber that can be kept as a clean environment and which are connected to each other, at least one unit of the plurality of clean units,
having a work chamber that can be kept as a clean environment,
exhaust duct connected to said work chamber, and a passive dust filter.

The clean unit system according to the thirty-sixth through the forty-third aspect and the forty-sixth aspect of the present invention is usable for various applications. With a nano-technology process unit or biotechnology process unit, for example, the clean unit system provides various process systems such as a nano-technology process system, biotechnology process system, etc. Further, with a combination of a nano-technology process unit and biotechnology process unit, the clean unit system provides a nano-technology/biotechnology unification platform. This is also true with a clean unit system which will be explained below. More particularly, the clean unit system is a material (inorganic or organic) processing system, device production system, cell breeding system, plant breeding system or the like.

According to the above the thirty-sixth through the forty-fourth aspect and the forty-sixth aspect of the present invention, at least one of the plurality of clean units has typically provided therein, for example, a compact process unit, analyzer, reactor, microchemical system, microchemical reactor, exposure apparatus, etching apparatus, growth apparatus, processing apparatus, sterilizer, particle filter, artificial light source, bio apparatus, food processor, inspection apparatus, drive or the like which will be described below.

The process unit, analyzer, reactor, microchemical system, microchemical reactor, exposure apparatus, etching apparatus, bleeder, processing apparatus, sterilizer, particle filter, artificial light source, bio apparatus, food processor, inspection apparatus, drive or the like to be installed in the clean unit should preferably be compact enough to be accommodated even in a small clean unit. For example, in case a total series of processes including from putting a workpiece into the clean unit up to output of a product is to be effected in the clean unit system or in case a series of processes forming a main part of the total series of processes is to be effected in the clean unit system, a group of compact process units that can be accommodated in the clean unit is used for various physical and chemical processes, respectively, included in the process flow. These process units may be provided removably in the clean unit or integrally with the latter.

For example, highly functional devices such as the above-mentioned devices, semiconductor devices, etc. are produced through consistent processes from charging of a material up to output of a product. Such production has been achieved in the past by passing a substrate between high-precision apparatuses such as lithography apparatus, etching apparatus, etc. disposed in a large, highly-controlled clean room as having previously been described. In the present invention, however, downsized apparatuses developed based on the recent innovated technologies are adopted instead of the conventional apparatuses in such a clean room. For example, a desk-top scanning tunnel microscope (STM), atomic force microscope (AFM) or miniature scanning electron microscope (SEM) is used in place of the transmission electron microscope (TEM), conventional scanning electron microscope (SEM) or the like. In the photolithography apparatus included in the present invention, the exposure light source uses a semiconductor laser (see the document 10, for example) instead of the gas laser. For growth of thin films, a microchemical reactor (see the Document 11, for example) is used in place of the large-scale equipment such as a molecular beam epitaxy (MBE), metaloganic chemical vapor deposition (MOCVD) apparatus or the like. Also, metalization is effected using a metal plating apparatus, desktop miniature deposition apparatus or the like. Further, a micro CVD (chemical vapor deposition) apparatus, micro RIE (reactive ion etching) apparatus, miniature spin coater, miniature baking apparatus and the like are used.

With the use of the smaller apparatus, the large clean room becomes unnecessary. That is, a series of all or main ones of the processes from charging of a substrate to output of a product lot with photolithography, forming of electrodes, surface observation, etc. in a process of producing semiconductors can completely be effected in a consistent manner in a series of concatenated clean units placed in an ordinary room, not in any large clean room, and including a local clean closed space (typically of a desk-top space size). Namely, owing to the compactness attained by replacement with the downsized apparatuses, it is possible to form the clean unit small enough to be installed on a table. Thus, when the clean units each having connectors provided at the back and at least one of the lateral sides of the work chamber are disposed in a zigzag line (winding line) or in a loop, the entire clean unit system will occupy only a small area. Further, the clean suits, air shower, clean mat and the like which have been indispensable for the operator working in the clean room become unnecessary. Therefore, almost all kinds of work can be effected in a local, very clean atmosphere with friendliness to both the human body and environment.

According to the aforementioned the thirty-fifth through the forty-sixth aspect of the present invention, the connectors are provided each at at least one of the back, top and bottom and at least one of the lateral sides of the work chamber of the clean unit, so that one clean unit can be connected to another horizontally as well as at the back or vertically with a considerably improved freedom of connection between the clean units. The clean units can thus be connected to each other and disposed in a zigzag line or in a loop to form a clean unit system in which the clean units are positioned optimally for a process going to be effected and that occupies a minimum area. Also, with the connectors being provided each at at least one of the back, top and bottom and at least one of the lateral sides of the work chamber of the clean unit and ventilator and active dust filter being provided in the work chamber, the freedom of connection between the clean units is not only improved considerably but the inner space of the work chamber can be kept as a clean environment.

Also, the clean units connected to each other and disposed in a non-single line, zigzag line, branching pattern, loop or in a combination of two or more of these patterns of configuration can form a clean unit system having the clean units positioned optimally for a process going to be effected and which occupies a minimum area.

As for the plurality of clean units each having a work chamber that can be kept as a clean environment and which are connected to each other, freedom of connection can be increased and optimum configuration at the smallest area becomes possible according to processes to be done, by making samples go in and come out at angle of ninety degree or at an angle that is not equal to zero nor one-hundred eighty degrees at least in one of the plurality of clean units.

Also, a clean unit system formed from the clean units connected to each other and disposed in such a zigzag line to be accommodated in a predetermined limited area is optimum for a process going to be effected and occupies a minimum area.

Also, a clean unit system formed from a plurality of clean units connected to each other and disposed in a mosaic pattern is optimum for a process flow including a wide variety of processes.

Also, since some of a plurality of clean units, connected to each other and disposed in a loop, can effect processes of the same type emerging more than once in a total series of process flows, so the number of clean units necessary for the same type of process can be reduced.

Also, a plurality of clean units each having compact apparatuses of different types provided therein, of which some are connected to each other and disposed in a zigzag line or in a loop to consistently perform all or main part of the processes in a total series of process flows, can efficiently perform processes such as material processing, device production, cell breeding, plant breeding, etc.

Also, the exhaust duct and passive dust filter provided in the work chamber of the clean unit can keep the work chamber inside as a clean environment without use of any blower.

Here, consideration will be made of a clean unit having a box-shaped work chamber of which the inside is kept as a clean environment using a ventilator and active dust filter with a blower (HEPA filter, ULPA filter or the like, for example). The clean unit may have or have not connectors. In this case, the dust density $n(t)$ in the work chamber is given as the following expression on the consumption that the gas flow rate of the dust filter is $V$, volume of the work chamber is $V_0$, internal area is $S$, desorption rate of dust particles per area and time is $\sigma$, dust density in the environment where the clean unit is installed is $No$ and dust collection efficiency of the dust filter is $y$:

$$V_o \frac{dn(t)}{dt} = S\sigma - n(t)V + N_o V(1-\gamma)^2$$

When it is defined that:

$$\alpha_c = \frac{S\sigma}{V_o} + (1-\gamma)^2 \frac{V}{V_o} N_o$$

and

$$\beta_c = \frac{V}{V_o}$$

the dust density is given by the following expression:

$$n(t) = \frac{\alpha_c}{\beta_c} + (N_0 - \frac{\alpha_c}{\beta_c})e^{-\beta_c t}$$

It will be a linear function of the dust density in the atmosphere even if the time passes. That is, the dust density will greatly depend upon the environment where the clean unit is installed.

Next, the aforementioned turbo system will be considered. It is assumed here that an airtight tube connected directly to the work chamber is connected to the inlet of the active dust filter to circulate a gas and the turbo system is airtight. In this case, the dust density n(t) is given by the following expression:

$$V_o \frac{dn(t)}{dt} = S\sigma - n(t)V + n(t)V(1 - \gamma)$$
$$= S\sigma - \gamma Vn(t)$$

When it is defined that:

$$\alpha_n = \frac{S\sigma}{V_o}$$

and

$$\beta_n = \frac{\gamma V}{V_o}$$

the dust particle density is given by the following expression:

$$n(t) = \frac{\alpha_n}{\beta_n} + (N_0 - \frac{\alpha_n}{\beta_n})e^{-\beta_n t}$$

Since the second term of the expression rapidly approximates to zero as the time passes, only the first term, that is, $\alpha_n/\beta_n = (S\sigma/V_0) / (\gamma V/V_0) = S\sigma/\gamma V$, will remain. Since this first term includes no dust density of the atmosphere, it will be apparent that an ultimate cleanliness can be assured, not depending upon the environment where the clean unit is installed. The feature of a clean unit using no turbo system is the cleanliness of the work chamber depends upon $1-\gamma$ or its power $(1-\gamma)^n$ while the cleanliness of the work chamber of a clean unit using the turbo system depends upon $1/\gamma$. Also, it is important to minimize $S\sigma/\gamma V$.

Also, according to a forty-seventh aspect of the present invention, there is provided a clean unit in which an active dust filter is used to keep a work chamber as a clean environment, wherein the cleanliness of the work chamber depends upon $1/\gamma$ where $\gamma$ is the dust collection efficiency of the dust filter.

Typically, the dust filter is a HEPA or ULPA filter and constructed for all the gas flowing out of the work chamber to enter the inlet of the active dust filter. More particularly, an airtight tube may be connected directly to the work chamber and also connected to the inlet of the dust filter to circulate the gas and assure the airtightness of the clean unit. Preferably for execution of a chemical process in the work chamber, use of a dust filter suitable for use with the chemical process and connecting an adsorbent source or adsorption tower to the tube permit to provide a closed system that can remove a harmful substance and also continuously provide a clean environment without having to connect the clean unit to outside via a duct or the like. To minimize emission of dust or powder dust from the inner surface of the work chamber, at least part of the inner surface of the work chamber may preferably be covered with an adhesive sheet and re-covered with a fresh adhesive sheet after the work chamber having been used for a predetermined period, for example. In case a multi-layer adhesive sheet is used, a clean sheet surface may be exposed by peeling one sheet layer off the adhesive sheet at each elapse of such a predetermined period. Also, the inner surface of the work chamber may be smoothed not to have any Fourier component of a surface roughness on the same order as the diameter of the dust particle to be removed from the work chamber, to thereby minimize the adsorption of dust particles having the size of the to-be-removed dust particles to the inner surface of the work chamber.

The aforementioned construction the clean unit or clean unit system according to the thirty-fifth through the forty-sixth aspects of the present invention and explanation made in connection with the construction are also true with, or applicable to, the forty-seventh aspect of the present invention unless the forty-seventh aspect is different in character from the thirty-fifth through the forty-sixth aspects.

Also, two or more of the aforementioned aspects of the present invention may be combined as appropriate.

Brief Description of the Drawings

Figs. 1A and 1B are schematic diagrams for explaining the present invention;
Figs. 2A and 2B are schematic diagrams for explaining the present invention;
Figs. 3 and 4 are schematic diagrams for explaining TPC; Fig. 5 is a schematic diagram for explaining the invention; Figs. 6A, 6B and 6C are schematic diagrams for explaining the invention; Fig. 7 is a schematic diagram for explaining the invention; Figs. 8A, 8B and 8C are photographs of a dark-field image, lattice image and diffraction pattern of $(AlAs)_2 (GaAs)_2$ superlattice taken by a transmission electron microscope for explaining growth of an AlAs/GaAs atomic-resolution superlattice; Fig. 9 is a schematic diagram for explaining the electrochemical growth mechanism; Figs. 10A, 10B and 10c are schematic diagrams for explaining the invention;

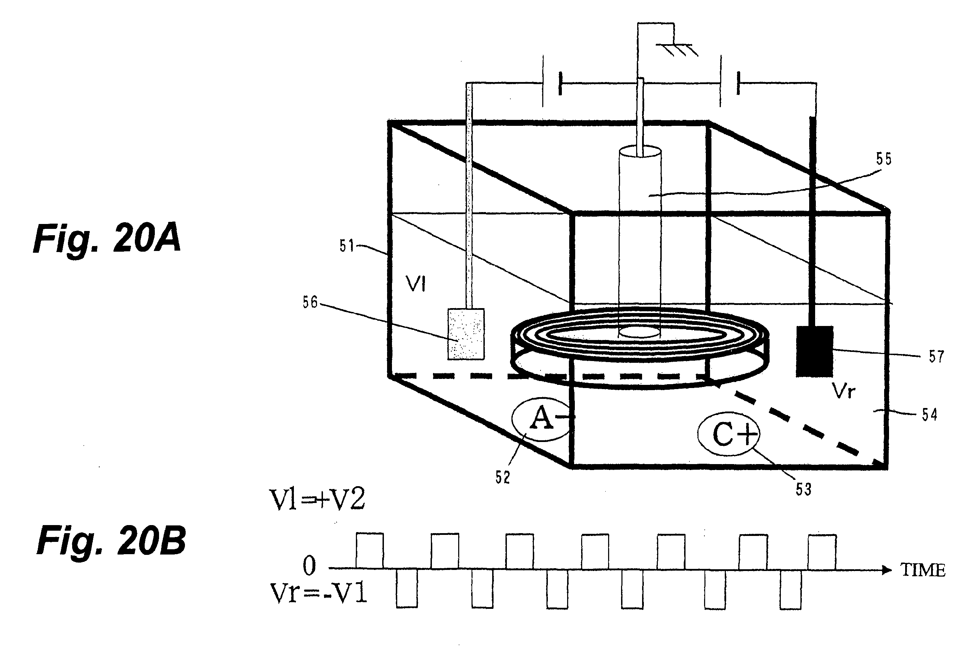

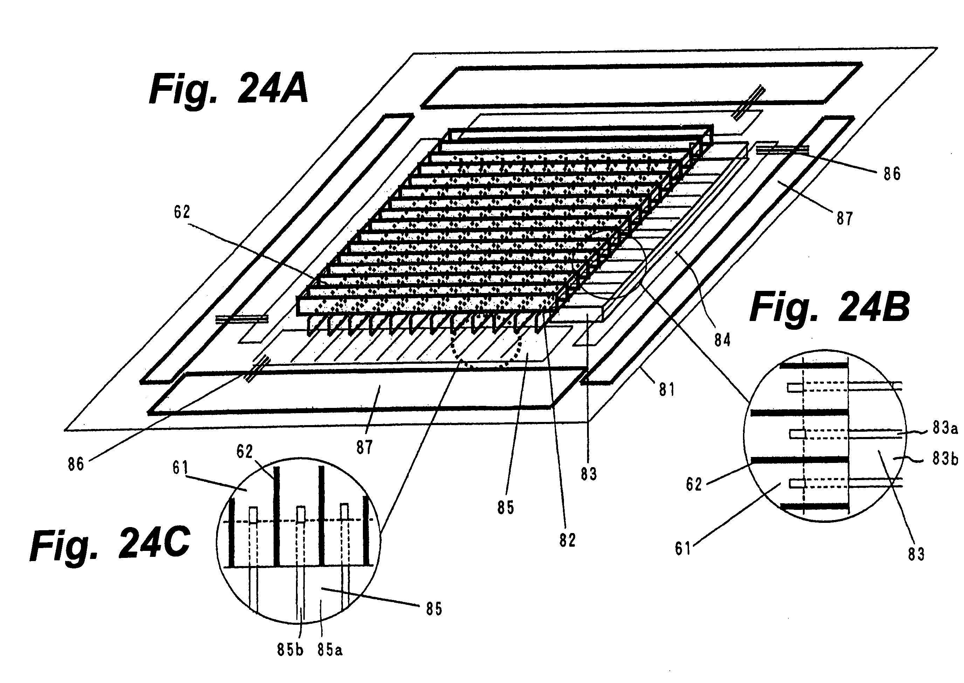

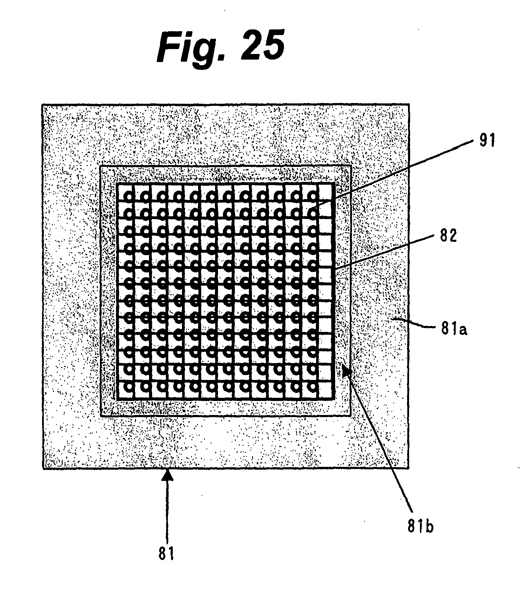

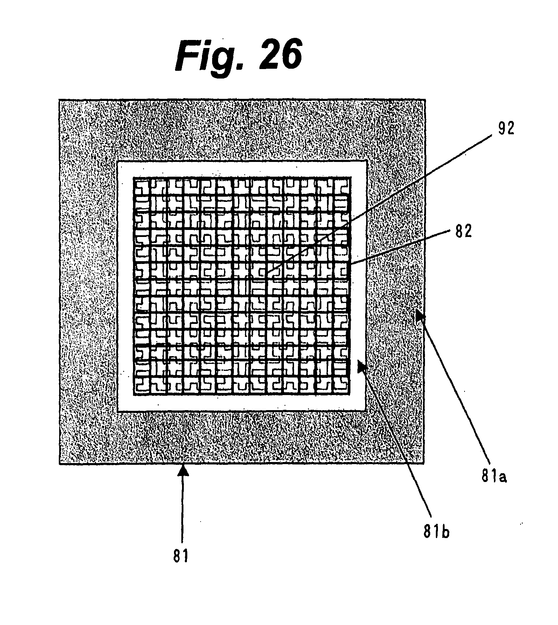

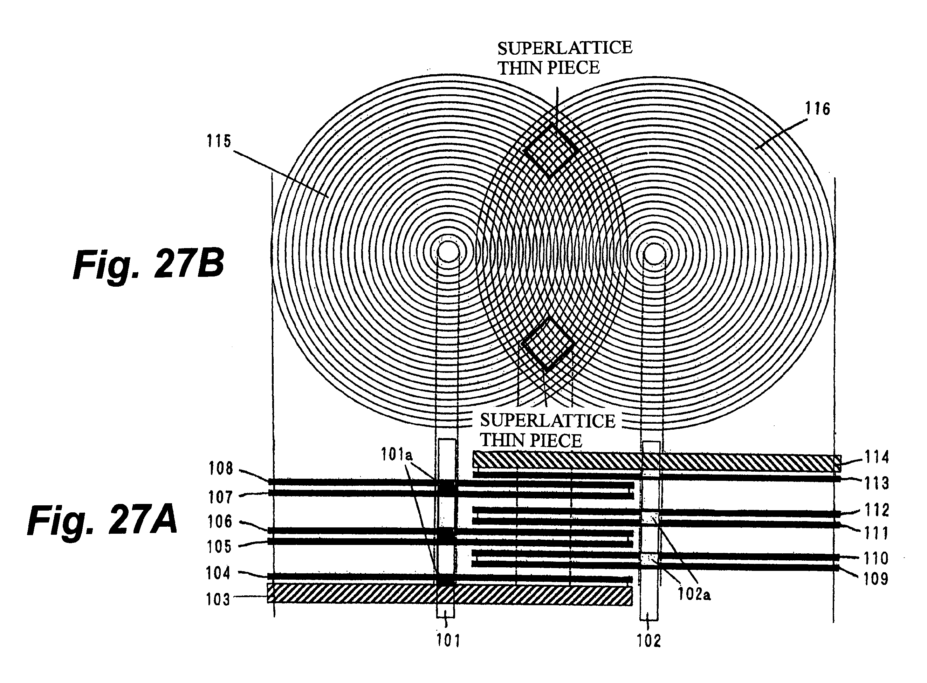

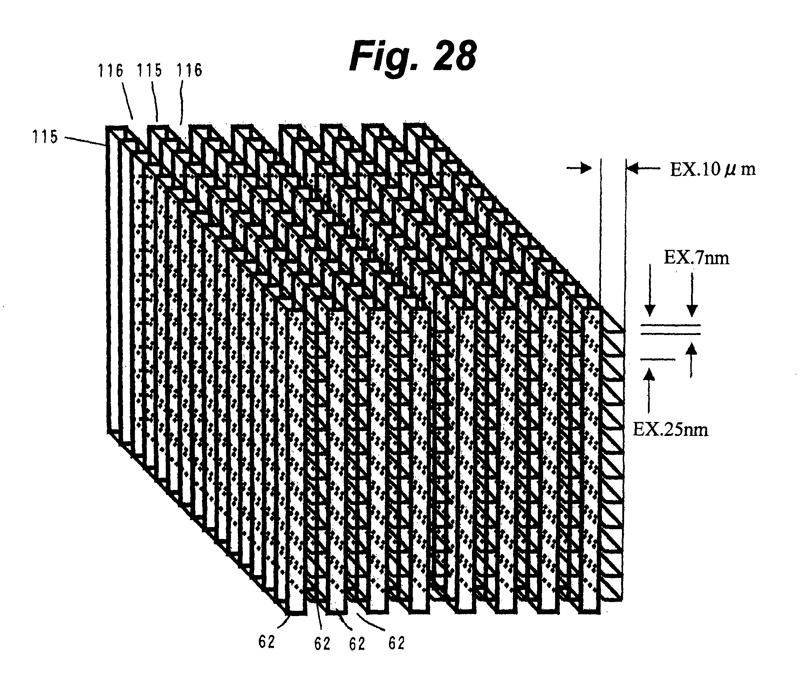

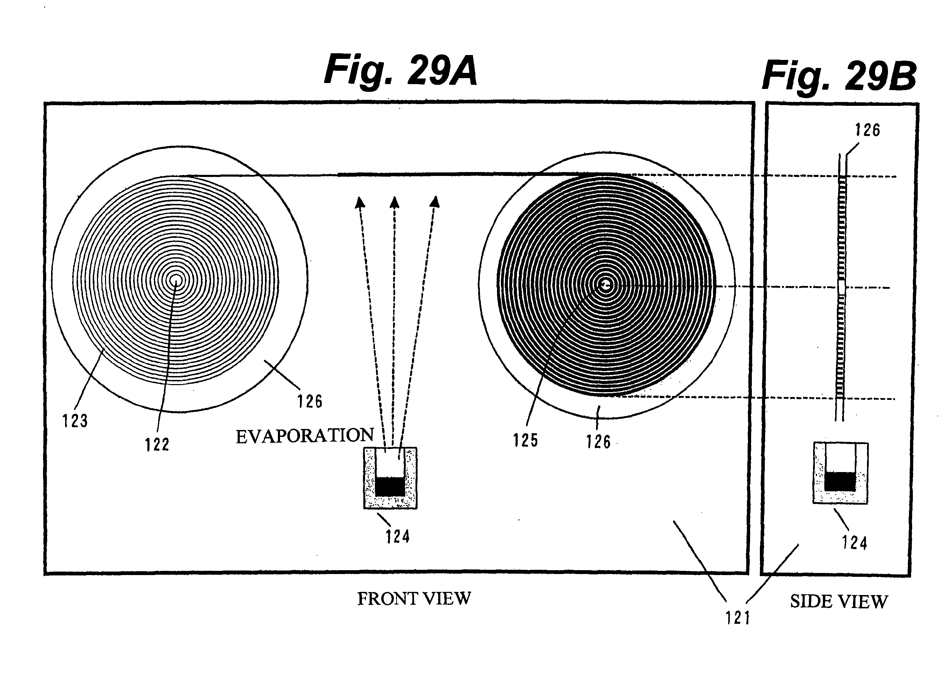

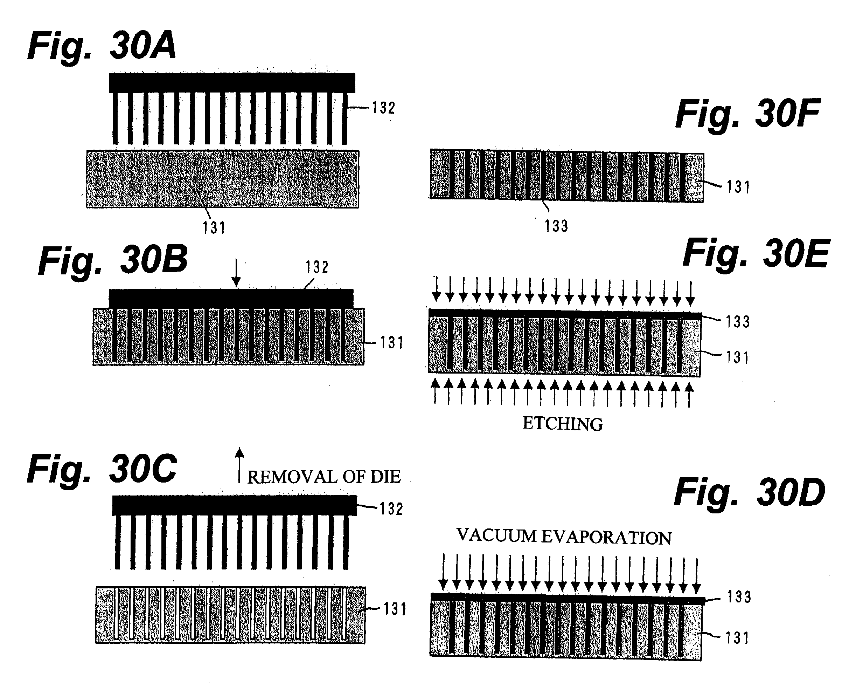

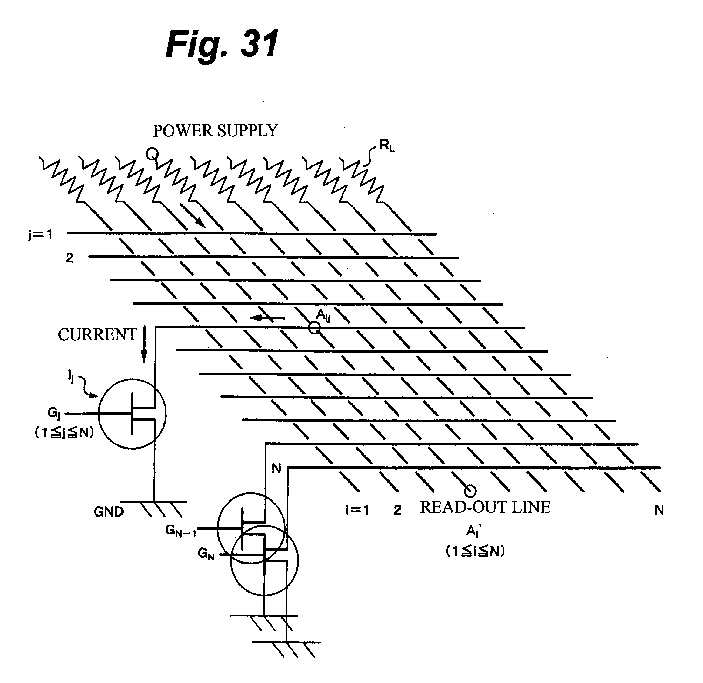

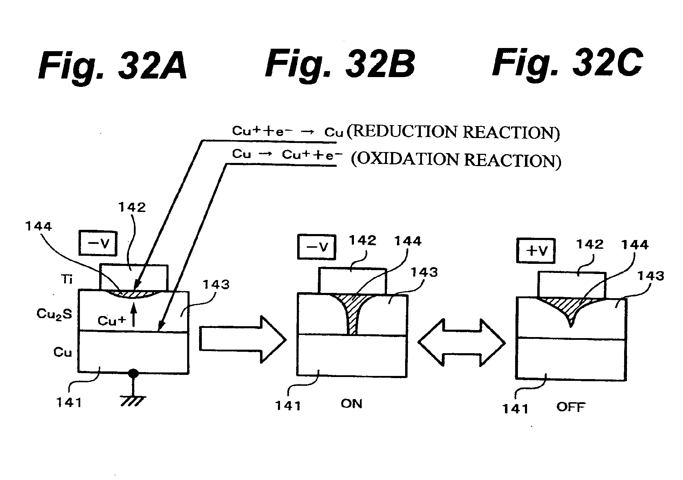

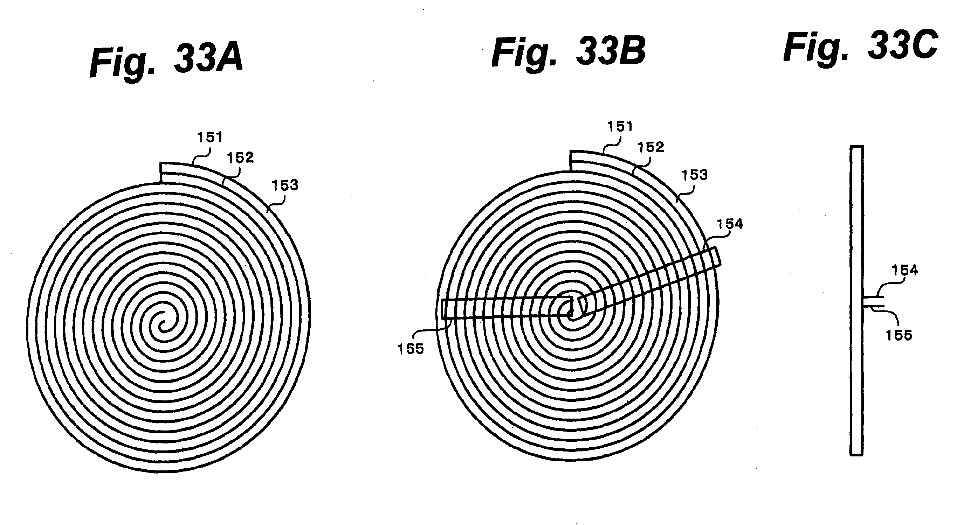

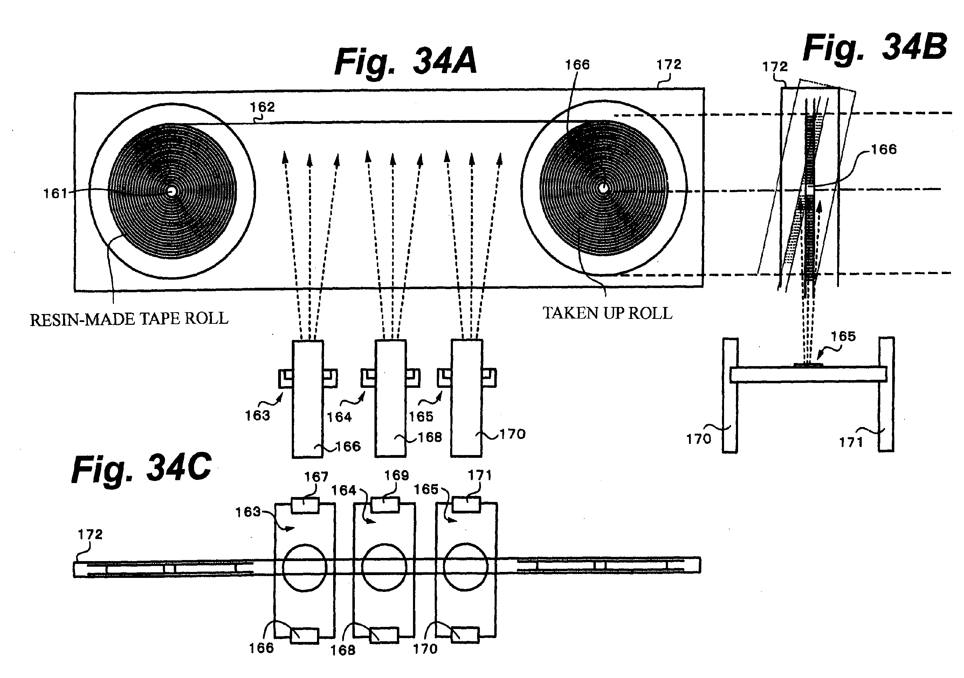

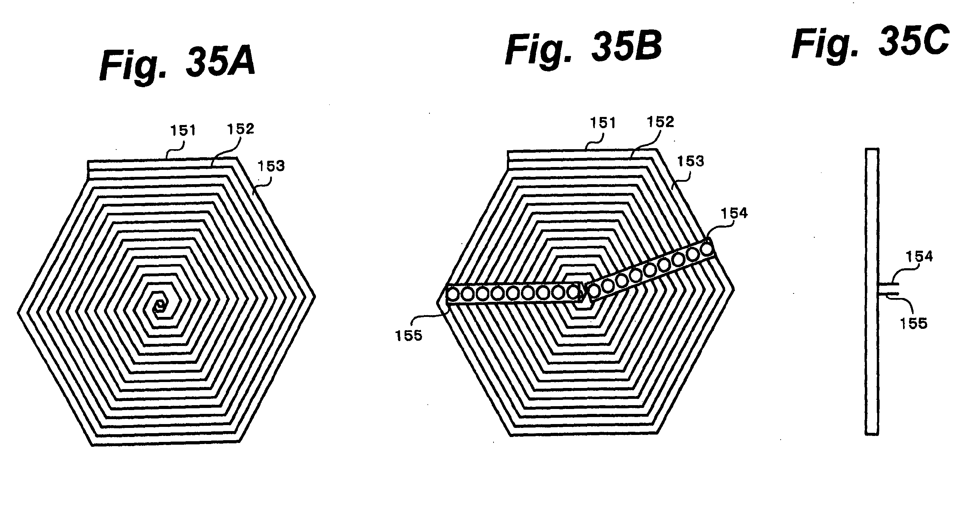

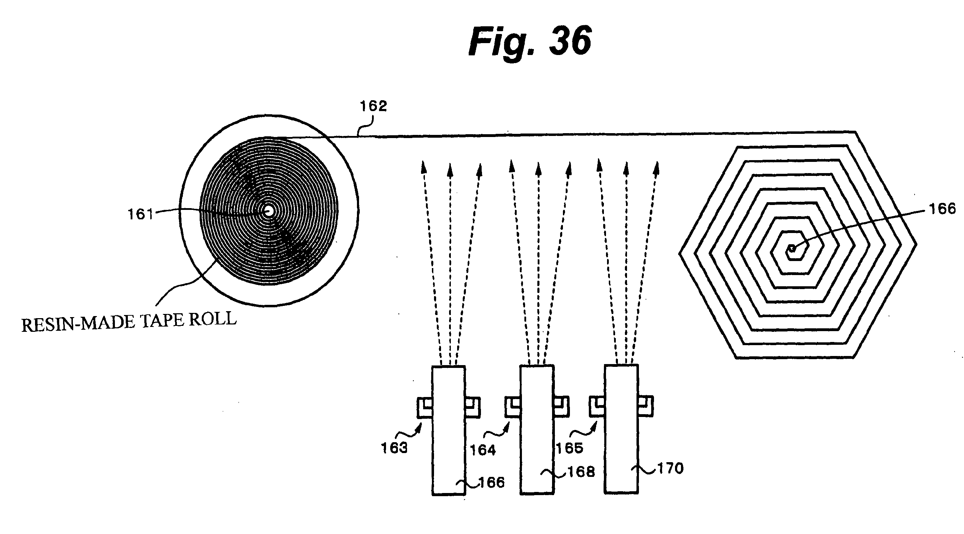

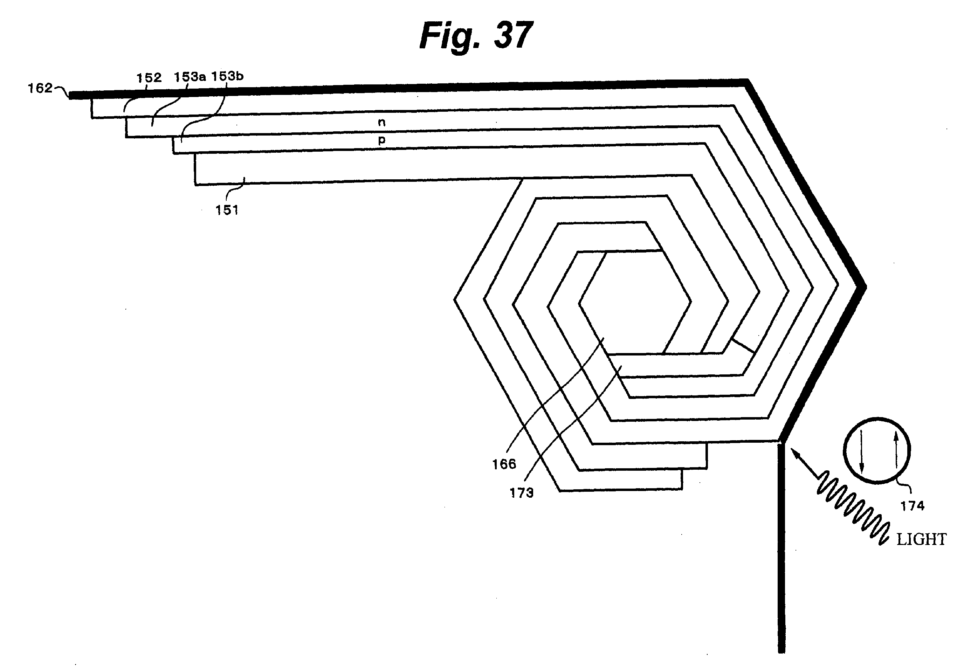

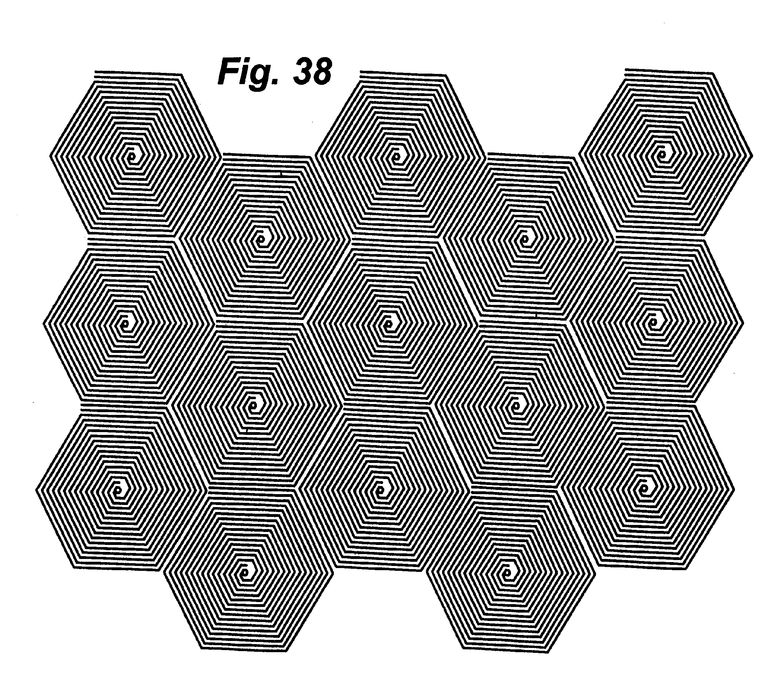

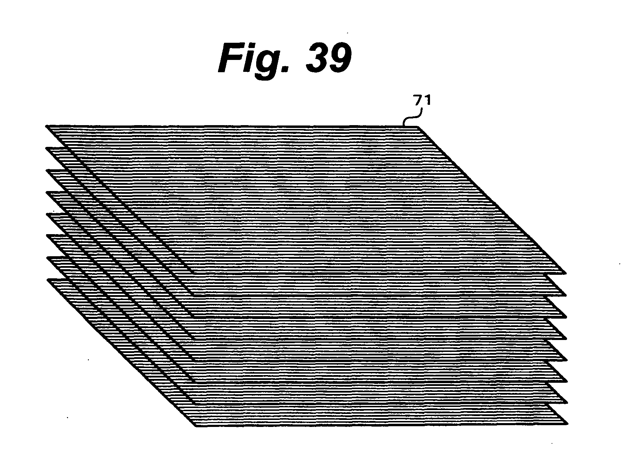

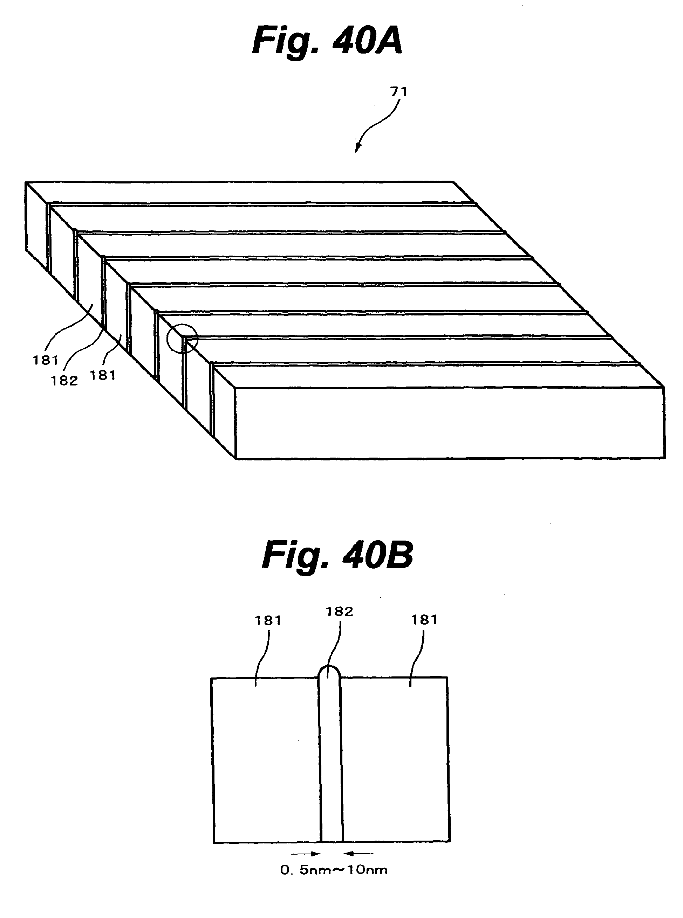

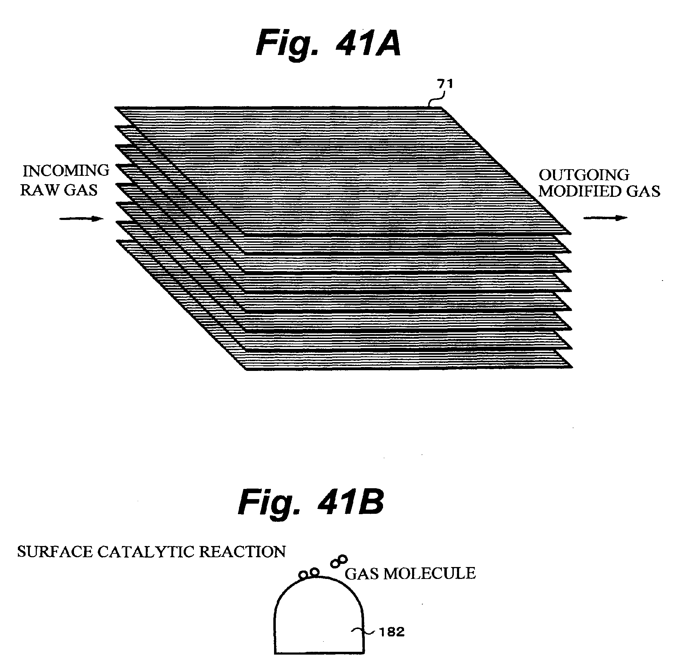

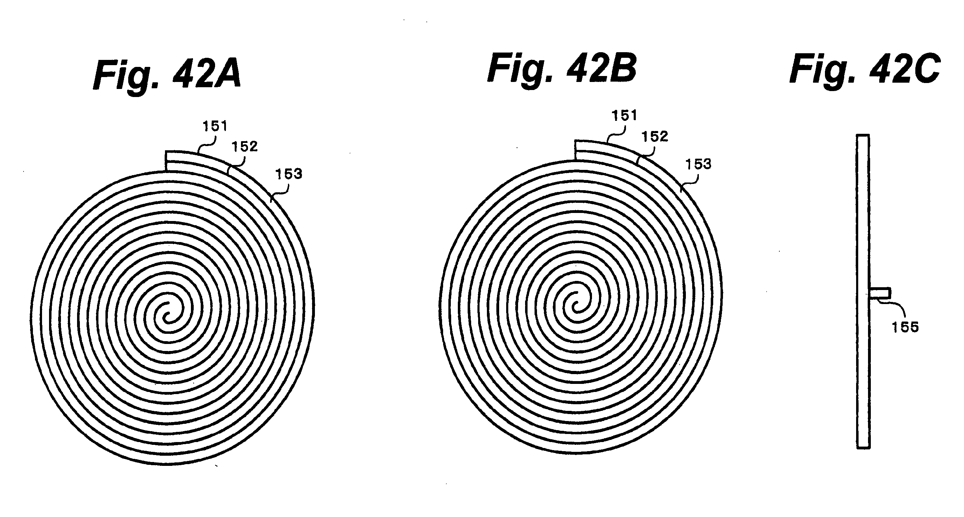

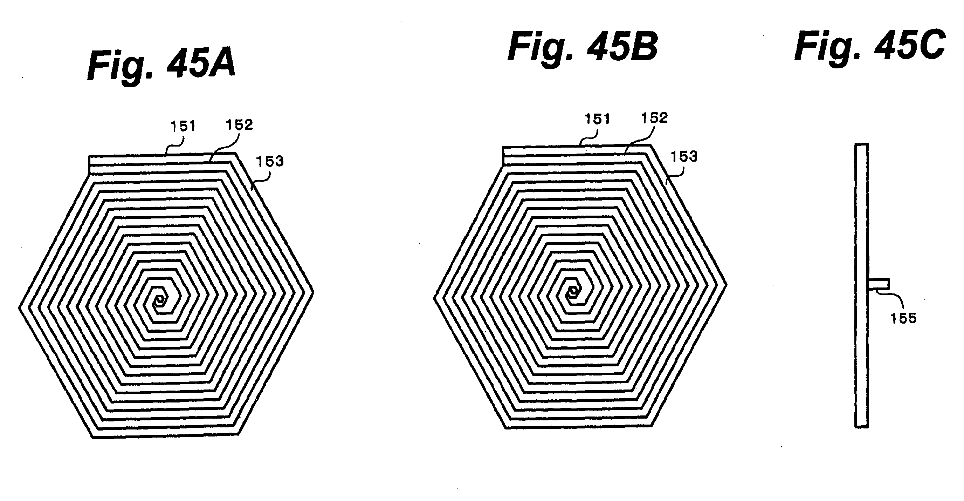

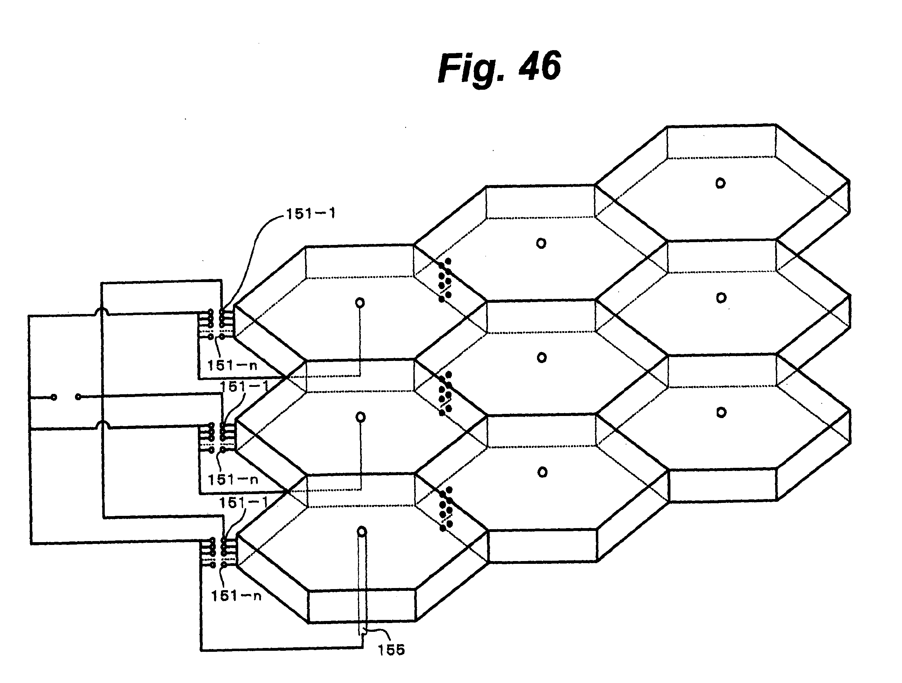

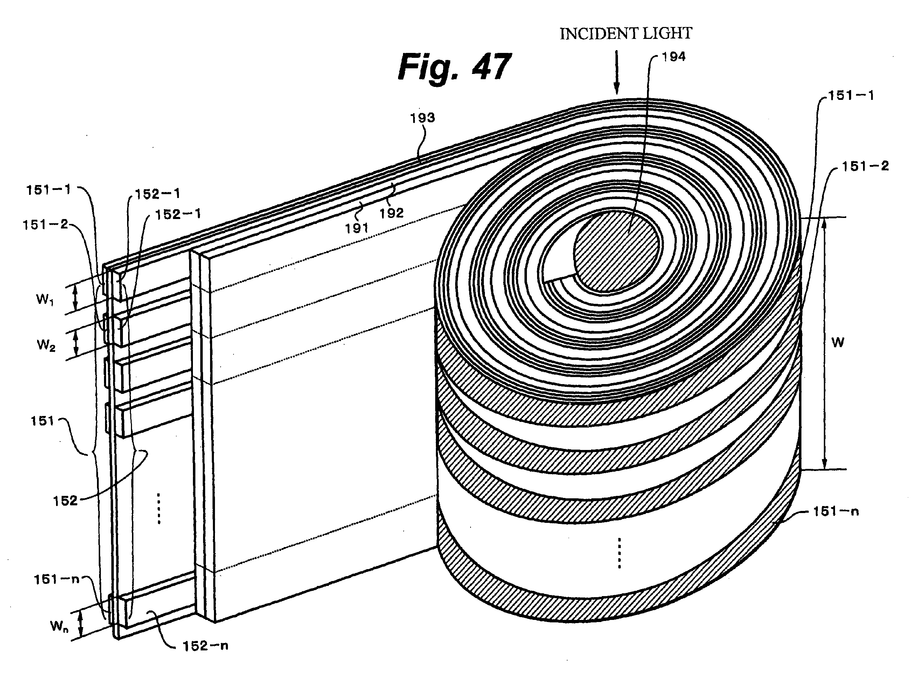

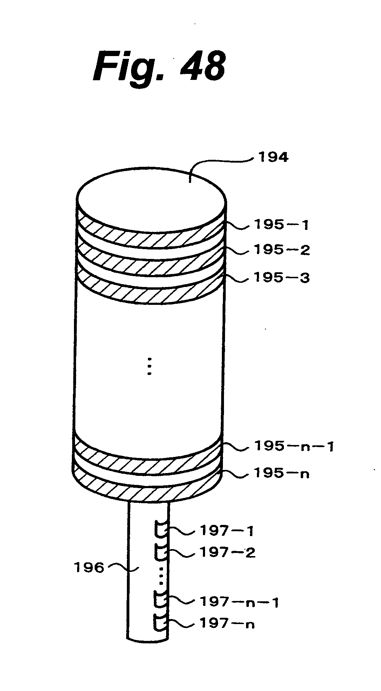

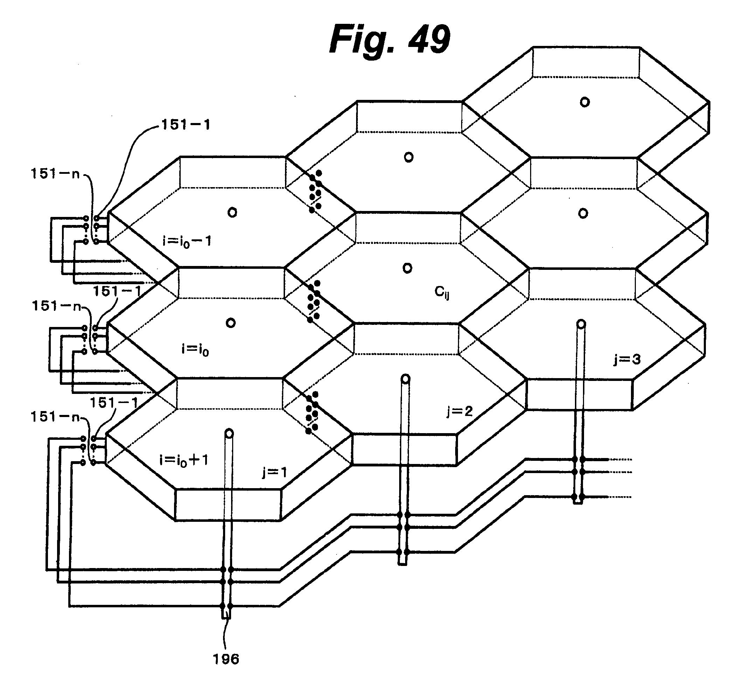

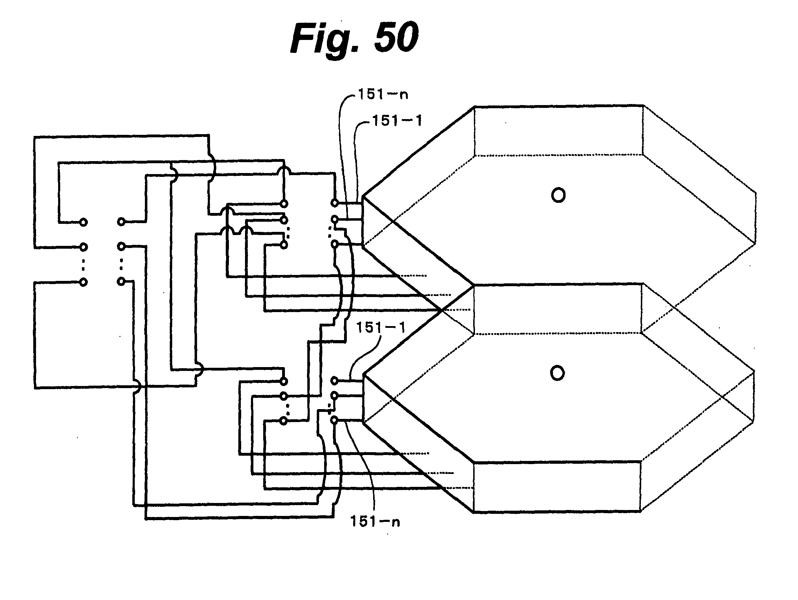

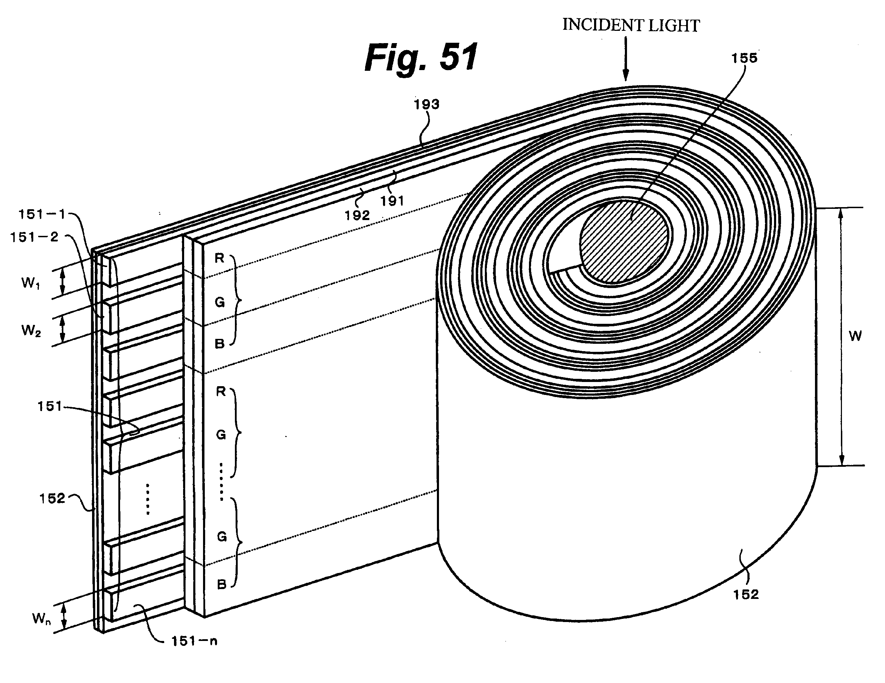

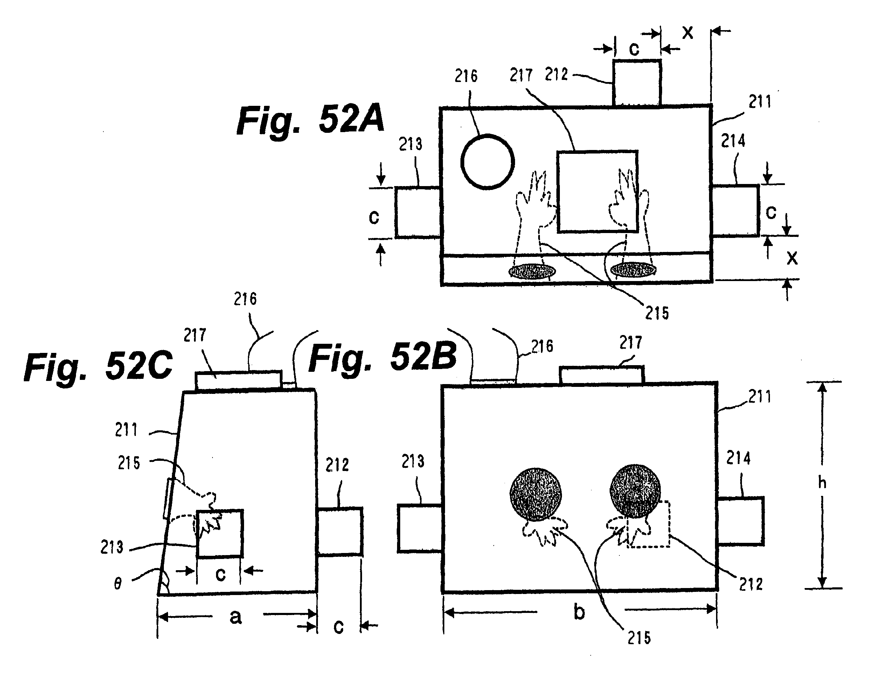

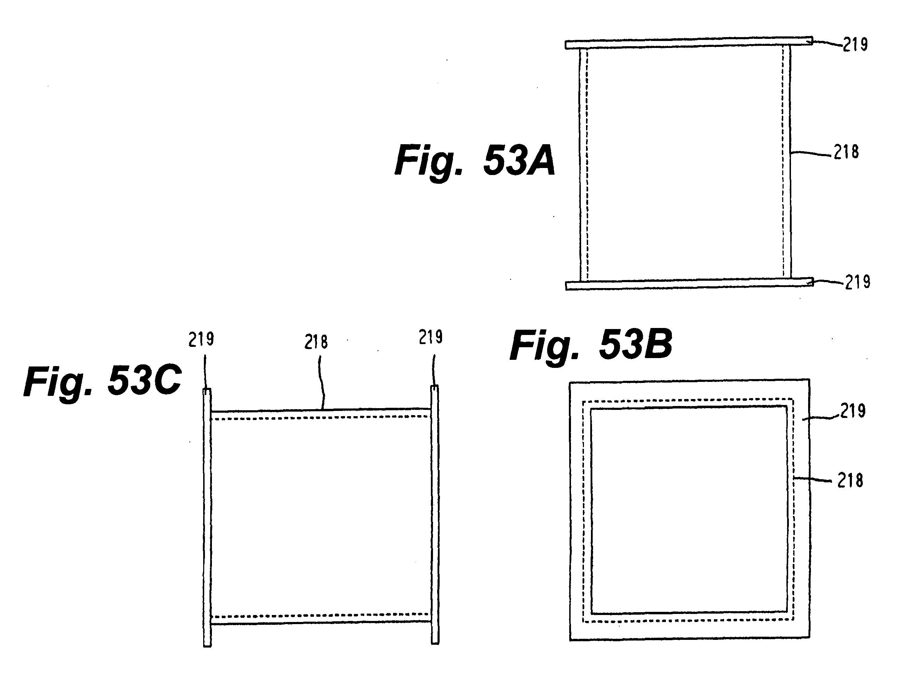

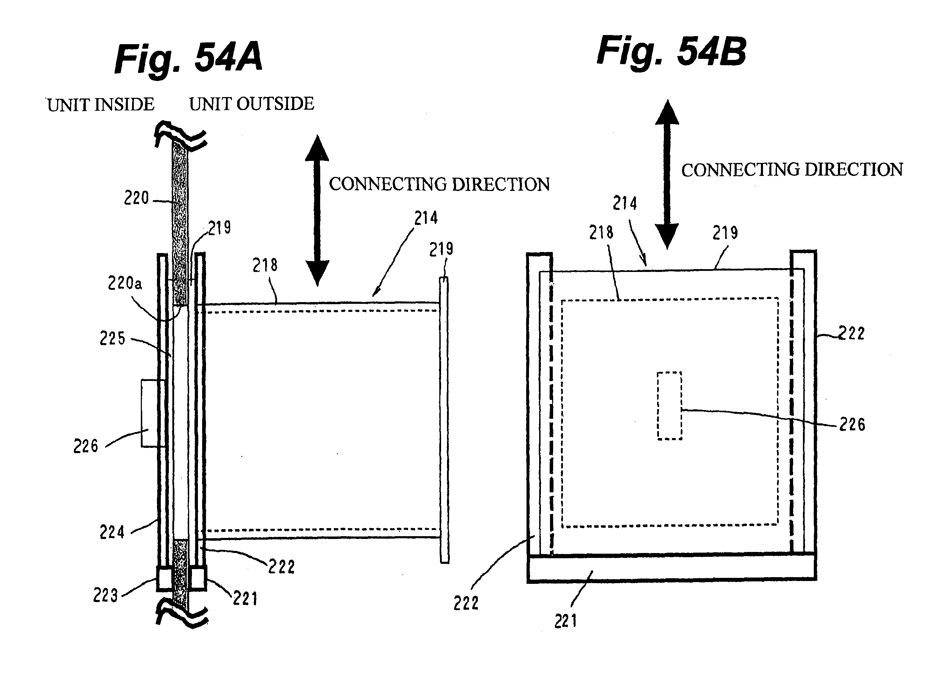

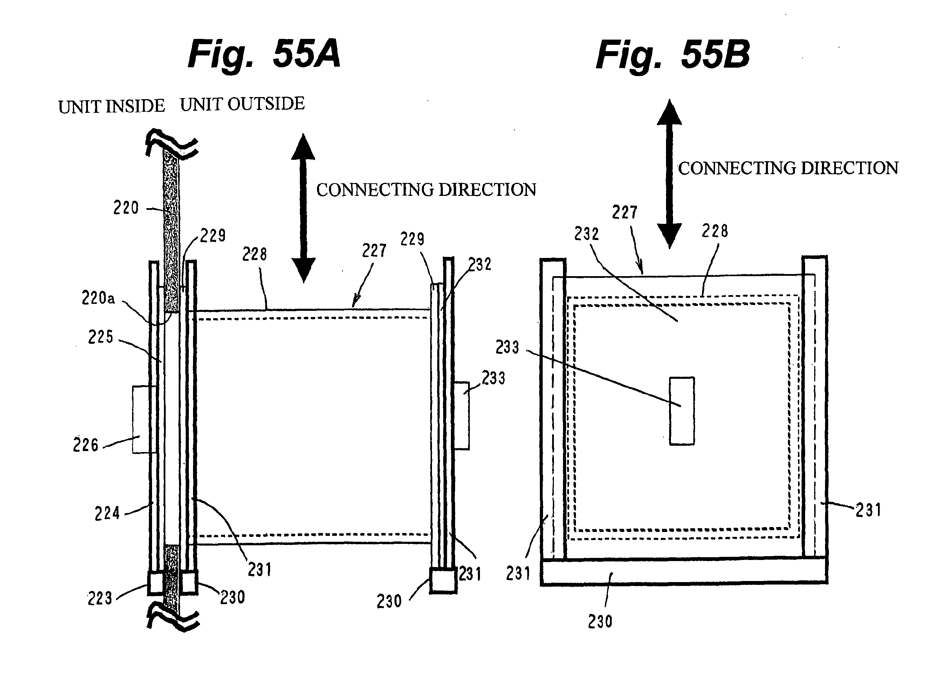

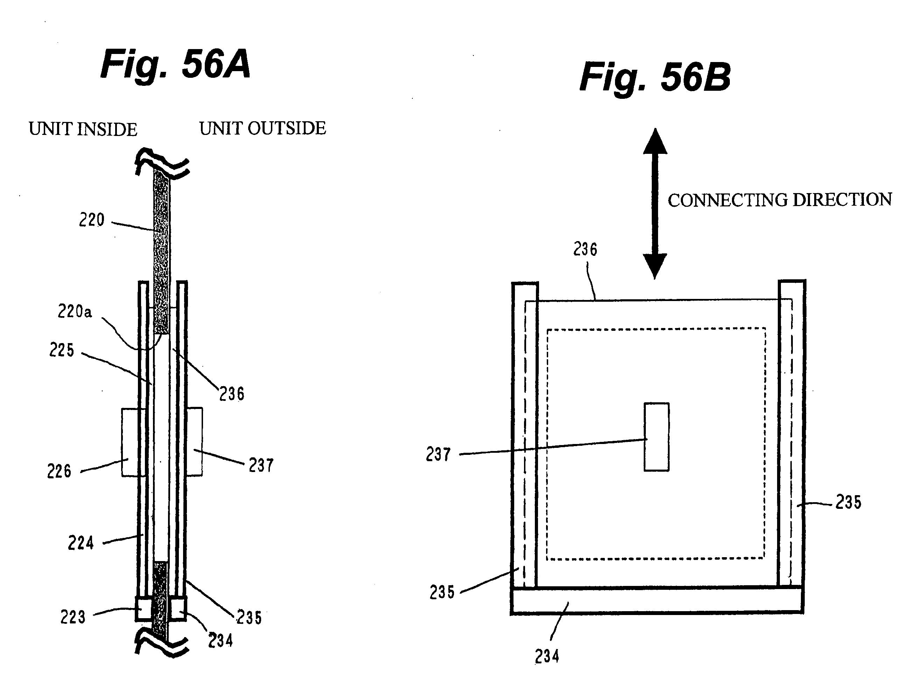

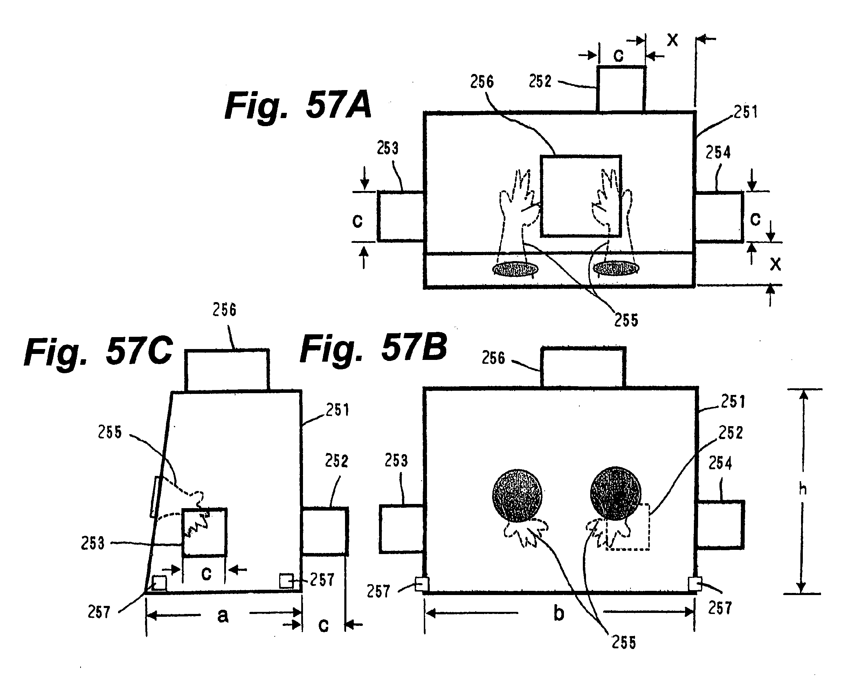

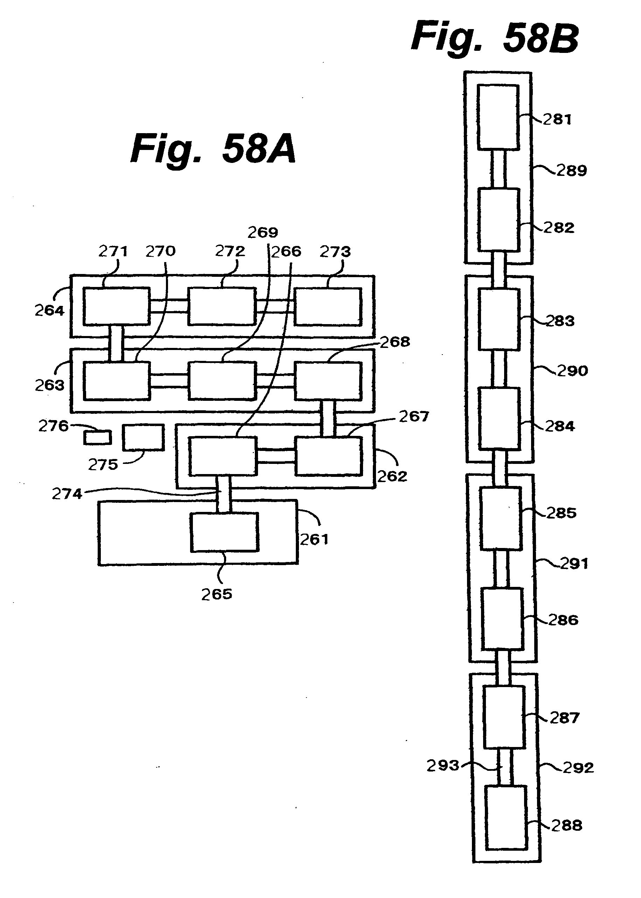

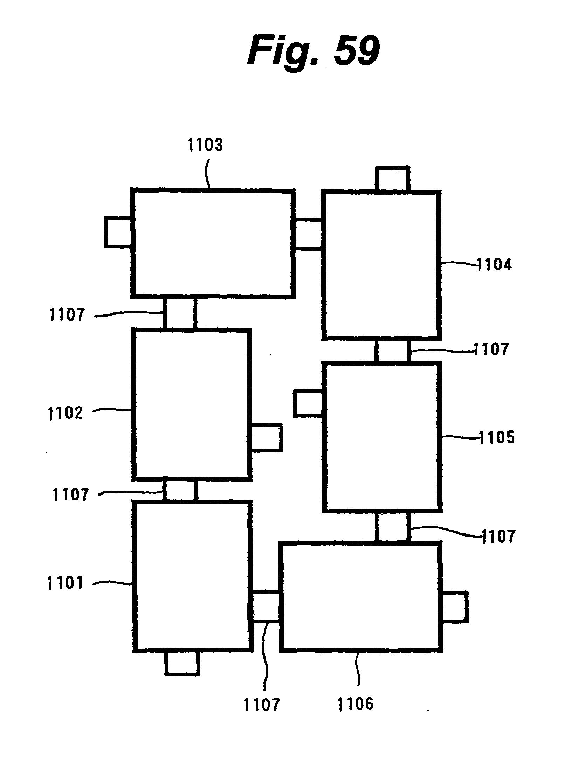

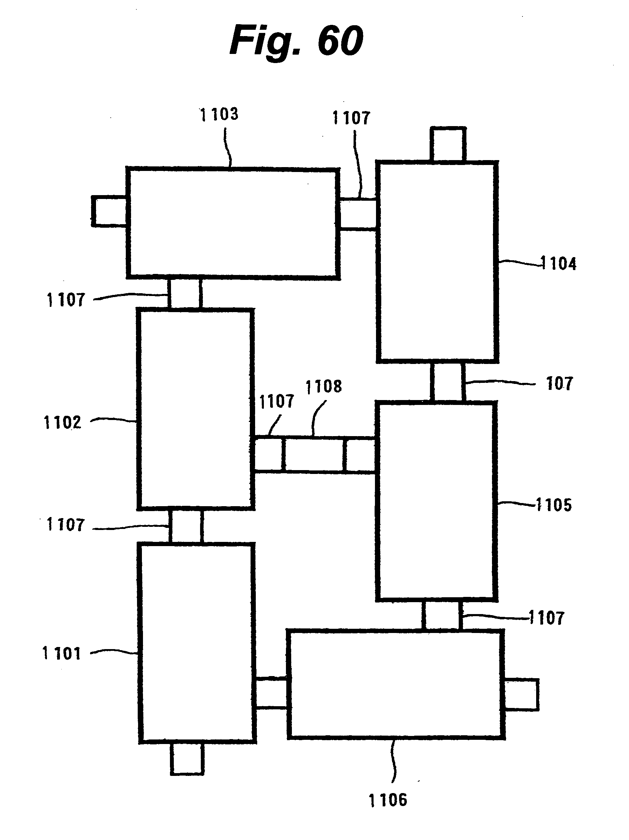

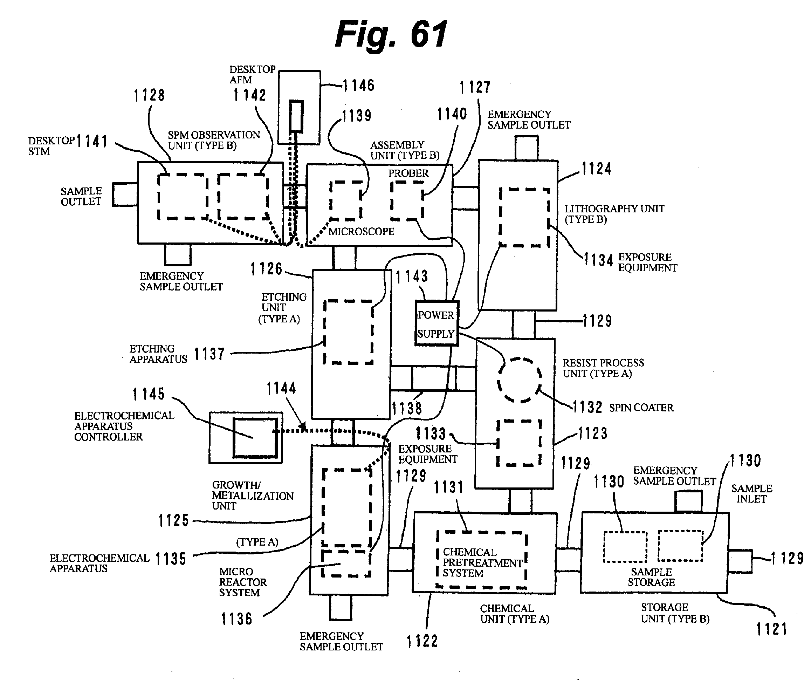

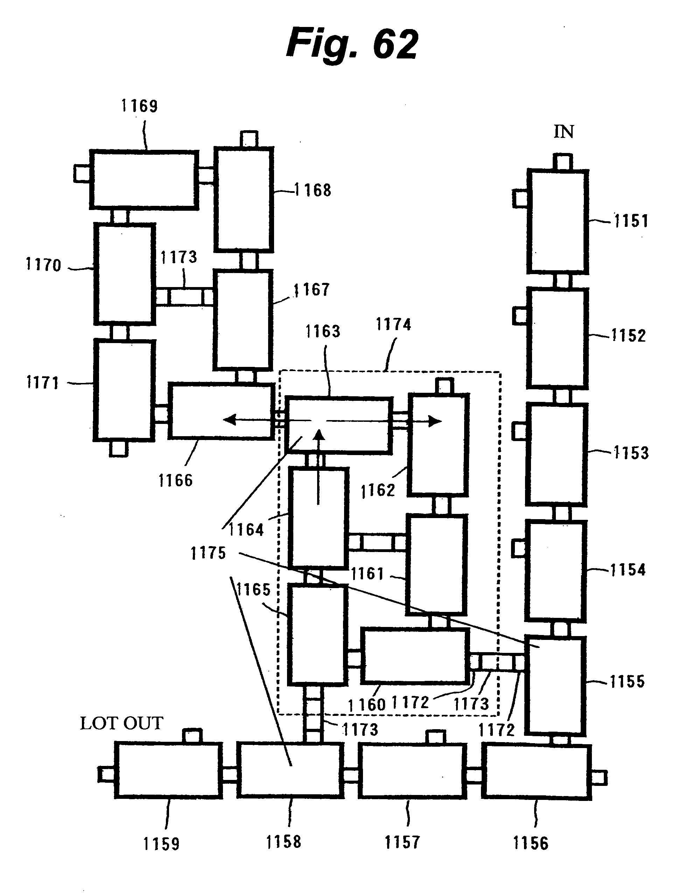

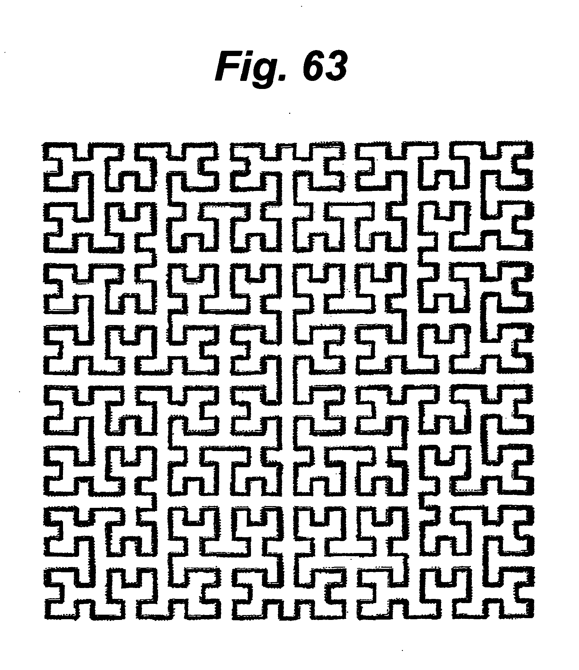

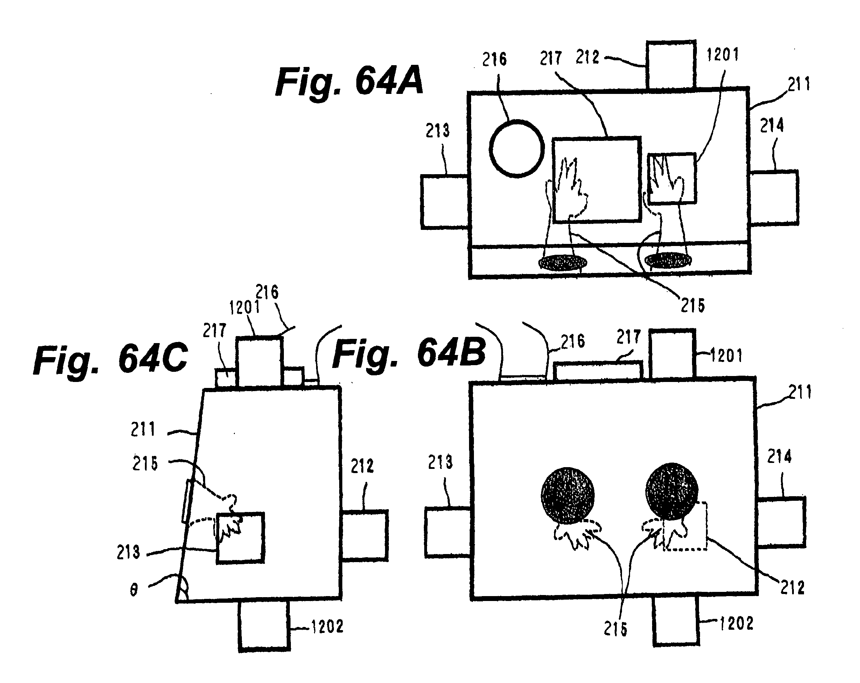

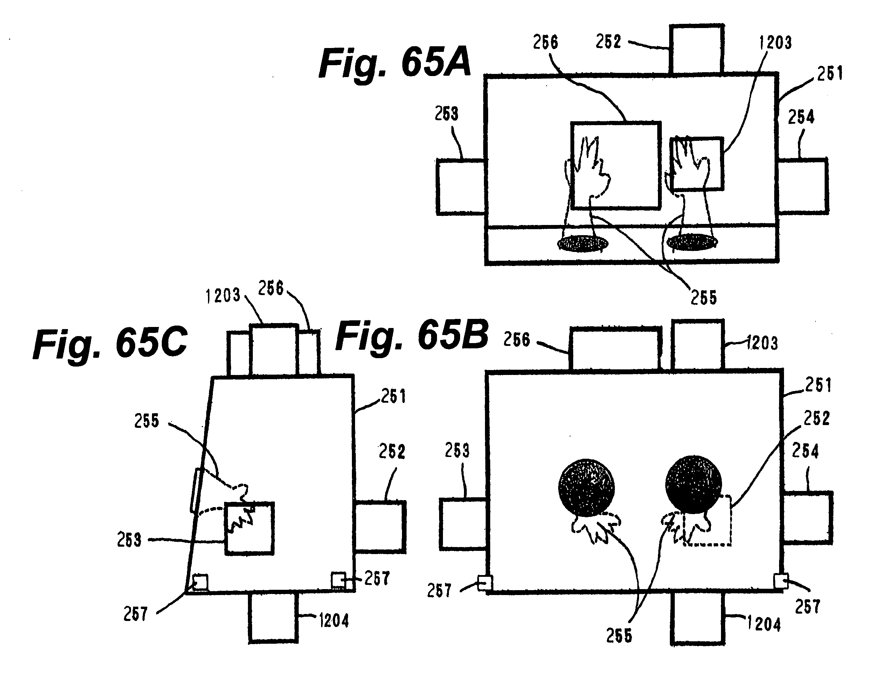

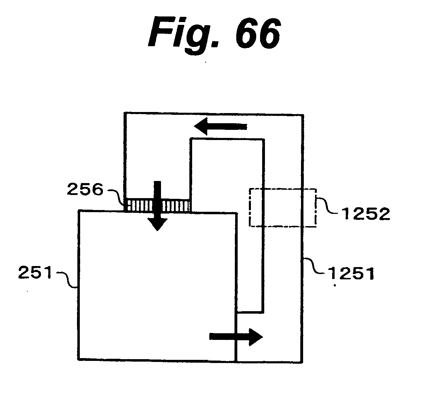

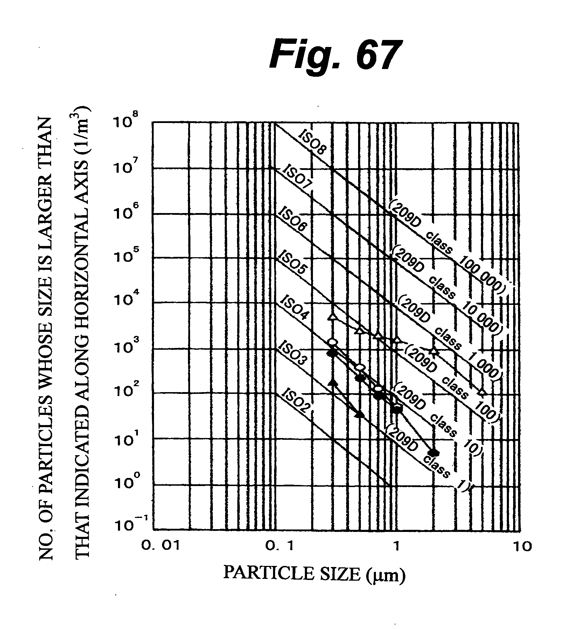

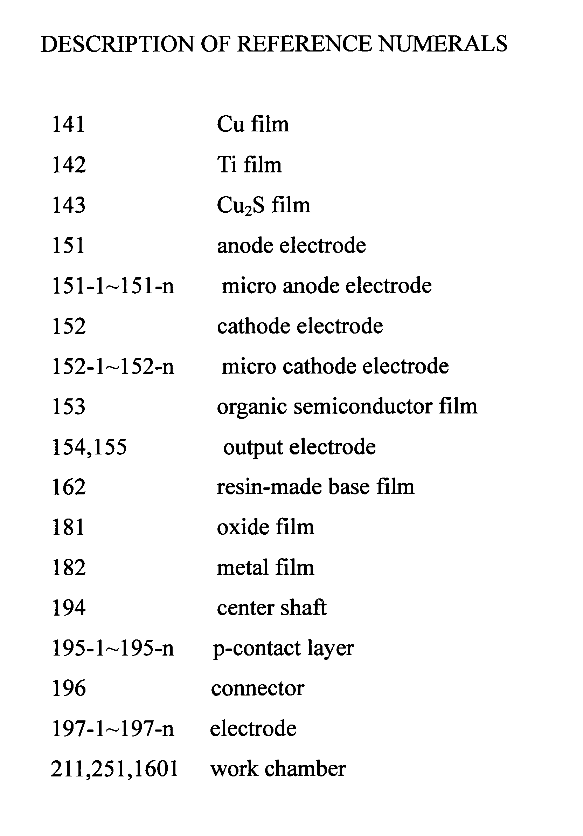

Figs. 11 through 14 are schematic diagrams showing results of calculation of the electric field distribution at the point contact as shown in Fig. 10A; Figs. 15 through 18 are schematic diagrams showing results of calculation of the electric field distribution at the intersection shown in Fig. 10B; Fig. 19 is a schematic diagram for explaining the invention; Figs. 20A, 20B, 21, 22, 23A, 23B and 23C are schematic diagrams for explaining the first embodiment of the invention; Figs. 24A, 24B and 24C are schematic diagrams showing the enlarged view of the functional device according to the first embodiment of the invention; Fig. 25 is a schematic diagram for explaining the second embodiment of the invention where an array of quantum dots is sandwiched; Fig. 26 is a schematic diagram for explaining the third embodiment of the invention; Figs. 27A and 27B are schematic diagrams for explaining the fourth embodiment of the invention concerning how to make a multi-sandwich structure; Fig. 28 is a schematic diagram for explaining the fourth embodiment of the invention; Figs. 29A and 29B are schematic diagrams for explaining the fifth embodiment of the invention concerning another way of growing spiral structure; and Figs. 30A, 30B, 30C, 30D, 30E and 30F are schematic diagrams for explaining the sixth embodiment. Fig. 31 is a schematic diagram to explain the seventh embodiment of the invention. Figs. 32A, 32B and 32C schematically illustrate the eighth embodiment of the present invention. Figs. 33A, 33B and 33C schematically illustrate the ninth embodiment of the present invention. Figs. 34A, 34B and 34C are schematic diagrams for explaining how to produce an organic solar cell according to the ninth embodiment of the present invention. Figs. 35A, 35B and 35C schematically illustrate the tenth embodiment of the present invention. Figs. 36 and 37 are schematic diagrams for explaining how to produce the organic solar cell as the tenth embodiment of the present invention. FIG. 38 schematically illustrates an example layout of the organic solar cells as the tenth embodiment of the present invention. Figs. 39, 40A and 40B schematically illustrate the twelfth embodiment of the present invention. Figs. 41A and 41B schematically illustrate how to use the catalytic reaction platform of the twelfth embodiment of the invention. Figs. 42A, 42B, 42C, 43, and 44 are schematic diagrams to explain the thirteenth embodiment of the present invention. Figs. 45A, 45B and 45C schematically illustrate the fourteenth embodiment of the present invention. Fig. 46 schematically illustrates a solar cell system using solar cells according to the fourteenth embodiment of the present invention. Figs. 47 and 48 schematically illustrate the fifteenth embodiment of the present invention. Figs. 49 and 50 schematically illustrate the solar battery system using the solar cell as the sixteenth embodiment of the present invention. Fig. 51 schematically illustrates the seventeenth embodiment of the present invention. Figs. 52A, 52B and 52C are a plan view, front view and side elevation, respectively, of a clean unit according to the eighteenth embodiment of the present invention. Figs. 53A, 53B and 53C are a plan view, front view and side elevation, respectively, of the transfer box attached to the clean unit as the eighteenth embodiment of the present invention. Figs. 54A and 54B are a side elevation and front view, respectively, of the connection between the clean unit as the eighteenth embodiment of the present invention and the transfer box. Figs. 55A and 55B are a side elevation and front view, respectively, of a charge/discharge box installed to the clean unit as the eighteenth embodiment of the present invention. Figs. 56A and 56B are a side elevation and front view, respectively, for explaining how to shield an unused connector opening of the clean unit as the eighteenth embodiment of the present invention. Figs. 57A, 57B and 57C are a plan view, front view and side elevation, respectively, of a clean unit according to an ninteenth embodiment of the present invention. Figs. 58A and 58B schematically illustrate a clean unit system according to the twentieth embodiment of the invention together, and a conventional clean unit system, respectively. Fig. 59 schematically illustrates a clean unit system according to the twenty-first embodiment of the present invention. Fig. 60 schematically illustrates a clean unit system according to the twenty-second embodiment of the present invention. Fig. 61 schematically illustrates a clean unit system according to the twenty-third embodiment of the present invention. Fig. 62 schematically illustrates a clean unit system according to the twenty-fourth embodiment of the present invention. Fig. 63 schematically illustrates a Hilbert curve. Figs. 64A, 64B and 64C are a plan view, front view and side elevation, respectively, of a clean unit according to the twenty-fifth embodiment of the present invention. Figs. 65A, 65B and 65C are a plan view, front view and side elevation, respectively, of a clean unit according to the twenty-sixth embodiment of the present invention. Fig. 66 is a front view of a clean unit according to the twenty-seventh embodiment of the present invention. Fig. 67 schematically illustrates results of cleanliness test made on the clean unit shown in Figs. 64A, 64B and 64C.

Best mode for carrying out the invention

Some embodiments of the invention will now be explained below with reference to the drawings.

First explained is the first embodiment.

In the first embodiment, a superlattice thin piece or slice is formed by electrochemical growth. Fig. 20A shows a growth apparatus for this purpose. As shown in Fig. 20A, the growth apparatus has an electrolytic bath 51 containing an electrolytic solution 54 including anions ($A^-$) 52 and cations ($C^+$) 53 corresponding to two kinds of materials to be grown. In the electrolytic solution 54, a shaft 55 having a micro-columnar electrode portion, for example, is inserted to serve as a substrate for electrochemical growth, and two electrodes 56, 57 are placed to sandwich the shaft 55. The electrode portion of the shaft 55 is grounded, and the electrodes 56, 57 can be biased to voltage Vl and voltage Vr, respectively. Alternatively, the electrodes 56, 57 may be placed to encircle the electrode portion of the shaft 55 in form of a ring. It is also acceptable to provide a partition in the electrolytic bath 51 to separate anions 52 and cations 53 and rotate the shaft 55.

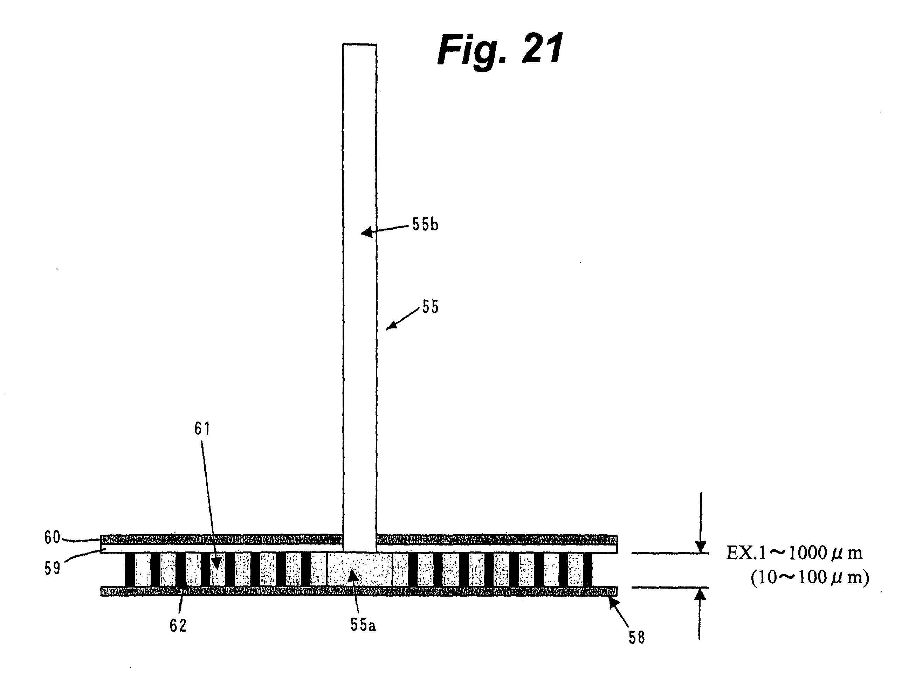

Fig. 21 shows exemplary structural details of the shaft 55. As shown in Fig. 21, the shaft 55 has a larger diameter in the electrode portion 55a serving as the substrate for growth than in the remainder portion 55b. A disk-shaped support plate 58 of glass or ceramics, for example, is mounted coaxially with the shaft 55 under the electrode portion 55a in contact therewith, and a disk-shaped support plate 60 pre-coated with an organic film 59 easy to dissolve into a solvent is mounted above the electrode portion 55a here again coaxially with the shaft 55. Diameters of the support plates 58, 60 are equal here. Distance between these support plates 58, 60 equals the thickness of the superlattice thin piece/slice (NBK) to be grown. For example, it may be 1~1000 $\mu$m. Typically, it is 10~100 $\mu$m.

To have a superlattice thin piece to grow in the growth apparatus, the electrodes 56, 57 are biased alternately to Vl=+V2 and Vr=-V1 as shown in Fig. 20B, for example. In this case, while the electrode 56 is biased to +V2, cations 53 in the electrolytic solution 54 deposit on side surfaces of the electrode portion 55a of the shaft 55. While the electrode 57 is biased to -V1, anions 52 in the electrolytic solution 54 deposit on side surfaces of the electrode portion 55a of the shaft 55. In this manner, as shown in Fig. 21, it is possible to deposit a periodically laminated structure or alternating heterostructure by alternate lateral growth of two different kinds of materials, namely, an electrodeposited organic strip/ribbon 61 difficult to dissolve into solvents, which is a dielectric element (insulator), and an electrodepositedmetal strip/ribbon 62 concentrically (in form of annual rings or baumkuchen) on side surfaces of the electrode portion 55a of the shaft 55 in the space between the support plate 58 and the organic film 59. After growth, the periodically laminated structure in form of annual rings is extracted by dissolving the organic film 59 into a solvent.

As the metal of the electrodeposited metal strip/ribbon 62, gold (Au), platinum (Pt) or copper (Cu) may be used, for example. For deposition of Au, a plating bath containing $KAu(CN)$, $(NH_9)_2HPO_4$, $K_2HPO_4$, or the like, is used. For deposition of Cu, a plating bath containing $CuSO_4 \cdot 5H_2O$, $H_2SO_4$, thiourea, or the like, is used. For deposition of Pt, a plating bath containing $(NH_4)_2PtCl$, $NaHPO_4 \cdot 12H_2O$, or the like, is used.

For growth of the electrodeposited organic strip/ribbon 61 difficult to dissolve into solvents, organic acid ions, for example, are used as the active agent (edited by Tsuguo Yamaoka, "New Development of Practical Polymeric Resist Materials, Their Applications as Photopolymers", Chapter 6, CMC Shuppan, 1996).

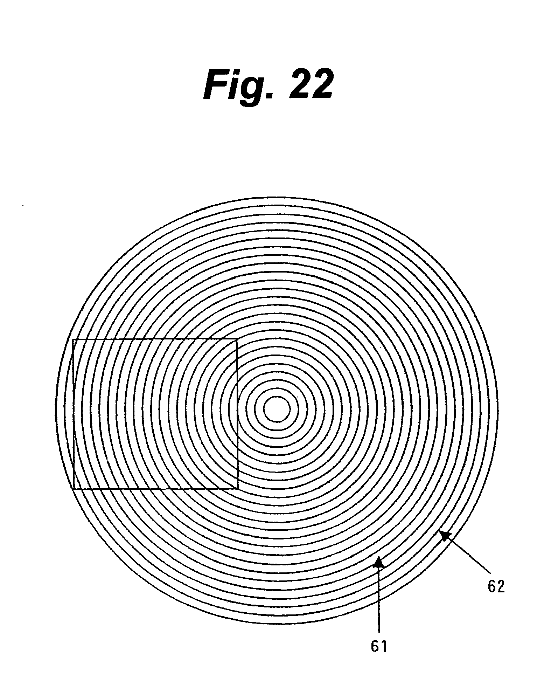

By using approximately constant growth rate for growth of the electrodeposited organic strip/ribbon 61 difficult to dissolve into solvents and the electrodeposited metal strip/ribbon 62, time interval can be projected to the structure, and as shown in Fig. 22, here is obtained a disk-shaped superlattice thin piece in form of a periodical lamination of electrodeposited organic strips/ribbons 61 difficult to dissolve into solvents and electrodeposited metal strips/ribbons 62, in which each layer has the thickness accuracy in the order of atomic layer.

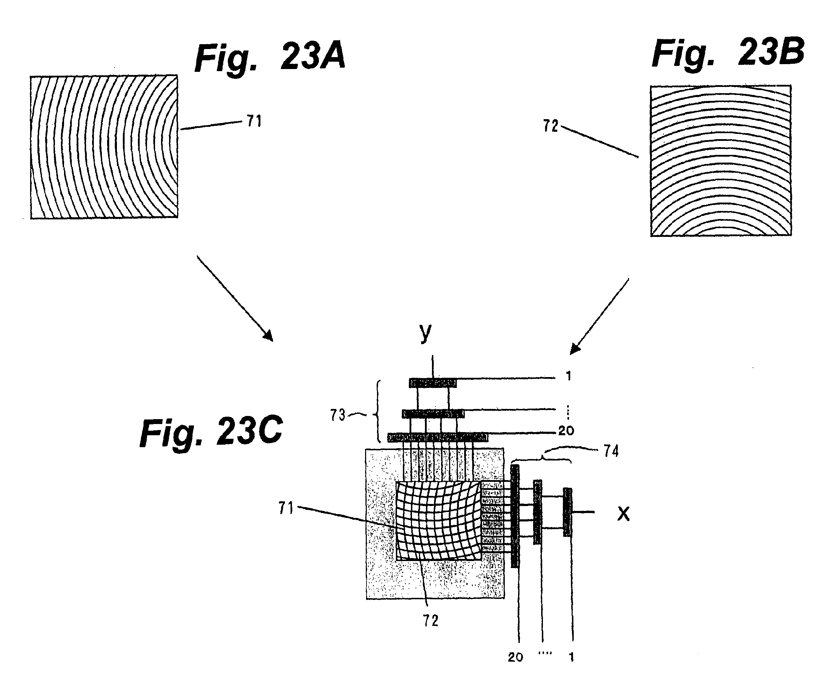

Next prepared are two cutouts as shown by the rectangular solid line in Fig. 22 from the disk-shaped superlattice thin piece. Figs. 23A and 23B show these cutouts rectangular superlattice thin pieces/slices 71, 72. As shown in Figs. 23A, 23B and 23C, the superlattice thin piece/slice 72 is superposed on the superlattice thin piece/slice 71 by rotating the relative orientation by an angle, typically, by 90 degrees. Here is completed a superlattice whose two-dimensional minimum units can be accessed by signals and information as an artificial neuron system. Accuracy of this superlattice can be enhanced to the order of an atomic layer. Strictly, the electrodeposited organic strip/ribbon 61 difficult to dissolve into solvents and the electrodeposited metal strip/ribbon 62 of each superlattice thin piece/slice 71, 72 are arcuate. However, the period of the electrodeposited metal strip/ribbon 62 is nearly 10 nm and very small, both the electrodeposited organic strips/ribbons 61 and the electrodeposited metal strips/ribbons 62 can be regarded straight. Therefore, this superlattice has substantially the same structure as that shown in Fig. 19.

If the superlattice thin pieces/slices 71, 72 each include N electrodeposited metal strips/ribbons 62, the electrodeposited metal films 62 of the superlattice thin piece/slice 71 and the electrodeposited metal strips/ribbons 62 of the superlattice thin piece/slice 72 makes $N^2$ intersections in total in Fig. 23C. In this case, these intersections (addresses) are easily accessible through each electrodeposited metal strip/ribbon 62 of the superlattice thin pieces/slices 71, 72. For example, as shown in Fig. 23C, by connecting relay circuits 73, 74 to individual electrodeposited metal strips/ribbons 62 appearing along edges of the superlattice thin pieces/slices 71, 72, which address should be accessed to can be controlled. More specifically, assuming that one side of the superlattice thin pieces/slices 71, 72 is 1 cm long, and the distance between adjacent electrodeposited metal strips/ribbons 62 is 10 nm, then 1 cm/10 nm = $10^{-2}m/10^{-8}m=10^6\sim2^{20}$. Thus, 20 stages of relay circuits 73, 74 can select $2^{20}\sim10^6$ electrodeposited metal strips/ribbons 62, and access to addresses can be controlled by approximately 20-bits information (per one degree of freedom on the x-y plane), for example.

At $N^2$ intersections made by the electrodeposited metal strips/ribbons 62 of the superlattice thin piece/slice 71 and the electrodeposited metal strips/ribbons 62 of the superlattice thin piece/slice 72, bottom-up structures having desired functions are built. For this purpose, quantum dots may be grown by self-organization or self-assembly on the superlattice thin piece/slice 71, for example, used as a substrate, and the other superlattice thin piece/slice 72 may be superposed thereon. Alternatively, a functional material layer (such as inorganic molecules or organic molecules) may be inserted between the superlattice thin pieces/slices 71, 72, and energy may be injected by applying a current between the electrodeposited metal strips/ribbons 62 that are opposed transversely. Thereby, a self-organized critical phenomenon arises, and as a result, a structure having a bottom-up structure between the superlattice thin pieces/slices 71, 72 can be obtained. In the case where bottom-up structures to be built at $N^2$ intersections of the superlattice thin pieces/slices 71, 72 are made finally by injection and dissipation of energy, these bottom-up structures can be formed automatically in self-alignment with the individual intersections without the need of positioning for alignment. In this case, the electrodeposited metal strips/ribbons 62 of the superlattice thin piece/slice 71 and those of the superlattice thin piece/slice 72 need not intersect at right angles, and it is the only requirement that they connect to edges. These bottom-up structures may be simple memory devices, for example, or bottom-up devices having acquired sophisticated functions by self-organization mentioned above. Dimension of the mesh structure by the electrodeposited metal strips/ribbons 62 of the superlattice thin pieces/slices 71, 72 is between 1 and the dimension 2 of the bottom-up system (plane system in this case), and here is established a relation equivalent to the dimension of living neuron systems being smaller than the dimension of cell systems. The source material as the basis for forming the bottom-up structures may be introduced by intercalation or by sandwiching, for example. It is also possible to sharpen the knife-edges of the electrodeposited metal films 62 by electrolytic etching before the intercalation/sandwiching. Thereby, it is possible to enhance the surface strengthening effect and compose the bottom-up structures built at intersections of the electrodeposited metal strips/ribbons 62 of the superlattice thin pieces/slices 71, 72 from fewer atomic groups (molecular groups).

A functional device is made by connecting the above-explained two-dimensional structure including bottom-up structures sandwiched by the superlattice thin pieces/slices 71, 72 to a silicon LSI. That is, as shown in Fig. 24A, the two-dimensional structure 82 is mounted on a substrate 81. Then, the electrodeposited metal strips/ribbons 62 of the superlattice thin piece/slice 72 are connected to a wiring connector 84 via a connection pad 83, and the electrodeposited metal strips/ribbons 62 of the superlattice thin piece/slice 71 are connected to a wiring connector 85. The connection pad 83 is in form of crossties, and its thickness is approximately equal to the difference between the top surface of the wiring connector 84 and the bottom surface of the superlattice thin piece/slice 72. Fig. 24B shows the connection between electrodeposited metal strips/ribbons 62 of the superlattice thin piece/slice 72 and the connection pad 83 in an enlarged scale. The connection pad 83 has electrode 83b formed with narrow spacing 83a with the electrode 83b having a width approximately equal to the thickness of the electrodeposited organic strip/ribbon 61, and these electrode portions 83b are connected to the electrodeposited metal strips/ribbons 62. Fig. 24C shows the connection between electrodeposited metal strip/slice 62 of the superlattice thin piece/slice 71 and the wiring connector 85 in an enlarged scale. The wiring connector 85 has electrode 85b formed with narrow spacing 85a with the electrode 85b having a width approximately equal to the thickness of the electrodeposited organic strip/ribbon 61. The wiring connectors 84, 85 are connected to top-down LSI 87 having desired functions via a wiring 86. Thereby, the two-dimensional structure 82 is connected to LSI 87, and here is obtained the highly functional device as a whole. LSI 87 is typically a silicon LSI, but may be an LSI using other semiconductors such as GaAs or other compound semiconductors. LSI 87 may be a chip mounted on the substrate 81. Alternatively, using a semiconductor substrate like a silicon substrate as the substrate 81, the circuit may be formed by LSI process.

Connection between the electrodeposited metal strips/ribbons 62 of the superlattice thin pieces/slices 71, 72 and the connection pad 83 or the wiring connector 85 may be made by N junctions per one side. Ratio between the number of junctions and the number of intersections of the superlattice thin pieces/slices 71, 72 for building the bottom-up structures are scaled by 1/N. Therefore, contrary to conventional techniques inviting the positional alignment error $N^2$, the embodiment of the invention can reduce the positional alignment error as the value of N increases, or in other words, as the degree of integration increases, and can therefore improve the production yield of devices than conventional techniques. Especially, as shown in Figs. 24B and 24C, the embodiment of the invention can approximately equalize the width of each electrode 83b of the connection pad 83 to the width (thickness) of each electrodeposited organic strip/ribbon 61 difficult to dissolve into solvents, which is the dielectric element of the superlattice thin piece/slice 72, and can approximately equalize the width of each electrode portion 85b of the wiring connector 85 to the width (thickness) of each electrodeposited organic strip/ribbon 61, which is the dielectric element of the superlattice thin piece/slice 72. Therefore, the embodiment can increase the margin for positional alignment between the electrodeposited metal strips/ribbons 62 of the superlattice thin pieces/slices 71, 72 and the electrode 83b, 85b, and this contributes to enhancement of the production yield of devices as well. The top-down system comprising LSIs 87 represented by silicon LSIs has a spatially anisotropic structure in which time is projected discontinuously as explained before, i.e. the structure characterized by (time projectivity, spatial directionality) = $(\downarrow,\downarrow)$ according to the foregoing notation. Further, since the bottom-up structure sandwiched between the superlattice thin pieces/slices 71, 72 is formed as an autonomous decentralized system, time is continuously projected in the structure. Therefore, it has no particular orientation in general, and has, to good approximation an isotropic configuration. Thus, the configuration is characterized by (time projectivity, spatial directionality) = $(\uparrow,\uparrow)$. Therefore, these both structures, even when directly positioned side by side, exhibit the relation of $(\uparrow,\uparrow)$ $(\downarrow,\downarrow)$, and the arrows flip. Therefore, these structures do not couple directly. In contrast, the said two-dimensional structure 82 has an anisotropic configuration with time being continuously projected in the growth direction, that is, the configuration characterized by (time projectivity, spatial directionality) = $(\uparrow,\downarrow)$. In the functional device shown in Figs. 24A, 24B and 24C, the two-dimensional structure 82 having the property $(\uparrow,\downarrow)$ is put connecting or uniting between bottom-up structure having the property $(\uparrow,\uparrow)$ and the LSI 87 with a top-down configuration having the property $(\downarrow,\downarrow)$. As a result, the relations of united structure characterized by $(\uparrow,\uparrow)(\uparrow,\downarrow)(\downarrow,\downarrow)$ are established with the neighboring arrows aligning without flips. Therefore, $(\uparrow,\uparrow)$ structures and $(\downarrow,\downarrow)$ structures, i.e. bottom-up systems and top-down systems, can be connected or united adequately enabling inter-accessibility.

Thus, the first embodiment makes it possible to easily realize a functional device having sophisticated functions capable of making the best use of advantages of a bottom-up system and a top-down system represented by silicon LSI. This functional device can exhibit various functions depending upon a combination of functions assigned to the bottom-up system and functions assigned to silicon LSI.

Next explained is the second embodiment of the invention. This embodiment uses quantum dots as the bottom-up structures.

As shown in Fig. 25, a two-dimensional structure 82 is mounted in a central part of the substrate 81 in the second embodiment. In this case, quantum dots 91 are inserted as bottom-up structures at crosswise intersections of electrodeposited metal strips/ribbons 62 of the superlattice thin pieces/slices 71, 72 of the two-dimensional structure 82. Period and thickness of the electrodeposited metal strips/ribbons 62 of the superlattice thin pieces/slices 71, 72 can be sufficiently smaller than the period of the array of the quantum dots 91. Therefore, the quantum dots 91 can be accessed electrically by one-to-one addressing with crosswise intersections of the electrodeposited metal strips/ribbons 62 of the superlattice thin pieces /slices 71, 72. That is, quantum dots 91 need not exist at all crosswise intersections, but all quantum dots 91 are always associated with crosswise intersections. This redundancy enhances the production yield of quantum dot devices, and induces the role of side-gates to diodes composed of crosswise intersections having, for example, quantum dots as active portions. Thus, it is possible to configure the quantum-dot device as a triple-terminal device although it was extremely difficult. In this case, it is effective to use as the superlattice thin pieces/slices 71, 72 a lamination-repeated structure of a conductive hetero-layered structure composed of dielectric layer and slightly thicker dielectric layer, i.e. a structure having two high and low spatial frequencies.

The structure shown in Fig. 25 is applicable as a flat display as well. Quantum dots 91 used in this display are light emitting quantum dots, and they may be light emitting organic molecular monomer, oligomer or polymer. In addition, since the superlattice thin pieces/slices 71, 72 have freedom in thickness, here is the advantage that the electrodeposited metal strips/ribbons 62 can be configured to as very thin conductive lines having high conductivity. In this flat display, since each crosswise intersection has a small area, it does not make a large shadow. Therefore, a bright screen can be realized with low power consumption. Further, although not shown, by using a lamination-repeated structure of a conductive two-layered structure sandwiching an extremely thin dielectric layer and a slightly thicker dielectric layer as explained above, i.e. a structure having two high and low frequencies as the spatial frequency, as the vertical and horizontal electrodeposited metal strips/ribbons 62, i.e. the respective conductive lines, redundancy can be introduced. This redundancy reduces the risk of losing pixels by defects of the active portions, for example, and enhances the production yield.

Moreover, the configuration of Fig. 25 can be used not only as optical devices but also as electronic devices by controlling positions and charged conditions of functional groups of, for example, $\pi$ electron organic molecules inserted at the crosswise intersections. Therefore, it can be used as integrated molecular electronics devices. Moreover, the above-explained redundancy obtained by using a superlattice thin piece structure having two high and low frequencies as the spatial frequency is very effective to enhance the fault tolerance needed in molecular electronic devices.

The outer circumferential portion 81a of the substrate 81 is the region for locating top-down LSIs. However, they need not be provided all around, and may be provided locally.

Where appropriate, a multi-layered structure may be used, and top-down LSIs can be provided on and under the entire surface including the central portion of the substrate 81.

The frame portion 81b around the two-dimensional structure 82 connects to the electrodeposited metal strips/ribbons 62 extending in parallel in the x and y directions and accessing to $N^2$ intersections of the two-dimensional structure 82 with the same configuration as that of Figs. 24B and 24C.

In the other respects, the second embodiment is identical to the first embodiment within the extent not contradict to its nature.

The second embodiment ensures the same advantages as those of the first embodiment as well.

Next explained is the third embodiment of the invention.

As shown in Fig. 26, the third embodiment uses a plane having self-similarity and a hierarchical configuration, i.e. a plane 92 having a fractal structure, as the bottom-up structure instead of the array of quantum dots used as the bottom-up structure in the second embodiment. Here again, the redundancy obtained by using a superlattice thin piece structure having two high and low frequencies as the spatial frequency is greatly effective to enhance robustness of the system.

In the other respects, the third embodiment is identical to the first and second embodiments within the extent not contradict to its nature.

The third embodiment ensures the same advantages as those of the first and second embodiments as well.

Next explained is the fourth embodiment of the invention.

In the fourth embodiment, as shown in Fig. 27A, two shafts 101, 102 are set in a spaced parallel relation in the electrolytic solution 54 of the growth apparatus used in the first embodiment. In the lengthwise direction of the shaft 101, a plurality of electrode portions 101a are provided in equal intervals, for example. In the lengthwise direction of the shaft 102, a plurality of electrode portions 102a are provided in equal intervals, for example, in an alternate relation with the electrode portions 101a. Above and under the lowermost electrode portion 101a of the shaft 101, a support plate 103 and a resin plate 104 easy to dissolve into solvents are mounted via a predetermined distance. Above and under the next electrode portion 101a, two resin plates 105, 106 easy to dissolve into solvents are mounted via a predetermined distance. Above and under the still next electrode portion 101a, similar two resin plates 107, 108 easy to dissolve into solvents are mounted via a predetermined distance. On the other hand, above and under the lowermost electrode portion 102a of the shaft 102, two resin plates 109, 110 easy to dissolve into solvents are mounted via a predetermined distance. Above and under the next electrode portion 102a, two resin plates 111, 112 easy to dissolve into solvents are mounted via a predetermined distance. Above and under the still next electrode portion 102a, a resin plate 113 easy to dissolve into solvents and a support plate 114 are mounted via a predetermined distance. These combinations of every two plates are alternate with those mounted on the shaft 101. In this case, these support plates 103, 114 and resin plates 104 to 113 easy to dissolve into solvents are disk-shaped, and their radii are slightly smaller than the distance between the shafts 101, 102. Therefore, the support plate 103 and the resin plates 104 through 108 mounted on the shaft 101 overlaps with the resin plates 109 through 113 and the support plate 114 mounted on the shaft 102 in space between the shafts 101, 102.

With this growth apparatus, growth is done as explained below, for example.

An electrically conductive organic resist (not shown) is first coated on side surfaces of the electrode portions 101a of the shaft 101 and the electrode portions 102a of the shaft 102 before hand. Here is used an organic resist that dissolves into a solvent used for dissolving the resin plated 104 through 113 easy to dissolve into solvents. After that, in the same manner as the first embodiment, a periodically laminated structure is formed by alternate lateral growth on side surfaces of the electrode portions 101a via an electrically conductive organic resist in the space between the support plate 103 and the resin plate 104 easy to dissolve into solvents both mounted on the shaft 101, the space between the resin plates 105, 106 and the space between the resin plates 107, 108. Similarly, also in the space between the resin plates 109, 110 easy to dissolve into solvents, both mounted on the shaft 102, the space between the resin plates 111, 112 and the space between the resin plate 113 and the support plate 114, a periodically laminated structure is formed by lateral growth on side surfaces of the electrode portions 102a via a electrically conductive organic resist. The periodically laminated alternatingly heterolayered structure grown on side surfaces of the electrode portions 101a may be either identical to or different from the periodically laminated structure grown on side surfaces of the electrode portions 102a. Subsequently, the electrolytic solution 54 is discharged from the electrolytic bath 51, and a predetermined solvent is introduced to dissolve the electrically conductive organic resist coated on the resin plates 104 through 113 and side surfaces of the electrode portions 101a, 102a. As a result, individual disk-shaped superlattice thin pieces 115 formed by lateral growth on side surfaces of the electrode portions 101a and individual disk-shaped superlattice thin pieces 116 formed by lateral growth on side surfaces of the electrode portions 102a sink down and accumulate alternately. In this manner, a laminated structure composed of alternate accumulation of superlattice thin pieces is obtained.

After that, the laminated structure is taken out from the electrolytic bath, and portions shown by solid-line rectangles in Fig. 27B are cut out. Thereby, superlattice thin-piece three-dimensional laminations are obtained as shown in Fig. 28, for example. By using these superlattice thin-piece three-dimensional laminations, a functional device is fabricated in the same manner as the first embodiment.

In the other aspects, the fourth embodiment is identical to the first embodiment, and their explanation is omitted here.

The fourth embodiment has an additional advantage that the functional device is significantly enhanced in functionality and degree of integration by using superlattice thin-piece three-dimensional laminations to form the functional device, in addition to the same advantages as those of the first embodiment.

Next explained is the fifth embodiment of the invention.

Fig. 29A is a plan view of a vacuum chamber 121 of a vacuum evaporation apparatus, and 29B is the side view of it. As shown in Figs. 29A and 29B, the fifth embodiment winds a resin base film 123 in form of a narrow thin flat tape on a roller 122 beforehand, and after forming a thin metal film (not shown) by evaporating a metal, for example, on one surface of the resin base film 123 from an evaporation source 124, winds up the resin base film 123 with the metal film thereon onto a take-up roller 125. Reference numeral 126 denotes support plates that support the roll of resin base film 123 from opposite sides thereof.

Once the resin base film 123 with the metal film is wound up onto the take-up roller 125, it makes a spiral structure in which the resin base film 123 and the metal film are laminated alternately. This spiral heterolayered structure is approximately equivalent to the concentrical structure shown in Fig. 22. Therefore, a superlattice thin film can be obtained based on the spiral structure in the same manner as the first embodiment.

The fifth embodiment has the same advantages as those of the first embodiment.

Next explained is the sixth embodiment of the invention.

In the sixth embodiment, superlattice thin pieces/slices 71, 72 are made by the imprinting method shown in Figs. 30A through 30E. First as shown in Fig. 30A, a nanostructure die 132 having a pattern configuration identical to the electrodeposited metal film 62 of the first embodiment is driven into a resin substrate 131 as shown in Fig. 30B for pressing. The nanostructure die 132 is removed thereafter from the resin substrate 131 as shown in Fig. 30C. After that, as shown in Fig. 30D, a metal film 133 is deposited onto the resin substrate 131 by vacuum evaporation, for example, to bury the grooves formed into the resin substrate 131 by the pressing using the nanostructure die 132 with the metal film 133. Next as shown in Fig. 30E, the resin substrate 131 undergoes etching from top and bottom, surplus of the metal film 133 is removed from the top surface, and the metal film 133 formed on the back surface is exposed. As a result, as shown in Fig. 30F, superlattice thin pieces/slices 71, 72 with metal film 133 are obtained.

In the other respect, the sixth embodiment is identical to the first embodiment to the extent not contradict to its nature.

The sixth embodiment has the same advantages as those of the first embodiment.

Next, explained is the seventh embodiment of the invention.

In the seventh embodiment, utilized is ROM feature of the first embodiment shown in Figs. 24A, 24B, and 24C. The electrodeposited organic strip/ribbon 61 difficult to dissolve into solvents and the electrodeposited metal strip/ribbon 62 of each superlattice thin piece/slice 71, 72 are here considered to be general organic/inorganic dielectric materials and conductors/metals grown by various methods. Here the thickness of said dielectric layer is 10 nm~100nm, and that of said conductor/metal 1nm ~ 10nm. LSI 87 being connected to thin piece/slice 71, 72 has, for example, an inverter (decorder).

Fig. 31 shows said ROM circuit schematically. In this ROM, if N strips/ribbons of metal are in thin piece/slice 71, 72, the memory capacity of said ROM is $N^2$ bits, since there are $N^2$ crossing points existing in the interface between thin slice/piece 71 and 72. Here numbers i=1~N are put on said N metal strips on thin film 71, and numbers j=1~N are put on said N metal strips on thin film 72. There formed is a thin natural oxidation layer (not shown) on principal surface of films 71 and 72, i.e., the surfaces of them facing to each other. For example in case of Al metal stries $Al_2O_3$ is formed, and thus at each cross, metal stripe/ribbon of superlattice thin film/slice 71 faces that of 72 in edge-to-edge configuration via the natural oxide layer. Here j-th of N metal strips/ribbons of superlattice thin film 72 is connected to one end/terminal of inverter $I_j$ (j=1~N). The other side of the inverter is grounded. Each end of N-matal strips/ribbons of superlattice thin film 71 is connected to an appropriate power supply through load $R_L$.

Nest, explained is the operation principle of said ROM.

First described is how to write information. When an information is written in memory cell $A_{ij}$ at address (i,j), i.e., the cross-point defined by strips/ribbons i and j. Here, by putting "high " level on $G_i$ that is component of inverter $I_j$ being connected to the j-th metal strip/ribbon of superlattice thin film 72, the corresponding n-channel FET is turned on. Here said natural oxides between said strips/ribbons is punched through by putting high voltage between superlattice thin film 71 and 72 by power supply, and the cross becomes conductive. Now it can be considered that, for example, information "1" is written in the conductive cross, and information "0" is written in a non-conductive cross for which oxide layer is not punched through, By doing that procedure for all the cell of selected addresses, information can be written in.

Next explained is how to read out.

When an information is read from memory cell $A_{ij}$ at address (i, j), i.e., the cross-point defined by strips/ribbons i and j, by putting "high " level on $G_i$ that is component of inverter $I_j$ being connected to the j-th metal strip/ribbon of superlattice thin film 72, the corresponding n-channel FET is turned on, and also high level signal is put in the i-th metal strip/ribbon of superlattice thin film/slice 71 by power supply. Then, if information "1" is written on memory cell $A_{ij}$, i.e., if the oxide layer is punched through there, current flows through the i-th metal strip/ribbon of film 71 via load $R_L$. As a result, the potential at the other end of the metal strip $A_i'$ becomes low. When "low " level is put in gate $G_i$ of n-channel FET being component of inverter $I_j$, current never flows through the i-th metal strip/ribbon of film 71 via load $R_L$. As a result, the potential at the other end of the metal strip $A_i'$ remains high. On the other hand, if information "0" is written in memory cell $A_{ij}$, i.e., if the cross is not conductive due to oxide layer being not punched through, no current flows through the i-th metal strip/ribbon of film 71 via load $R_L$ no matter how the n-channel FET being a component of inverter Ij is, ie., on or off. As a result, the potential at the other end of the metal strip $A_i'$ remains high.

As described above, a new ROM device whose memory cell has superlattice thin film/slice 71, 72. according to the seventh embodiment of the invention. The memory capacity of said ROM can be as large as 10 ~ 160 Gbits/cm$^2$. Also, since said ROM, being able to be made flexible, can be installed in many electronic apparatuses. Further, said ROM, being made of superlattice thin film/slice 71, 72, can be made lithography-free, which leads to low cost production. Said ROM can be used as disposable memory and appropriate for ubiquitous information processing apparatus, etc.

Next, explained is the eighth embodiment of the invention.

In the eighth embodiment, in the said ROM by the seventh embodiment of the invention, used is so called nano-bridge structure (Internet <URL: http://www.nec.co.jp/press/ja/0402/1801-01.htm>, as of 18 Feb. 2004) at the cross of strips/ribbons of superlattice thin film/slice 71 and 72. Here Cu film is used for metal strips/ribbons in superlattice thin film/slice 71, Ti is used as metal strips/ribbons in superlattice thin film/slice 72, and $Cu_2S$ is used as the material inserted at the cross.

Fig. 32A shows the structure of the cross made of those metals. In Fig. 32A, reference numeral 141 denotes the Cu metal layer in superlattice thin film/slice 71, reference numeral 142 said Ti metal layer in superlattice thin film/slice 72, and Tag Number 143 said $Cu_2S$. When Ti layer 142 is negatively biased, oxidation occurs at the surface of Cu layer 141, and Cu atom becomes Cu+ ion, which desolbes into $Cu_2S$ 143. On the other hand, reduction occurs at the surface of Ti layer 42, and Cu+ in $Cu_2S$ 143 becomes Cu and precipitates. Reference numeral 144 shows said Cu precipitation. As shown in Fig. 32B, when said precipitated Cu reaches at Cu film 141 to form metal bridge made of Cu precipitation region 144, and the cross becomes "ON". When positive bias is applied to Ti film 142, reversed reaction takes place, and then, as shown in Fig. 32C, the nano-bridge diminishes and the cross becomes "OFF". Using phenomena described above, information can be written in said memory cell.

In the other aspects, the eighth embodiment is almost identical to the seventh embodiment.

The eighth embodiment has an additional advantage to the seventh embodiment that the information can be written non-destructively.

Next, a functional device as the ninth embodiment of the present invention will be explained below:

The ninth embodiment of the present invention is a functional device having a periodic structure, that is, a structure in which the time is continuously factored and to which access is to be made from a direction perpendicular to the direction in which the time is projected into or factored. This functional device is formed from a slice of a periodic spiral structure including a strip- or ribbon-shaped conductor layer of a metal or the like and a non-metal layer having a thickness more than double that of the conductor layer, and which accesses light (sunlight or the like) from a direction intersecting, preferably perpendicular to, the slice.

More specifically, the functional device is an organic solar cell as the ninth embodiment of the present invention as shown in Figs. 33A, 33B and 33C which are a front view, rear view and side elevation, respectively. As shown in Figs. 33A, 33B and 33C, the organic solar cell is formed from a spiral structure composed of an anode 151 and cathode 152 with an organic semiconductor layer 153 laid between the anode 151 and cathode 152. The solar cell has the general form of a thin disk as shown. An insulating layer (not shown) is provided where the anode 151 and cathode 152 are in a back-to-back relation to electrically insulate the anode 151 and cathode 152 from each other. On the back of the organic solar cell, linear output electrodes 154 and 155 are provided radially from the center of the solar cell. It should be noted that the output electrode 154 is in contact with the anode 151, while the output electrode 155 is in contact with the cathode 152.

The organic semiconductor layer 153 has a structure of heterojunction or bulk-heterojunction type. In the heterojunction type structure, organic semiconductor layer 153, a p-type organic semiconductor film and an n-type one are joined to each other to be in contact with the anode 151 and cathode 152, respectively. The bulk-heterojunction type structure, organic semiconductor layer 153 is a fine one, and formed from a mixture of p-type organic semiconductor molecules and n-type ones, and the p-type organic semiconductor film and n-type one are in such an intricate relation as to be in contact with each other. The organic semiconductor layer 153 may be formed from any one of common materials having ever been reported as those for the organic solar cell, more particularly, polyacetylene (preferably a double-substituted polyacetylene), poly(p-phenylene vinylene), poly(2, 5-thienylene vinylene), polypyrrole, poly(3-methyl thiophene), polyaniline, poly(9, 9-dialkyl fluorene) (PDAF), poly(9, 9-dioctyl fluorene-co-bithiophene) (F8T2), poly(1-hexyl-2-phenylacetylene) (PhxPA) (as a light-emitting material to emit blue light), poly(diphenyl acetylene) derivative (PDPA-nBu)(as a light-emitting material to emit green light), poly(pyridine) (PPy), poly(pyridyl vinylene) (PPyV), thiano-substituted poly(p-phenylene vinylene) (CNPPV), poly(3, 9-di-tert-buthylindeno[1, 2-b]fluorene (PIF) and the like. For these organic semiconductor dopants, alkali metal (Li, Na, K or Cs) may be used as donor, halogen ($Br_2$, $I_2$ or $Cl_2$), Lewis acid ($BF_3$, $PF_5$, $AsF_5$, $SbF_5$ or $SO_3$), transition metal halide ($FeCl_3$, $MoCl_5$, $WCl_5$ or $SnCl_4$) be used as acceptor, and TCNE or TCNQ be used as organic acceptor molecule. Also, for the dopant ion used in the electrochemical doping, tetraethyl ammonium ion ($TEA^+$), tetrabutyl ammonium ion ($TBA^+$), $Li^+$, $Na^+$ or $K^+$ may be used as cation and $ClO_4^-$, $BF_4^-$, $PF_6^-$, $AsF_6^-$, $SbF_6^-$ or the like be used as anion.

Further, a polyeletrolyte may be used as the organic semiconductor layer 153. More specifically, the polyelectrolytes usable as the organic semiconductor layer 153 include sulfonate polyaniline, poly(thiophene-3-acetic acid), sulfonate polystyrene, poly(3-thiophene alkane sulfonate), etc. as polyaniline, and polyallyl amine, poly(p-phenylene-vinylene) precursor polymer, poly(p-methyl pyridinium vinylene), protonated poly(p-pyridil vinylene), proton(2-N-methyl pyridinium acetylene), etc. as polycation.

The anode 151 and cathode 152 should preferably be made of metals different in work function from each other, respectively. More specifically, the anode 151 is made of Au or Ni, while the cathode 152 is of Al.

The organic semiconductor layer 153 of the organic solar cell is 70 to 100 nm thick, and the anode 151 and cathode 152 are about 100 nm in thickness. The height (thickness) of the organic solar cell, that is, the height of the organic semiconductor layer 153, is designed large enough for light incident from a direction perpendicular to the surface of the organic solar cell to be almost all or completely absorbed for photoelectric conversion. More specifically, the selected height ranges from about a few $\mu$m to 1 mm.

Next, how to produce the organic solar cell will be explained by way of example. It should be noted that in this solar cell, the p-type organic semiconductor film and n-type one are joined to each other in the organic semiconductor layer 153 (heterojunction structure). Figs. 34A, 34B and 34C are a front view, side elevation and plan view, respectively, to show a vacuum evaporation apparatus to be used for production of the organic solar cell.

First, with a thin, flat tape-shaped resin-made base film 162 having a predetermined width, for example, being wound on a supply roller 161, a metal for the cathode is vaporized from a evaporation source 163 to form the cathode 152 on one side of the resin-made base film 162 as shown in Figs. 34A, 34B and 34C. Next, an n-type organic semiconductor is vaporized from a evaporation source 164 to form an n-type organic semiconductor film on the one side of the resin-made base film 162. Then, a p-type organic semiconductor is vaporized from a evaporation source 165 to form a p-type organic semiconductor film on the one side of the resin-made base film 162. Further, the metal for the anode is vaporized from the evaporation source 163 to form the anode 151 on the one side of the resin-made base film 162. Then, the deposited films thus deposited are taken up on a take-up roller 166. In this case, the resin-made base film 162 should be a heat- or light-separable one. That is, the resin-made base film 162 has to be separated from the deposited films. In order to prevent the resin-made base film 162 from being wound onto the take-up roller 166 together with the cathode 152, n-type organic semiconductor film, p-type organic semiconductor film and anode 151 going to be formed spiral on the take-up roller 166, the resin-made base film 162 is pressed at the other side thereof with a hot roller, or irradiated at the other side with light, just before it is wound onto the take-up roller 166. Thus, the resin-made base film 162 is separated from the cathode, semiconductor films and cathode. Reference numerals 166 to 171 indicate electrodes to energize the evaporation sources 163 to 165. The roller 161 having the resin-made base film 162 wound thereon and the take-up roller 166 are accommodated as a whole in a housing 172 open at the bottom thereof so that evaporation beams from the evaporation sources 163 to 165 will be irradiated from the open bottom of the housing 172 to the resin-made base film 162.

As shown in Fig. 34B, all the housing 172 and rollers 161 and 166 accommodated in the housing 172 can be tilted from a vertical plane indicated with a dotted line, so that the evaporation can be made obliquely as appropriate.

Also, a metallic shield plate (not shown) having an opening of 1 to 3 mm in diameter, for example, formed therein is actually formed at each of the evaporation sources 163 to 165 to minimize the heat radiation from the evaporation sources 163 to 165 to the resin-made base film 162.

According to this ninth embodiment, the anode 151 and cathode 152 are formed spiral with the organic semiconductor layer 153 being laid between them to provide a thin, disk-shaped organic solar cell. Thus, the p-n junction area per unit area of the organic solar cell is extremely large so that light incident perpendicularly upon the surface of the organic solar cell can be absorbed in an increased light absorption area of the organic semiconductor layer 153. Generally, the organic semiconductor layer 153 is high in electrical resistance, but the electrical resistance can be reduced sufficiently by forming the organic semiconductor layer 153 sufficiently thin. Thus, it is possible to provide an organic solar cell being highly flexible and having a high efficiency of photoelectric conversion.

Next, the tenth embodiment of the present invention will be explained:

Figs. 35A, 35B and 35C which are a front view, rear view and side elevation, respectively, schematically illustrate together an organic solar cell as the tenth embodiment. As shown in Figs. 35A, 35B and 35C, this organic solar cell is formed hexagonal-spiral from the anode 151 and cathode 152 with the organic semiconductor layer 153 being laid between the latter. Namely, it has the general form of a thin, hexagonal plate. In other respects, this organic solar cell is similar to that as the ninth embodiment.

Here will be explained how to produce this organic solar cell by way of example. It should be noted that the organic semiconductor layer 153 has the heterojunction type structure in which a p-type organic semiconductor film and n-type organic semiconductor film are joined to each other. Fig. 36 shows a vacuum evaporation apparatus used for production of this organic solar cell, and Fig. 37 shows winding of the resin-made base film 162 having the deposited films thereon onto the take-up roller 166.

With a thin, flat tape-shaped resin-made base film 162 having a predetermined width, for example, being wound on a supply roller 161, a metal for the cathode is vaporized from a evaporation source 163 to form the cathode 152 on one side of the resin-made base film 162 as shown in Fig. 36. Next, an n-type organic semiconductor is vaporized from a evaporation source 164 to form an n-type organic semiconductor film 153a on the one side of the resin-made base film 162. Then, a p-type organic semiconductor is vaporized from a evaporation source 165 to form a p-type organic semiconductor film 153b on the one side of the resin-made base film 162. Further, the metal for the anode is vaporized from the evaporation source 163 to form the anode 151 on the one side of the resin-made base film 162. Then, the deposited films thus deposited are taken up on a hexagonal take-up roller 166. In other respects, this method of organic solar cell is similar to that having been described above concerning the ninth embodiment.

In FIG. 37, a reference numeral 173 indicates an insulating film for providing electrical insulation between the p- and n-type organic semiconductor films. The indicating film 173 is formed just before the metal for the anode is vaporized from the evaporation source 163.

In order to prevent the resin-made base film 162 from being wound onto the hexagonal take-up roller 166 together with the cathode 152, n-type organic semiconductor film 153a, p-type organic semiconductor film 153b and anode 151 going to be formed spiral on the take-up roller 166, the resin-made base film 162 is pressed at the other side thereof with a hot roller 174, or irradiated at the other side with light, just before it is wound onto the take-up roller 166. Thus, the resin-made base film 162 is separated from the cathode, semiconductor films and cathode.

The tenth embodiment is similarly advantageous to the ninth embodiment and also advantageous as follows. Since the organic solar cell as the second embodiment has the general form of a hexagon, a plurality of the organic solar cells can be bedded in a plane with no gaps among them as shown in FIG. 38. Thus, it is possible to increase the production of electricity per unit area considerably.

Next, explained is the eleventh embodiment of the invention.

In the eleventh embodiment spin tunneling junction (for example, Jpn. J. Appl. Phys. Vol. 42 (2003) pp. 1246-1249), and Japan Patent 3557442) is used for magnetic recording apparatus.

In said magnetic recording apparatus, like in the ROM device in the seventh embodiment, Co film is used for the metallic strips/ribbons in superlattice thin film/slice 71 and 72. $Al_2O_3$ film is used for the material sandwiched between superlattice thin films/slices 71 and 72. The thickness of said $Al_2O_3$ film is 2 nm, and that of Co film 10~50 nm. Here the spin tunneling junction is completed where Co strips or ribbons, being crossed in edge-to-edge configuration, face to each other with $Al_2O_3$ film in between. In this structure, electron transfers across the cross, the active region, along the direction of strip/ribbon- width.

In the eleventh embodiment, new ultra-high density magnetic recording apparatus can be realized.

Next explained is the twelfth embodiment. In the twelfth embodiment catalytic reaction platform is realized.

As shown in Fig. 39, said catalytic reaction platform has a structure in which multiple parallel layers of superlattice thin films/slices 71 are stacked with appropriate spacing. Fig. 40A shows the superlattice film/slice 71. The dielectric films and metals films in said superlattice thin film/slice 71 are, respectively, oxide films 181 such as TiO2, SiO2, etc., and metal film 182 such as Au, Pd, and Pt. The thickness of said oxide is 10~100 nm, and that of Co film 0.5~10 nm. Fig. 40B shows an enlarged view of the end-region/edge of the metal film 182 exposed at the principal surface of superlattice thin film/slice 71. As shown in Fig. 40B, the end-region/edge of metal 182 has shape of convex, whose radius of curvature is on the same order as that of its thickness, i.e., 0.5~10 nm.

The usage of said catalytic reaction platform is as follows.

As shown in Fig. 41A, the catalytic reaction platform is set in an appropriate reactor, from one end of which reactive gas is introduced and from the other end of which the gas goes out. There the reactive gas makes contact with the end-region/edge of metal 182 exposed at the principal surface of superlattice thin film/slice 71. Since the radius of curvature, being 0.5~10 nm, very small, the surface of the end-region/edge is catalytically very active. As a result, as shown in Fig. 41B, reaction speed is significantly enhanced for gas molecules 183 thanks to the catalytic reaction on the end-region/edge of metal film 182.

As described above, the twelfth embodiment realizes high efficiency catalytic reaction platform based upon superlattice thin film/slice 171 that is composed of metal film 182 whose end-region/edge, being exposed at the principal surface of film 171, has convex shape with radius of curvature of 0.5 ~ 10 nm.

Next, a solar cell according to the thirteenth embodiment will be explained:

Figs. 42A, 42B and 42C which are a front view, rear view and side elevation, respectively, schematically illustrate together a solar cell as the thirteenth embodiment. As shown in Figs. 42A, 42B and 42C, this solar cell is formed spiral from an anode 151 and cathode 152 with a p-n junction of a p-type semiconductor layer and n-type semiconductor layer being laid between them. Namely, it has the general form of a thin disk. Each of the p- and n-type semiconductor layers may be of an inorganic or organic semiconductor.

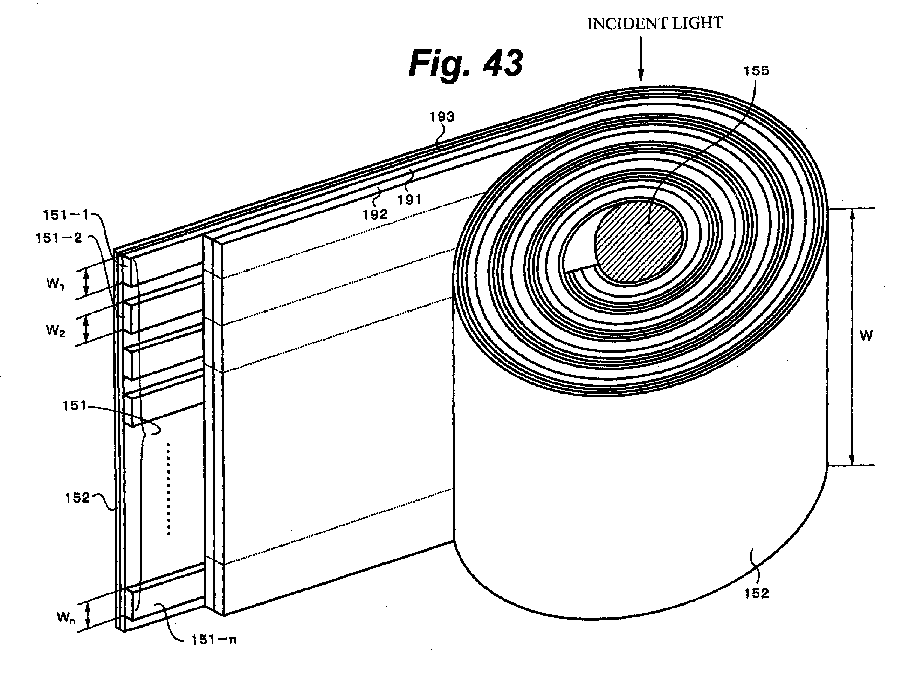

FIG. 43 schematically illustrates the solar cell in detail. In FIG. 43, a reference numeral 191 indicates a p-type semiconductor film and 192 indicates an n-type semiconductor film. As shown in FIG. 43, an insulating layer 193 of various insulating materials such as a resin is provided where the anode 151 and cathode 152 are in a back-to-back relation to electrically insulate the anode 151 and cathode 152 from each other. In this embodiment, the cathode 152 is a whole surface electrode and in ohmic contact with the n-type semiconductor layer 192, while the anode 151 includes n elongated micro electrodes 151-1 to 151-n isolated in the direction of the disk thickness (W) from each other. These micro anodes 151-1 to 151-n have widths W1, W2, ..., Wn, respectively, which may be equal to each other or different from each other.

The p- and n-type type semiconductor layers 191 and 192 have a band gap Eg between them The band gap Eg is decreased stepwise (in n steps ($n >= 2$)) in the direction of the disk thickness from the light-incident surface. Namely, the band gaps Eg are $E_{g1}$, $E_{g2}$, ..., $E_{gn}$ ($E_{g1} > E_{g2} > ... > E_{gn}$) in this order from the light-incident side. A zone in which the band gap Eg between the p- and n-type semiconductor layers 191 and 192 is $E_{gk}$($1 =< k =< n$) is called "$E_{gk}$ zone". In this $E_{gk}$ zone, the p-semiconductor layers 191 and micro anode 151-k are in ohmic contact with each other. These $E_{gk}$ zones may be integral with each other or isolated from each other. A structure in which the $E_{gk}$ zone is laid between the micro anode 151-k and cathode 152 forms a micro solar cell. The solar cell is formed from n such micro solar cells with the cathode 152 being taken as a common electrode.

The band gap $E_{gk}$ can be set as will be explained below. In the entire or main wavelength range of a sunlight spectrum of AM1.5 (including a portion in which the incident energy is high), the wavelength is divided into n zones. Then, the zones are sequentially numbered 1, 2, ..., n starting at the short-wavelength side(high-energy side), and an $E_{gk}$ zone is selected equally to the minimum photon energy in a k-th zone. Thus, when a photon having the photon energy in the k-th zone is incident upon the $E_{gk}$ zone, a pair of electron and positive hole takes place for photoelectric conversion. Also in this case, a depth from the light-incident surface to the $E_{gk}$ zone is selected so that the photon having the photon energy in the k-th zone will arrive at each $E_{gk}$ zone and be absorbed sufficiently. Thus, the sunlight incident upon the light-incident surface of the solar cell is first incident upon the Eg1 zone where photon energies larger than $E_{g1}$ in its spectrum will be absorbed for photoelectric conversion, then upon the $E_{g2}$ zone where photon energies larger than $E_{g2}$ and smaller than $E_{g1}$ will be absorbed for photoelectric conversion, and finally upon the $E_{gn}$ zone where photon energies larger than $E_{gn}$ and smaller than $E_{gn-1}$ will be absorbed for photoelectric conversion. As a result, light in almost the entire or main wavelength range of the sunlight spectrum can be photoelectrically converted.

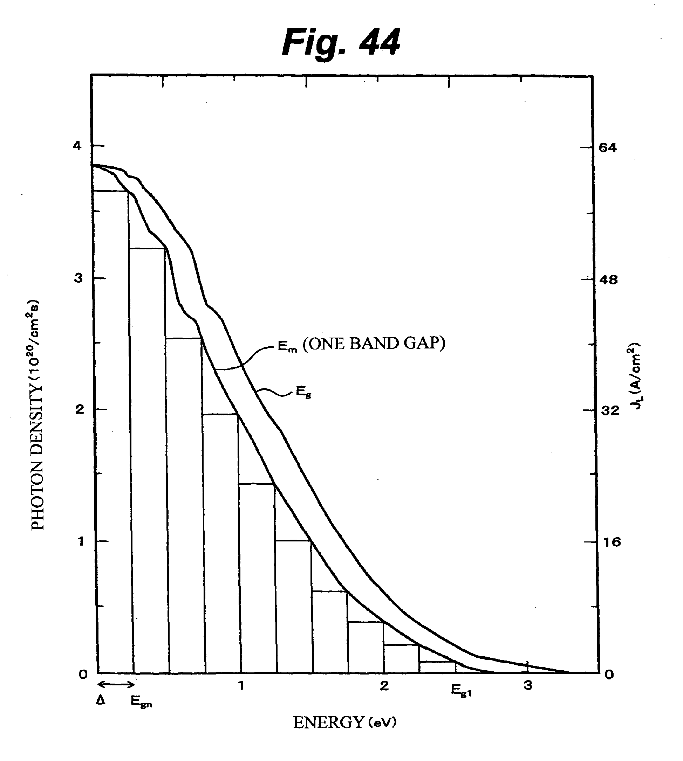

An example of ideal setting of the $E_{gk}$ zone will be explained herebelow. FIG. 44 shows the relation between a photon density nph and photon energy hv of the sunlight spectrum of AM1.5. It is assumed here the photon energy of the sunlight spectrum of AM1. 5 is equally divided into 10 zones each of an energy width $\Delta$. The theoretical maximum efficiency of photoelectric conversion is as high as about 65%, which is twice more than 31% of the theoretical maximum efficiency of photoelectric conversion of a conventional solar cell of $E_g$ = 1.35 eV, for example.

Each $E_{gk}$ zone can be set by changing the composition of a semiconductor forming each $E_{gk}$ zone. More specifically, the $E_{gk}$ zones are formed from different types of semiconductors. In case the semiconductors used are inorganic ones, the $E_{gk}$ zones are formed as follows. In case the photon energy is divided into two zones (n = 2), the $E_{g1}$ zone is formed from GaAs (Eg = 1.43 eV) and Eg2 zone is formed from Si (Eg =1.11 eV), for example. In case n = 3, the $E_{g1}$ zone is formed GaP (Eg = 2.25 eV), $E_{g2}$ zone is formed from GaAs (Eg = 1.43 eV) and $E_{g3}$ zone is formed from Si (Eg = 1.11 eV), for example. In case n = 4, the Eg1 zone is formed from GaP (Eg = 2.25 eV), $E_{g2}$ zone is formed from GaAs (Eg = 1.43 eV), $E_{g3}$ zone is formed from Si (Eg = 1.11 eV) and Eg4 zone is formed from Ge (Eg = 0.76 eV). Further, the $E_{gk}$ zones when the photon energy is divided into a range of n to 10 may be formed from GaInNxAs1-x and GaInNxP1-x just by controlling the value x. In addition, the $E_{gk}$ zone may be formed from a II-VI compound semiconductor well known to show large bowing when Te is included therein.

The method of producing this solar cell is similar to the producing method for the ninth embodiment.

In case a solar battery system is formed from a plurality of the solar cells according to the third embodiment, the micro anodes 151-k of the solar cells laid in a line are connected to each other to output a voltage from the micro anodes 151-k of the last one of the solar cells laid in each line.

The thirteenth embodiment is similarly advantageous to the ninth embodiment, and also has the following advantage. That is, the conventional amorphous Si solar cell, for example, cannot utilize light having a wavelength of which the photon energy in the sunlight spectrum is smaller than 1.12 eV, but the solar cell according to the thirteenth embodiment is enabled by the design of the $E_{gk}$ zone to utilize all or main part of light in the sunlight spectrum, to thereby permitting to attain a dramatically improved efficiency of photoelectric conversion.

Next, a solar cell according to the fourteenth embodiment will be explained:

Figs. 45A, 45B and 45C which are a front view, rear view and side elevation, respectively, schematically illustrate together the said solar cell. As shown in Figs. 45A, 45B and 45C, this solar cell is formed spiral from an anode 151 and cathode 152 with a p-n junction of a p-type semiconductor layer 191 and n-type semiconductor layer 192 being laid between them. Namely, it has the general form of a thin hexagonal plate. In other respects, the fourteenth embodiment is similar to the thirteenth embodiment.

In case a solar battery system is formed from the hexagonal solar cells bedded in a plane with no gaps among them, the micro anodes 151-k of the solar cells laid in a line are connected to each other to output a voltage from the micro anode 151-k of the last one of the solar cells laid in each line. In this case, the micro solar cells in the $E_{gk}$ zones of the solar cells laid in one line are connected in parallel to each other. FIG. 46 shows the solar battery system.

The fourteenth embodiment is similarly advantageous to the thirteenth embodiment, and also has the following advantage. That is, since the solar cell according to the fourteenth embodiment is formed hexagonal, the solar cells can be bedded in a plane with no gaps among them as shown in FIG. 38. Thus, the efficiency of photoelectric conversion of each solar cell can be increased dramatically and also the production of electricity per unit area can also be increased dramatically.

Next, a solar cell according to a fifteenth embodiment of the present invention will be explained.

As shown in FIG. 47, the solar cell is formed spiral from an anode 151 and cathode 152 with a p-n junction of a p-type semiconductor layer and n-type semiconductor layer being laid between them, which is similar to the thirteenth embodiments except that a center shaft 194 is provided as a take-up shaft at the anode side so that the p-type semiconductor layer 191 is wound on the shaft more early than the n-type semiconductor layer 192 and that the anode 151 includes n elongated micro anodes 151-1 to 151-n separated from each other in the direction of hexagonal-plate thickness (W) and also the cathode 152 includes n elongated micro cathodes 152-1 to 152-n separated from each other in the direction of hexagonal-plate thickness (W). The widths of the micro cathodes 152-1 to 152-n are W1, W2, ..., Wn, respectively. In other respects, the fifth embodiment is similar to the thirteenth embodiment.

FIG. 48 shows the center shaft 194 in detail. As shown in FIG. 48, the surface of the center shaft 194 is formed from an insulating material and has formed thereon p-type contact layers 195-1 to 195-n axially separated from each other. Micro anodes 151-1 to 151-n are wound on the contact layers to be in contact with the latter. A connector 196 is provided at one end of the center shaft 194. The surface of the connector 196 is formed from an insulating material and has formed thereon electrodes 197-1 to 197-n separated axially from each other. The electrode 197-1 to 197-n are electrically connected to the p-type contact layers 195-1 to 195-n by internal wiring (not shown).

In case a solar battery system is formed from a plurality of these solar cells, the micro anodes 151-k of the solar cells laid in a line are connected to each other while the micro anodes 152-k are connected to each other to output a voltage from the micro anode 151-k of the last one of the solar cells laid in each line. In this case, micro solar cells in the Egk zones of the solar cells laid in one line are connected in parallel to each other.

The fifteenth embodiment is similarly advantageous to the thirteenth embodiment.

Next, a solar cell according to a sixteenth embodiment of the present invention will be explained.

The solar cell is shaped to have the general form of a thin, hexagonal plate. In other respects, this solar cell is similar to that according to the fifteenth embodiment.

In case the hexagonal solar cells are bedded in a plane with no gap among them to build a solar battery system, the micro anodes 151-k of the solar cells laid in a line are connected to each other while the micro anodes 152-k are connected to each other to output a voltage from the micro anode 151-k of the last one of the solar cells laid in each line. In this case, micro solar cells in the $E_{gk}$ zones of the solar cells laid in one line are connected in parallel to each other. In this embodiment, since the micro anode 151-k is exposed at the lateral side of the solar cell, just butt-joining the lateral sides of the solar cells to each other of the solar cells permits to provide electrical connection between the micro anodes 151-k. FIG. 49 shows this solar battery system.

A voltage should preferably be outputted from the solar battery system as will be described below. A photo electromotive force developed between the micro anode 151-k and micro cathode 152-k of each of the micro solar cells included in the solar battery system is given by $E_{gk}/e$. Namely, the micro solar cells are different in photo electromotive force from each other. The photo electromotive force of each micro solar cell may be used as it is, but to make use of the most of the solar cells, the connection between the micro solar cells should preferably be adapted to provide a single output voltage. On this account, denoting $E_{gn}$ as $\Delta$ and it is set so that $E_{gi} = E_{g1} - (i-1)\Delta$ (for $i = 1$ to $n$). In this case, the micro solar cells in the $E_{gk}$ zone of each of the solar cells laid in one line are connected in parallel to each other. When a j-th one of the solar cells in an i-th line is given by $C_{ij}$, the micro solar cell in the $E_{gk}$ zone ($k >= 2$) of a first one $C_{2i-1,1}$ of the solar cells laid in a (2i - 1) th line and micro solar cell in the $E_{g(n+2-k)}$ zone of a first one $C_{2i, l}$ of the solar cells laid in a 2i-th line are connected in series to each other as shown in FIG. 50. In this case, the total photo electromotive force will be $(E_{gk} + E_{g(n+2-k)})/e = E_{g1}/e$. On the other hand, the photo electromotive force of the micro solar cell in the $E_{g1}$ zone is $E_{g1/e}$. Therefore, these photo electromotive forces can be taken out from the same terminal to output a single output voltage from the solar battery system.

Next explained is the seventeenth embodiment of the invention, which is a luminous device. The front view, back view, and side view of the luminous device are identical to those shown in Fig. 42A, 42B, and 42C.

Fig. 51 shows the detailed structure of said luminous device schematically. As shown in Fig. 51, anode electrode 151 and cathode electrode 152 are set back to back, separated by insulator film 193, due to which electrodes 151 and 152 are electrically isolated to each other. Here cathode electrode 152, being whole surface electrode, makes an Ohmic contact to n-type semiconductor 192, whereas electrode 151 is split into n mini-anodes 151-1 through 151-n. Those mini-anodes 151-1 through 151-n have width W1, W2, .... , Wn, which can be identical to, or different from, each other. Cathode electrodes 151 and 151-1 through 151-n are made of electrodes that are transparent with respect to the light being emitted, and one example is Indium-Tin-Oxide (ITO), etc. Active layer with band-gap $E_{gk}$ being sandwiched by mini-anode electrode 151-k and cathode electrode 152 is a part of the luminous mini-device. With the cathode 152 as a common electrode, these n luminous mini-devices form the luminous device as a whole.

The band-gap Eg of p- type semiconductor 191 and n-type semiconductor 192 are varied n-step(n>=2) along the depth direction, i.e., from the top surface down to bottom. Specifically, band-gap of each region is selected such that red light (R) comes out from, for example, region $E_{g1}$, $E_{g4}$, $E_{g7}$, ....; green light (G) comes out from, for example, region $E_{g2}$, $E_{g5}$, $E_{g8}$, .... ; and blue light (B) comes out from, for example, region $E_{g3}$, $E_{g6}$, $E_{g9}$, ...... Thus, the colors of emission is repetition of R, G, and B from the top surface to bottom. The light emission is achieved by applying appropriate voltage between mini-anode electrodes 151-k and the cathode 152 to inject current in each luminous mini-device. White light can be obtained by operating those luminous R, G, B mini-devices.

In the other aspect, the seventeenth embodiment of the invention is identical to the thirteenth embodiment to the extent not contradict to its nature.

By the seventeenth embodiment, very efficient luminous device can be obtained, compared to conventional LED's, because photons are generated in all the $E_{gk}$ regions that fill up almost all the three dimensional volume of the luminous device.

By this high efficiency, the injection current density can be set low for obtaining strong emission and the lifetime of the luminous device can be much elongated.

Next, there will be explained a clean unit and clean unit system, suitable for use in producing the functional devices according to the aforementioned first to seventeenth embodiments.

Figs. 52A, 52B and 52C which are a plan view, front view and side elevation, respectively, schematically illustrate together a clean unit according to the eighteenth embodiment of the present invention. The clean unit is used mainly for a chemical process to which generation of a gas, use of an organic solvent and the like are incident, which however is not any limitative example of application.

As shown in Figs. 52A, 52B and 52C, the clean unit includes a hexahedral box-shaped work chamber 211. The opposite lateral sides of this work chamber 211 are parallel to each other, and also the top and bottom are parallel to each other. The lateral sides, top, bottom, front and back are at right angles to each other, but the front is not parallel to the back and is inclined at an angle θ (70 to 80 deg., for example) to a direction in which the top gets close to the back. Transfer boxes 212, 213 and 214 that serve as an inter-clean unit connector and passageway are removably provided at the back and opposite lateral sides, respectively, of the work chamber 211. An opening (not shown in Figs. 52A, 52B and 52C) is formed in the wall of the work chamber 211 on which the transfer boxes 212, 213 and 214 are provided. These transfer boxes 212, 213 and 214 can be used to connect one clean unit to another clean unit from the directions of the back and opposite lateral sides and carry workpieces between the clean units. In the front wall of the work chamber 211, there are formed two circular openings to which manipulation-use pair of gloves 215 are attached, respectively. The operator can make necessary work inside the work chamber with the hands being inserted in the manipulation-use gloves 215. On the top of the work chamber 211, there are installed an exhaust duct 216 and a passive dust filter 217 with no blower, which contribute to keeping the inside of the work chamber 211 as a clean environment nearly at Class 10 or 100, for example. The passive dust filter 217 may be, for example, a passive HEPA filter.

The front of the work chamber 211 is detachable so that with the front being detached, necessary equipment such as a process unit, observation apparatus, etc. can be introduced into the work chamber 211.

The size of the work chamber 211 is large enough to accommodate necessary process units etc. and for the operator to make necessary work in the work chamber 211 with the hands being inserted in the manipulation-use gloves 215. More specifically, the depth a of the work chamber 211 is 50 to 70 cm, width b is 70 to 90 cm and height h is 50 to 100 cm, for example, as shown in Figs. 52A, 52B and 52C. Also, the work chamber 211 should preferably be formed from a transparent material such as an acrylic resin plate, for example, for the chamber inside to be visible from outside. For mechanical reinforcement, the acrylic resin plate may be fixed to a metal frame. The dimension c of the transfer boxes 212, 213 and 214 is, for example, 15 to 20 cm.

Figs. 53A, 53B and 53C which are a plan view, front view and side elevation, respectively, schematically illustrate together an example construction of the transfer boxes 212, 213 and 214.

As shown in Figs. 53A, 53B and 53C, each of the transfer boxes 212, 213 and 214 includes a body 218 having a rectangular section, and a picture frame-like flange 219 one size larger than the body 218 and formed at either end of the body 218. In this case, the inner wall of the flange 219 coincides with that of the body 218.

The work chamber 211 and transfer boxes 212, 213 and 214 are connected to each other as will be discussed below. Connection of the transfer box 214 to the right side of the work chamber 211 will be explained here by way of example, which is also true with the connection of the transfer boxes 212 and 213. As shown in Figs. 54A and 54B, the work chamber 211 has a wall 220 to isolate the inside and outside of the work chamber 211 from each other, and the wall 220 has a rectangular opening 220a formed in a portion to which the transfer box 214 is to be fixed. Also, a horizontally extending stopper 221 is provided on the outer surface of the wall 220 and just below the opening 220a, and a pair of guide rails 222 extending vertically above the opposite ends of the stopper 221 are provided opposite, and in parallel, to each other. The clearance between these guide rails 222 and wall 220 is designed slightly larger than the thickness of the flange 219 of the transfer box 214. The flange 219 of the transfer box 214 is inserted at both lateral sides thereof into the clearance and slid along the guide rails 222 from above. When the lower end of the flange 219 touches the stopper 221, the flange 219, guide rails 222 and wall 220 are nearly appressed to each other. The transfer box 214 is completely installed.

A stopper 223 extending horizontally just below the opening 220a is provided also on the inner surface of the wall 220, and a pair of guide rails 224 extending vertically above the opposite ends of the stopper 223 are provided opposite, and in parallel, to each other. A rectangular sliding door 225 one size larger than the opening 220a is inserted at both lateral sides thereof into a clearance between the guide rails 224 and wall 220 and slid along the guide rails 224. When the lower end of the sliding door 225 touches the stopper 223, the sliding door 225, guide rails 224 and wall 220 is nearly appressed to each other and the inside and outside of the wall 220 are isolated from each other. The clearance between these guide rails 224 and wall 220 is designed a little larger than the thickness of the sliding door 225. The sliding door 225 has a handle 226. The operator can open or close the sliding door 225 by moving the latter vertically with the handle 226 in hand. By operating the sliding door 225 in this manner, the operator can control the communication/non-communication between the inside of the work chamber 211 and the transfer box 214.

The clean unit system can be expanded by attaching the transfer unit 214 to outside the opening 220a in the wall 220 with the inner sliding door 225 being closed, connecting the work chamber 211 of a next clean unit to the other end of the transfer box 214, and then opening the inner sliding door 225. That is, the space in the work chamber 211 can be kept clean, and this clean environment can be expanded in the horizontal direction and in the direction of depth.

Next, there will be explained how a workpiece is put into the clean unit and taken out. As shown in Figs. 55A and 55B, a next clean unit is not connected to the clean unit but a charge/discharge box 227 is installed to the work chamber 211 of the clean unit in order to put a workpiece into the clean unit and take it out. The charge/discharge box 227 is almost similar in construction to the transfer boxes 212, 213 and 214. That is, the charge/discharge box 227 includes a body 228 having a rectangular section, and a picture frame-like flange 229 one size larger than the body 228 and formed at either end of the body 228. A stopper 230 is fixed below one of the flanges 229, and a pair of guide rails 231 extending vertically above the opposite ends of the stopper 230 are provided opposite, and in parallel, to each other. The inner wall of the flange 229 coincides with that of the body 228. A rectangular shield plate 232 one size larger than the body 228 is inserted at opposite ends thereof into the clearance between the guide rails 231 and flange 229 and slid along the guide rails 231. When the lower end of the shield plate 232 touches the stopper 230, the shield plate 232, guide rails 231 and flange 229 are nearly appressed to each other and the inside and outside of the charge/discharge box 227 are isolated from each other. The clearance between these guide rails 231 and flange 229 is designed slightly larger than the thickness of the shield plate 232. The shield plate 232 has a handle 233. The operator can open or close the shield plate 232 by moving the latter vertically with the handle 233 in hand. By operating the shield plate 232 in this manner, the operator can control the communication/non-communication between the inside and outside of the charge/ discharge box 227. Installation of the charge/discharge box 227 to the clean unit is the same as that of the transfer boxes 212, 213 and 214 to the clean box, and so will not be explained any more.

With regard to one of the connectors provided at three places on the clean unit, through which nothing is introduced or removed and which is not connected to any other clean unit, an opening/closing mechanism is also provided on the outer surface of the wall 220 as on the inner surface as shown in Figs. 56A and 56B. More specifically, a stopper 234 and a pair of guide rails 235 are installed to the wall 220 of the work chamber 211. A rectangular shield plate 236 one size larger than the opening 220a is inserted at the opposite ends thereof into the clearance between the guide rails 235 and wall 220 and slide along the guide rails 235. When the lower end of the shield plate 236 touches the stopper 234, the shield plate 236, guide rails 235 and wall 220 are attached to each other to isolate the outside and inside of the wall 220 from each other. The clearance between the guide rails 235 and wall 220 is designed slightly larger than the thickness of the shield plate 236. The shield plate 236 has a handle 237. The operator can open or close the shield plate 236 by moving the latter vertically with the handle 237 in hand. By operating the shield plate 236 in this manner, the operator can control the communication/non-communication between the clean unit inside and outside. In this embodiment, the wall 220 has also a similar closing/operating mechanism provided on the inner surface thereof. That is, the wall 220 of the connector is doubly shielded. Thus, in case the clean unit is not connected to any other one and has no transfer box connected thereto, the inside of the work chamber 211 of the clean unit can efficiently be isolated from the atmosphere.

Figs. 57A, 57B and 57C, which are a plan view, front view and side elevation, respectively, schematically illustrate together a clean unit according to an eighth embodiment of the present invention. This clean unit is to be used for performing non-chemical processes such as various kinds of measurement like surface observation, inspection, assembling, etc. which however are not any limitative examples of application.

As shown in Figs. 57A, 57B and 57C, the clean unit has a work chamber 251 constructed similarly to the work chamber 211 of the clean unit shown in Figs. 52A, 52B and 52C. As shown, transfer boxes 252, 253 and 254 are provided at the back and lateral sides, respectively, of the work chamber 251. The transfer boxes also serve as inter-clean unit connector and passageway. These transfer boxes 252, 253 and 254 can be used to connect another clean unit to this clean unit from three directions, namely, from the back and lateral sides, and a workpiece or the like can be carried through the transfer boxes 252, 253 and 254. Also, in the front surface of the work chamber 251, there are formed two circular openings to which manipulation-use gloves 255 in pair are attached. On the top of the work chamber 251, there is installed an active dust filter 256 with a blower, which contributes to keeping the inside of the work chamber 251 as a clean environment nearly at Class 10 or 100, for example. In this embodiment, no exhaust duct is provided but an exhaust ventilator 257 is provided instead at the lower corner of either lateral side of the work chamber 251. The exhaust ventilator 257 is to control the positive air pressure applied by the active dust filter 256 by exhausting air coming from the active dust filter 256 to outside the work chamber 251. The active dust filter 256 may be, for example, an active HEPA filter. It should be noted that in case this clean unit is used in place of a bio clean room, for example, an ion sterilization/clearing unit may be connected directly to the active dust filter 256.

In other respects, the clean unit as the eighth embodiment of the present invention is constructed similarly to that shown in Figs. 52A, 52B and 52C.

In case the clean unit is not connected to any other clean unit, a shield plate or door may be attached to the connecting portion of the transfer boxes 252, 253 and 254 similarly to the clean unit shown in Figs. 52A, 52B and 52C.

Next, there will be explained a clean unit system according to the twentieth embodiment of the present invention.

Fig. 58A shows the clean unit system as the twentieth embodiment. Fig. 58B shows a conventional clean unit system to compare with the clean unit system as the twentieth embodiment.

As shown in FIG. 58A, tables 261, 262, 263, and 264 are located in a room with such spacing that enables operators to stand in between and do processes. Clean unit 265 is put on table 261, clean units 266 and 267 on table 262, clean units 268, 269 and 270 on table 263, and clean units 271, 272 and 273 on table 264, respectively. These clean units 265 through 273 are connected by transfer box 274 and they are in a configuration of folded lines.

In the above, the clean unit being described as the eighteenth and nineteenth embodiments, which can be connected in three directions, is used as clean unit 265 through 273. That is the reason why the clean units 265 through 273 can be in the configuration of folded lines.

For clean units 265, 269, 272, and 273, however, conventional clean units that are only connectable in two directions may be used.

Since recent progress in technology has made it possible to do pre-treatment, resist coating, baking, exposure, development, post-baking, etching, thin-film growth, surface observation, and assembly in a compact manner with small apparatus, the clean unit as the eighteenth embodiment (hereafter Type A) and the clean unit as the nineteenth embodiment (hereafter Type B) can contain the aforementioned compact machines in them. Thus, compact processing apparatus (chemical equipments such as growth apparatus or etching apparatus, and non-chemical equipments like a lithography apparatus or baking apparatus), small observation apparatus (AFM, STM, optical microscope, SEM), can be installed in the clean units 265 through 273. For example, compact growth machine can be set in the clean unit 270, and power supply 275 for the growth apparatus and oscilloscope 276 are located near the clean unit 270.

How to do processing, analysis, and measurement using the clean unit system is shown in the following. First, a operator standing in front of the clean unit 265 put a substrate (not shown) into the unit through the inlet. After doing appropriate processes in the clean unit 265, the operator transfers the substrate using globes (not shown) to the neighboring clean unit 266 via the transfer box 274. Next, the operator moves to stand in front of the clean unit 266, and do needed processes in the clean unit 266. The operator do a series of processes transferring the sample among the clean units 265 through 273, and when finished, the operator takes the substrate/sample out of the clean unit 273.

As described above, the twenties embodiment can make the total footprint of the whole clean unit system very close to square by exploiting the configuration of folded lines, which leads to efficient use of rooms.

As shown in Fig. 58B, the total length becomes very large when the conventional clean units 281 through 288 for which only right-hand-side and left-hand-side connections are possible are used, because only the configuration of single line is allowed. This leads to inefficient use of room space. This comparison clearly shows the advantage of the clean unit system as the eighteenth embodiment. IN Fig. 58B, reference numeral 289 through 292 show the tables and 293 the connector.

Next explained is the twenty-first embodiment of the present invention.

The clean unit system is schematically illustrated in FIG. 59. As shown in FIG. 59, the clean unit system includes clean units 1101 to 1106 of Type A or B, designed for three-directional connection. The clean units are connected in a loop to each other via a transfer box 1107. A transfer box 1107 no used for this connection is shielded by a shield plate.

The twenty-first embodiment is advantageous as follows. In general, one process is repeated often in a total series of processes. However, in case the same process is repeated in the conventional clean unit system in which clean units that can be connected only horizontally are connected to each other horizontally in a single line, a workpiece has to be returned back to an upstream clean unit at completion of each process. Therefore, the working efficiency is very low. In the twenty-first embodiment, however, since the clean units 1101 to 1006 are connectable in three directions, they can be connected to each other in an optimum loop for an intended process flow and a series of processes can be repeated a required number of times without having to carry the workpiece unnecessarily. Thus, the series of processes can be effected efficiently.

Next, there will be explained a clean unit system according to the twenty-second embodiment of the present invention.

FIG. 60 shows the clean unit system as the tenth embodiment. As shown in FIG. 60, the clean unit system includes clean units 1101 to 1106 of Type A or B are connected in a loop to each other via a transfer box 1107, which is similar to the aforementioned nineteenth embodiment. In this embodiment, however, the clean units 1102 and 1105 are connected directly to each other via a transfer box 1107 and junction box 1108. In this case, the clean unit system may be so designed that the depth a of the work chamber, dimension c of the transfer box and distance x of the transfer box at the back from the right side in the drawing will be given by an expression $x = (a - c)/2$ as shown in Figs. 52A, 52B, 52C, 57A, 57B or 57C to connect only the clean units 1101 to 1106 constructed according to the same specification to each other as shown in FIG. 60.

According to the twenty-second embodiment, the clean units 1101 to 1106 are connected to each other to form a loop and the clean units 1102 and 1105 are connected directly to each other via the transfer box 1107 and junction box 1108. So, the clean unit system as the twenty-second embodiment is advantageous similarly to the aforementioned twenty-first embodiment and further advantageous in that it can be branched or looped smaller for effecting a process more adaptationally. More specifically, a substrate can be processed being passed sequentially through the clean units 1101 to 1106. Also, after the substrate is processed first in the clean unit 1101 and then in the clean unit 1102, it can be passed to the clean unit 1105 in which it will further be processed, for example.

Next, there will be explained a clean unit system according to the twenty-third embodiment of the present invention.

Fig. 61 shows the clean unit system as the twenty-third embodiment. As shown in FIG. 61, Type A or B, i.e., the clean units 1121 through 1128, which are connectable in three directions, are connected to each other via a transfer box 1129. Here, clean units 1122 through 1127 are connected in such a loop configuration that are explained for the twenty-second embodiment of the invention.

For example, cleanunits 1122, 1123, 1125, 1126 are of Type A, and the clean units 1121, 1124, and 1127 are of Type B.

Processes done in the clean units 1121 through 1128 are, for example, as follows. The clean unit 1121 is a store unit and storing equipment (for example, a wafer cassette 1130 that stores wafers) is set inside. The transfer box 1129 set at the clean unit's right-hand-side that is not used for connecting clean units serves as inlet. The transfer box 1129 set at the clean unit's back-side that is not used, either, for connecting clean units serves as an emergency outlet. The clean unit 1122 is a chemical unit, in which chemical process system 1131 is set and chemical processes are done there. The clean unit 1123 is a resist process unit, in which spin coater 1132 and development apparatus 1133 are installed and resist coating and development are done there. The clean unit 1124 is a lithograpy unit, in which exposure machine 1134 is set and the transfer box 1128 set at the clean unit's right-hand-side that is not used for connecting clean units serves as an emergency outlet. The clean unit 1125 is a growth/metallization unit, in which electrochemical system 1135 and micro-reactor system 1136 are installed. The transfer box 1128 set at the clean unit's right-hand-side that is not used for connecting clean units is an emergency outlet. The clean unit 1126 is an etching process unit, in which etching apparatus 1137 is installed. The transfer box 1129 set at the clean unit 1126's back-side is connected to the transfer box 1129 set at the clean unit 1123' s back-side, via a connecting box 1138. The clean unit 1127 is an assembly unit, in which micorscope 1139 and prober 1140 are installed. The clean unit 1128 is a surface probing microscope (SPM) observation unit, in which scanning tunneling microscope (STM) 1141 and atomic force microscope (AFM) 1142 are installed. The transfer box 1129 set at the clean unit's right-hand-side that is not used for connecting clean units is an outlet, and the transfer box 1129 set at the clean unit's back-side that is not used, either, for connecting clean units serves as an emergency outlet. The spin coater 1132 in the clean unit 1123, the exposure system 1134 in clean unit 1124, the electrochemical system 1135 plus the micro-reactor system 1136 in the clean unit 1125, the etching machine1137 in the clean unit 1126, and the prober 1140 in the clean unit 1127 are connected to the power supply 1143. Also, the electrochemical system 1135 in the clean unit 1125 is connected to electrochemical machine controller via cable 1144, and the controller 1145 controls the electrochemical reaction. The images of the micorscope 1139 in the clean unit 1127 and those of desktop STM 1141 and desktop AFM 1142 in the clean unit 1128 can be seen on the monitor 1146.

The twenty-third embodiment provides following advantages. Almost all the processes that are done in conventional huge clean room, such as pre-treatment, resist coating, baking, exposure, development, growth/metalization, etching, probing, surface analysis, and the like, can be done in a compact and simple manner by the clean unit system of present invention exploiting loop configuration or the like.

As shown in Fig. 61, by using a mosaic configuration composed of Type A, Type B and their transformation, all of the processes or main part of the processes can be done very effectively. For example, processes which are afraid of decreasing yield when the workpiece is exposed to an atmosphere including dusts midway are done and then processes are proceeded to a suitable process which can be done in an atmosphere including dusts.

When a total process flow or main part of the whole process is given, a corresponding one-dimensional connection of the clean units (mosaic pattern) of the present invention is determined. By using the clean units of the present invention, for example, the Type A and Type B clean units, a total process system can be constructed in very extensive and flexible manner, corresponding to the needed stages of processes. It is possible to realize loop configuration of clean units to satisfy constraint conditions which are doing repeat of the same process or group of processes in the same clean unit or group of clean units (in other words, by determining which parts of the mosaic are connected to increase the efficiency to the maximum).

Next, there will be explained a clean unit system according to the twenty-fourth embodiment of the present invention.

Fig. 62 shows the clean unit system as the twentieth embodiment. As shown in FIG. 62, Type A or B, i.e., the clean units 1151 through 1171, which are connectable in three directions, are connected to each other via a transfer box 1172. Here, the clean units 1160 through 1165 are connected in such a loop configuration that are explained for the twenty-first embodiment of the invention, and the clean units 1166 through 1171 are connected in such a loop configuration that are explained for the twenty-second embodiment of the invention. The transfer box 1172 set at the clean unit 1155's back-side is connected to the transfer box 1172 set at the clean unit 1160' s right-hand-side, via a connecting box 1173. Also, the transfer box 1172 set at the clean unit 1158's back-side is connected to the transfer box 1172 set at the clean unit 1165's right-hand-side, via a connecting box 1173. The transfer box 1172 set at the clean unit 1167's back-side is connected to the transfer box 1172 set at the clean unit 1170's back-side, via a connecting box 1173. Process units and observation apparatus which are necessary for process using this clean unit system are installed in the clean units 1160 through 1165.

The twenty-fourth embodiment provides following advantages. All the processes or main part of the processes can be performed automatically under controlled of a computer by computer-controlling the opening/closing of the transfer box and the operation of sample transfer. This is because the clean unit system of the present invention can be constructed exactly corresponding to a programming flowchart. The total process flow from the top stream to the down stream in the clean unit system can be seen as identical to the sequence of the programming flowchart. Subroutine 1174 and/or conditional decision 1175, for example, in a program can be well treated by branching and loop configurations exploiting the tri-directional connectablity of the clean units of the present invention.

Thanks to the loop structure that the clean unit system of the present invention can take, a series of processes can be performed on a substrate repeatedly with a minimum transfer distance. This is a marked contrast to the conventional case, in which the process units are connected in a line configuration and samples have to go back and forth from up-stream to down-stream many times when a series of processes is to be repeated. The clean unit system of the present invention has in general the following advantage. The clean unit system of the present invention can have the configuration of Peano line or Hilbert curve as shown in Fig. 63, and has advantage of small total foot-print. When the clean unit system of the present invention has configuration like the one shown in Fig. 63, due to the tri-directional connectability of the clean units, the operator can enjoy "warp" in process as well as multi-purpose use of a configuration of the clean units system, whose high efficiency is similar to the case of plurality of proteins production out of one-dimensional string of DNA's, and is very effective to enhance the performance of the system as a process/production platform of uniting or unification of top-down systems with bottom-up systems.

Next, there will be explained a clean unit according to the twenty-fifth embodiment of the present invention.

The clean unit as the twenty-fifth embodiment is schematically illustrated in Figs. 64A, 64B and 64C which are a plan view, front view and side elevation, respectively.

As shown in Figs. 64A, 64B and 64C, the clean unit includes a hexahedral box-shaped work chamber 211. Transfer boxes 212, 213 and 214 are removably provided at the back and opposite lateral sides, respectively, of the work chamber 211, and transfer boxes 1201 and 1202 are removably provided at the top and bottom, respectively, of the work chamber 211. The transfer boxes 1201 and 1202 are constructed similarly to the transfer boxes 212, 213 and 214.

In other respects, this embodiment is similar to the eighteenth embodiment, and so will not be explained any more.

It should be noted that the clean unit according to the twenty-fifth embodiment will be referred to as "Type C" hereunder.

Next, there will be explained a clean unit according to the twenty-sixth embodiment of the present invention.

The clean unit as the twenty-sixth embodiment is schematically illustrated in Figs. 65A, 65B and 65C which are a plan view, front view and side elevation, respectively.

As shown in Figs. 65A, 65B and 65C, the clean unit includes a hexahedral box-shaped work chamber 251. Transfer boxes 252, 253 and 254 are removably provided at the back and opposite lateral sides, respectively, of the work chamber 251, and transfer boxes 1203 and 1204 are removably provided at the top and bottom, respectively, of the work chamber 211. The transfer boxes 1203 and 1204 are constructed similarly to the transfer boxes 212, 213 and 214.

In other respects, this embodiment is similar to the eighth embodiment, and so will not be explained any more.

It should be noted that the clean unit according to the twenty-sixth embodiment will be referred to as "Type D" hereunder.

Next, there will be explained a clean unit according to the twenty-seventh embodiment of the present invention.

FIG. 66 is a front view of the clean unit as the twenty-seventh embodiment of the present invention.

As shown in FIG. 66, the clean unit has an exhaust ventilator (not shown) formed at the lower corner of the left lateral side of the work chamber 251. The exhaust ventilator is closed with a lid or the like (not shown) and an airtight tube 1251 is connected between the exhaust ventilator at the lower corner of the right lateral side and the inlet of an active dust filter 256 so that all the gas exhausted from the exhaust ventilator will enter the active dust filter 256 through the tube 1251. Thus, the gas is circulated through the active dust filter 256, work chamber 251, exhaust ventilator, type 1251 and active dust filter 256 in this order, whereby the cleanliness inside the work chamber 251 can be improved considerably.

In case a chemical process is to be effected inside the work chamber 251, a chemical process-compatible active dust filter 256 is used and an adsorption tower 1252 or adsorbent is provided in the middle of the tube 1251, to thereby permit both removal of a harmful substance and maintenance of a clean environment in a closed system without having to connect the work chamber 251 to outside via any duct or the like.

Also, an adhesive tape is attached on all or part of the whole inner wall of the work chamber 251 to catch dust particles, whereby it is possible to further improve the cleanliness. In this case, the adhesive sheet may be a multilayered one. By peeling one of the adhesive-sheet layers at completion of each process to expose a clean sheet surface, the adhesion effect of the adhesive sheet to catch dust particles can always be maintained.

The work chamber 251 is not illustrated and explained in detail, but it is similar to the work chamber included in the nineteenth or twenty-fourth embodiments.

The clean unit as the twenty-seventh embodiment will be referred to as "Type E" hereunder.

FIG. 67 shows the cleanliness inside the work chamber 251, measured with the Type-E clean unit being placed in an ordinary office environment and active dust filter 256 being in operation. In FIG. 67, the horizontal axis indicates the size (in $\mu$m) of particles and vertical axis indicates the number (pieces/m3) of particles larger than the particle size along the horizontal axis. It should be noted however that the work chamber 251 of the clean unit used in this measurement is cuboid and 80 cm wide, 60 cm deep and 80 cm high. The active dust filter 256 used was a HEPA unit GK-0757-01 (Model 25S), 0.3 $\mu$m, available from the AS ONE. Also, the measurement was made in 20 or 30 min after the active dust filter 256 was put into operation. As will be known from FIG. 67, the mean value (indicated with a small white circle in FIG. 67) of the cleanliness of the circulation-type clean unit is nearly at Class 10, and the maximum cleanliness value (indicated with a small black circle) is approximate to Class 1. The time taken for attaining the cleanliness was as short as 20 or 30 min after the active dust filter 256 was put into operation. The above shows that circulation of all the gas exhausted from the exhaust ventilator to the inlet of the active dust filter 256 through the tube 1251 is very effective for attaining a high cleanliness of the work chamber inside. FIG. 67 also shows cleanliness (indicated with a small white triangle) measured in a super-clean area of the clean room and that (indicated with a small black triangle) in an ordinary area.

Heretofore, some embodiments have been explained specifically. However, these embodiments should not be construed to limit the invention, but the invention contemplates various changes and modifications based on the technical concept of the invention.

For example, numerical values, materials, configurations, locations, and so on, are not but mere examples, and any other appropriate numerical values, materials, configurations, locations, and so on, may be employed, if necessary.

Further, as the layer sandwiched by superlattice thin pieces, the ferroelectric system or giant magnetoresistance materials as the PrCaMnO system are usable in addition to $\pi$ electron conjugate organic molecular materials and biomolecular materials.

The concentrical structure itself can be made by other methods than the methods explained as the first to sixth embodiments. For example, it is possible to alternately form different substances on side surfaces by vacuum evaporation while rotating a rotation axis or alternately grow different substances on a columnar substrate by MOCVD, for example.

As materials for forming the concentrical structure, other materials than those used in the first to six embodiments may be used as well. As the dielectric material, inorganic substances such as oxides and organic substances such as polyethylene and polycarbonate may be used.

To bind ($\uparrow,\uparrow$) and ($\downarrow,\downarrow$), a structure having the property ($\downarrow,\uparrow$), i.e. a structure with discontinuous projection of time and isotropic spatial configuration, may be used in lieu of a structure having the property ($\uparrow,\downarrow$) already explained.

Brain-derived structures that make a category of top-down structures include tangible objects and intangible objects. The former are physical architectures including hardware having three-dimensional existence whereas the latter includes intellectual architectures such as intellectual academic systems, database, software, and so on. Gene-derived structures forming a category of bottom-up structures include not only structures of cell or tissue levels but also organs such as skeletons and internal organs.

Coupling and integration of a bottom-up system and a top-down system are not limited only to hardware in narrow sense, but applicable to various aspects where flows of two incompatible systems rejecting their direct coupling. For example, by carefully examining properties of both systems and identifying and extracting individual sets of incompatible properties ($\uparrow,\uparrow$) and ($\downarrow,\downarrow$), an intermediate layer (buffering strategy) having the property ($\uparrow,\downarrow$) can be inserted between them (if necessary, the operation can be repeated in mode of recurring formula and iteratively). Thereby, the invention can be used to function as a quasi-software scheme (a scheme on a business model or a service model) for matching between movements indwelling in and springing up from users or a mass of consumers (of a hierarchical bottom), such as build-up of markets, consumption trends, etc and rules or planning of business operations and administrations (of the hierarchical top) given downward from the top according to a predetermined plans.

Further, the concept of the invention can be extended to N component systems like ($x_1, x_2, ..., x_N$), and coupling of a plurality of components such as $x_i$ and $x_j$ is possible. In addition, $x_i$ need not be two values of $\uparrow,\downarrow$, and may be a many-valued (discrete) parameter.

The clean unit systems as the aforementioned the eighteenth to the twenty-seventh embodiments of the present invention are formed by disposing five types (Types A to E) of clean units equal in size to each other in a predetermined pattern and connecting them to each other. In the clean unit systems, however, the clean units of Types A to E may be different in size from each other. Otherwise, clean units equal in type to each other but different in size from each other may be used to form the clean unit system. Further, three or more types of clean units may be used together to build the clean unit system.

In the clean unit systems as the twentieth through the twenty-fourth embodiments, a three-dimensional connection may partially be adopted based on the freedom of vertical connection between the clean units. Also, the shield plate of the transfer box may be of a type using a gasket. Some of the clean units and transfer boxes may be constructed for resistance against a pressure or vacuum. In this case, the transfer box should desirably be designed to have an increased airtightness and have a pressure device or local exhaust unit provided therein. Also, the transfer box may not necessarily be linear but may be dog-legged, for example. Also, designing the transfer box to be connectable in three directions permits to dispose the clean units in a T pattern. Further, after the clean units are connected to each other, the sliding doors of all the transfer boxes may be opened and an automatic conveyor such as an elbowed conveyor be provided through the clean unit system.

As described above, the invention can achieve ultimate spatial resolution of one atomic layer in said devices by making access to the structure, in which time is continuously woven into, from the direction perpendicular to the direction in which the time is woven into. This situation is similar to the case when people unrolls and watches in facing in a two-dimensional plane (for example, in right and left direction) a drawing that has been rolled up.

The invention makes it possible to exploit the very best of bottom-up and top-down systems, and new high density memory and magnetic recording device can be realized.

As having been described in the foregoing, the present invention can provide a novel, higher-efficiency solar cell, photoelectric conversion device, light-emitting device and catalytic reaction apparatus.

As described above, according to the present invention, it is possible to realize a sophisticated functional device that can make the best use of advantages of a bottom-up system represented by a living organism and a top-down system represented by silicon LSI. That is, it is possible to realize a sophisticated functional device providing an artificial information transmission and control system corresponding to an associated neuron system between a bottom-up system corresponding to cells and a top-down system.

Furthermore, by using a structure that time is projected into continuously, it is possible to produce an artificial neuron system equivalent having the extreme resolution (control on the order of atomic layer). This in turn enables supermultiple parallel arrangement of nanostructures/zero-dimensional structures, which can perform surface strengthening effect, for example, over a bulk size.

Moreover, by creating a nanoscale discrete bulk-size system and coupling an LSI system formed on a silicon substrate and an autonomously dispersed system located closely, for example, a platform connecting a bottom-up system and a top-down system can be realized.

Further, by creating a nanoscale discrete bulk size system and obtaining a global size of two-dimensional to three-dimensional nanostructures appearing in the system and addressable locally and individually, a sophisticated platform that couples a microscopic world and a macroscopic world can be obtained. Furthermore, by synergetically coupling almost all nanoscale parallel new functional elements, which have no forms at present but will acquire forms, to existing ULSI systems, coupling the world of Silicon-base with organic world of Carbon-base, epoch-making increase of functions will be possible.

Moreover, the present invention makes it possible to realize a flexible functional device having the degree of integration 10~160 Gbits/cm$^2$ (0.1~1Tb/inch$^2$). For example, a ubiquitous information device in which the surface of a substance directly becomes functional devices can be realized. In this case, since the core portion of the functional device can be formed by lithography, the functional device can be manufactured at a low cost. If the number of elements is N, although conventional techniques needed positional alignment for N$^2$, the present invention needs positional alignment of 4N only, and alleviates the difficulty of positional alignment by 1/N as compared with the conventional difficulty. Moreover, this effect is enhanced with increase of the recording capacity.

Especially in the present invention of recording device that stores information at crosses, very high speed read out can be achieved by reading simultaneously the information written crosses aligned along a diagonal line.

In addition, the invention can provide a system of discrete substances represented by cellular automaton governed by difference equations, instead of a system of substances governed by differential equations. This system of substances can demonstrate modulated dimensions, connectivity, spontaneous break of symmetry, or self-organized critical phenomenon concerning a remarked nature, for example.

Nanotechnologies are expected to develop almost ad infinitum. However, matrix structures supporting nanotechnologies have a cutoff in terms of inter-atomic distance (endless miniaturization is not possible). Therefore, it is important to foresee their "point of convergence" (with certain accuracy), set the limit value and coupling with existing ULSI systems in straight sights from the present moment to start conquering from the viewpoint of preceding the era and acquiring expected fruits of future nanotechnologies that are figureless currently.

According to the present invention, the clean units (with the connectors) may be connected to each other in one of various patterns of disposition and with a large freedom of connection to implement a highly functional clean unit system permitting to easily provide a clean environment and advanced breeding environment without use of any large-scale clean room or plant factory requiring a large capital investment and on which a large fixed asset tax is imposed, maximize the total performance in all the respects of investment, working efficiency and efficiency of room space utilization by giving a solution to the low efficiency of space utilization of the conventional clean units that can be connected only linearly to each other to, and carry out processes correspondingly to a total series of on-target process flows, easily, with a high flexibility and at a lower cost. Also, since a clean unit system may be built from a minimum number of clean units of a minimum number of types used in a total range from upstream to downstream of a process, so the process efficiency can be maximized. Also, the present invention easily implements an advanced process environment without any degradation of the working efficiency.

Further, in producing a nano-technology device or carrying out a biotechnology process, at least part of a large box, namely, a clean room, ranging from the inlet to outlet, may be replaced with a plurality of super-clean clean units disposed in a loop or in a vertical polygonal line to improve the efficiency of space or area utilization.

Also, clean units of more than one type may be used to carry out a chemical process, non-chemical process, bio process and the like in one high-function clean unit system.

Also, the present invention permits to create a next-generation key structure such as a micro structure or make plant transformation by a less-demanding method higher in cost performance.

Also, the present invention permits plant breeding in a desired local environment as well as early-yield cultivation and cultivation of enriched vegetables and herbs.

Also, the present invention permits to build a consistent process line at a lower cost irrespectively of the performance of a room in which equipments are to be disposed. Thus, the present invention permits a venture business to enter the field of manufacture with a smaller capital investment. Also, the present invention permits a small or middle venture business having only a small fixed asset to provide an advanced nano-technology product and thus a nano-technology hardware industry to rise into power as a new industry like the IT software prosperity.

Also, the present invention permits to produce a novel and improved nano-technology device by a less-demanding method higher in cost performance (which is not any method of producing a high-technology device as an extension of the conventional one).

Also, according to the present invention, the clean unit system may be formed from clean units connected to each other and of which the cleanliness and degree of harmlessness are set for each of process elements to consistently perform element processes such as pre-processing, resist coating, baking, exposure, development, post-baking, etching, growth of thin film, metalization, surface observation, assembling, etc. in a highly clean environment.

Also, according to the present invention, each process may be taken as an element, each of the clean units or functional units may be given the function of the element process and the clean units or functional units be connected to each other corresponding to an intended purpose, to thereby form a total system which provides a high-efficiency nano-technology platform or biotechnology platform. Also, nano-technology process units and biotechnology process units may be mixed together or connected to each other to provide a nano-technology/biotechnology platform. In addition, plant factory units may be connected to each other.

Also, a process flow can be executed with a minimum number of clean units, maximum efficiency and without any clean unit by including subroutines and a concept such as branching in the process flow as in programming. Also, being likened to a computer program, a series of all or main ones of the processes from charging of a workpiece to output of a product lot can be performed in a full automatic manner.

Further, the present invention can provide an environment that can implement the nano-technology and biotechnology ubiquitously.

**Claims**

1.  A functional device comprising a slice having a periodic structure including a conductor layer and a non-metallic layer larger in thickness than the conductor layer, and upon which light is incident from a direction intersecting the slice.

2.  A functional device comprising a slice having a periodic structure including a conductor layer and a non-metallic layer larger in thickness than the conductor layer, and to at least part of which electrons are supplied in a direction intersecting the slice.

3.  A functional device formed from two slices each having a periodic structure including a conductor layer and a non-metallic layer larger in thickness than the conductor layer, wherein the two slices are superposed on each other so that the layers intersect each other; and
    edges of the conductor layer are opposite to each other with a predetermined functional material being laid between the edges.

4.  A functional device comprising a structure in which a plurality of conductor layers intersect each other with their edges being laid opposite to each other with a predetermined functional material being laid between them.

5.  A storage device formed from two slices each having a periodic structure including a conductor layer of over 0.2 nm and under 100 nm in thickness and a dielectric layer larger in thickness than the conductor layer, wherein the two slices are superposed on each other so that the layers intersect each other; and
    edges of the conductor layer are opposite to each other with a predetermined functional material being laid between the edges.

6.  A magnetic storage device comprising at least two slices having a periodic structure formed from an insulator layer and ferromagnetic layer, wherein the two slices are superposed on each other so that the layers intersect each other; and edges of the conductor layer are opposite to each other with a tunnel insulator layer of over 0.2 nm and under 10 nm in thickness being laid between them.

7. A solar cell comprising an anode and cathode shaped to have a spiral form and a semiconductor layer laid between them and which has a generally plate form.

8. A catalytic apparatus comprising at least a slice having a periodic structure formed from a metallic layer of over 0.5 nm and under 10 nm in thickness and a dielectric layer.

9. A photoelectric conversion device comprising a photoelectric conversion layer formed spiral or concentric to have the general form of a plate and upon which light is incident from a direction intersecting the plate, wherein the incident light that can be photoelectrically converted by the photoelectric conversion layer varies in wavelength stepwise and/or continuously in the direction of the plate thickness.

10. The photoelectric conversion device of claim 9, wherein the first and second electrodes are formed spiral or concentric with each other with the photoelectric conversion layer being laid between them.

11. The photoelectric conversion device of claim 9, wherein at least one of the first and second electrodes includes a plurality of electrodes provided being separated from each other in the direction of plate thickness.

12. The photoelectric conversion device of claim 9, wherein the wavelength of light that can be photoelectrically converted by the photoelectric conversion layer is increased stepwise in the direction of plate thickness from the light-incident surface of the plate; and
at least one of the first and second electrodes includes a plurality of electrodes provided being separated from each other in the direction of plate thickness.

13. The photoelectric conversion device of claim 9, wherein the photoelectric conversion layer is a p-n junction of a p-type semiconductor layer and n-type semiconductor layer.

14. The photoelectric conversion device of claim 13, wherein the p- and n-type semiconductor layers are formed from an inorganic or organic semiconductor of which the composition is graded in the direction of plate thickness.

15. The photoelectric conversion device of claim 13, wherein a bandgap between the p- and n-type semiconductor layers is decreased stepwise and/or continuously in the direction of plate thickness from the light-incident surface of the plate.

16. The photoelectric conversion device of claim 9, wherein the photoelectric conversion layer is shaped to have a circular, triangular or hexagonal form.

17. A light-emitting device comprising a light-emitting layer formed spiral or concentric.

18. The light-emitting device of claim 17, wherein the light-emitting layer has a plate-like shape.

19. The light-emitting device of claim 17, wherein first and second electrodes are formed spiral or concentric with each other with the light-emitting layer being laid between them.

20. A clean unit in which an active dust filter is used to keep a work chamber as a clean environment, wherein the cleanliness of the work chamber depends upon $1/\gamma$ where $\gamma$ is the dust collection efficiency of the dust filter.

**Fig. 1A**

S | D | S | D

G | G

IC PATTERN

S | D

G

**Fig. 1B**

VARIATION

IC PATTERN

TIME

SPACE
(STRUCTURE)

*Fig. 2A*

*Fig. 2B*

VARIATION

TIME

SPACE
(STRUCTURE)

# Fig. 3

# Fig. 4

# Fig. 5

VARIATION

TIME

SPACE
(STRUCTURE)

31

**Fig. 6A**

**Fig. 6B**

**Fig. 6C**

EP 1 804 300 A1

# Fig. 7

# Fig. 8A    Fig. 8B    Fig. 8C

# Fig. 9

Fig. 10A    Fig. 10B    Fig. 10C

Fig. 11

# Fig. 12

Fig. 13

Fig. 14

Fig. 15

# Fig. 16

# Fig. 17

EP 1 804 300 A1

Fig. 18

Fig. 19

EP 1 804 300 A1

**Fig. 20A**

**Fig. 20B**

$$Vl = +V2$$

$$Vr = -V1$$

TIME

*Fig. 21*

EX.1～1000 μm
(10～100 μm)

EP 1 804 300 A1

# Fig. 22

# Fig. 23B

# Fig. 23A

# Fig. 23C

EP 1 804 300 A1

Fig. 24A

Fig. 24B

Fig. 24C

## Fig. 25

EP 1 804 300 A1

# Fig. 26

EP 1 804 300 A1

Fig. 27B

SUPERLATTICE THIN PIECE

Fig. 27A

SUPERLATTICE THIN PIECE

# Fig. 28

116 115 116

115

EX.10 μm

EX.7nm

EX.25nm

62 62 62 62

# Fig. 29A

# Fig. 29B

126

123

122

126

EVAPORATION

125    126

124

FRONT VIEW

121

126

124

SIDE VIEW

EP 1 804 300 A1

EP 1 804 300 A1

**Fig. 30A**

132

131

**Fig. 30F**

131

133

**Fig. 30B**

132

131

**Fig. 30E**

133

131

ETCHING

**Fig. 30C**

↑ REMOVAL OF DIE

132

131

**Fig. 30D**

VACUUM EVAPORATION

133

131

# Fig. 31

POWER SUPPLY

EP 1 804 300 A1

# Fig. 32A     Fig. 32B     Fig. 32C

$Cu^+ + e^- \rightarrow Cu$ (REDUCTION REACTION)

$Cu \rightarrow Cu^+ + e^-$ (OXIDATION REACTION)

# Fig. 33A

# Fig. 33B

# Fig. 33C

EP 1 804 300 A1

# Fig. 34B

166
172
165
171
170

# Fig. 34A

172
166
161
162

TAKEN UP ROLL

RESIN-MADE TAPE ROLL

170
165
168
164
166
163

# Fig. 34C

171
169
165
167
164
163
170
168
166
172

## Fig. 35A

## Fig. 35B

## Fig. 35C

EP 1 804 300 A1

EP 1 804 300 A1

# Fig. 36

RESIN-MADE TAPE ROLL

Fig. 37

EP 1 804 300 A1

Fig. 38

# Fig. 39

71

# Fig. 40A

71

181
182 181

# Fig. 40B

181    182    181

0. 5nm~10nm

# Fig. 41A

71

INCOMING
RAW GAS

OUTGOING
MODIFIED GAS

# Fig. 41B

SURFACE CATALYTIC REACTION

GAS MOLECULE

182

Fig. 42A Fig. 42B Fig. 42C

**Fig. 43**

EP 1 804 300 A1

## Fig. 44

Fig. 45A

Fig. 45B

Fig. 45C

151  152
153

151  152
153

155

EP 1 804 300 A1

Fig. 46

EP 1 804 300 A1

**Fig. 47**

INCIDENT LIGHT

# Fig. 48

194

195—1
195—2
195—3

⋮

195—n—1
195—n

196

197—1
197—2

197—n—1
197—n

Fig. 49

EP 1 804 300 A1

# Fig. 50

**Fig. 51**

INCIDENT LIGHT

EP 1 804 300 A1

EP 1 804 300 A1

**Fig. 52A**

**Fig. 52C**

**Fig. 52B**

*Fig. 53A*

219

218

219

EP 1 804 300 A1

*Fig. 53C*

219    218    219

*Fig. 53B*

219

218

## Fig. 54A

UNIT INSIDE    UNIT OUTSIDE

220

219

220a

218

214

219

225

CONNECTING DIRECTION

226

224

222

223

221

## Fig. 54B

CONNECTING DIRECTION

214

218

219

222

226

222

221

EP 1 804 300 A1

# Fig. 55A

# Fig. 55B

EP 1 804 300 A1

# Fig. 56A

UNIT INSIDE    UNIT OUTSIDE

220

220a

225

226        237

224

223        235

234

# Fig. 56B

CONNECTING DIRECTION

236

237

235

235

234

EP 1 804 300 A1

Fig. 57A

Fig. 57C

Fig. 57B

# Fig. 58B

# Fig. 58A

# Fig. 59

# Fig. 60

# Fig. 61

EP 1 804 300 A1

# Fig. 62

# Fig. 63

Fig. 64A

Fig. 64B

Fig. 64C

Fig. 65A

Fig. 65B

Fig. 65C

# Fig. 66

## Fig. 67

# DESCRIPTION OF REFERENCE NUMERALS

| | |
|---|---|
| 141 | Cu film |
| 142 | Ti film |
| 143 | $Cu_2S$ film |
| 151 | anode electrode |
| 151-1~151-n | micro anode electrode |
| 152 | cathode electrode |
| 152-1~152-n | micro cathode electrode |
| 153 | organic semiconductor film |
| 154,155 | output electrode |
| 162 | resin-made base film |
| 181 | oxide film |
| 182 | metal film |
| 194 | center shaft |
| 195-1~195-n | p-contact layer |
| 196 | connector |
| 197-1~197-n | electrode |
| 211,251,1601 | work chamber |

## INTERNATIONAL SEARCH REPORT

| International application No. |
| --- |
| PCT/JP2005/017003 |

A. CLASSIFICATION OF SUBJECT MATTER
*H01L31/045*(2006.01), *H01L51/10*(2006.01), *H01L21/8246*(2006.01),
*H01L27/112*(2006.01), *G11C13/00*(2006.01)

According to International Patent Classification (IPC) or to both national classification and IPC

B. FIELDS SEARCHED

Minimum documentation searched (classification system followed by classification symbols)
*H01L31*(2006.01), *H01L51*(2006.01), *G02B5*(2006.01)

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho    1971-2006   Toroku Jitsuyo Shinan Koho   1994-2006

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 60-74685 A   (Toshiba Corp.), 26 April, 1985 (26.04.85), (Family: none) | 1 |
| Y | US 6340788 B   (King), 22 January, 2002 (22.01.02), & EP 1109230 A | 1 |
| X | JP 2000-329934 A   (Mitsui Chemicals, Inc.), 30 November, 2000 (30.11.00), (Family: none) | 1 |
| Y | JP 3-233501 A   (Copal Co., Ltd.), 17 October, 1991 (17.10.91), & JP 3-274506 A          & JP 3-274507 A & JP 4-7505 A            & US 5241417 A | 1 |

| ☒ | Further documents are listed in the continuation of Box C. | ☐ | See patent family annex. |

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search 19 January, 2006 (19.01.06) | Date of mailing of the international search report 31 January, 2006 (31.01.06) |
| --- | --- |
| Name and mailing address of the ISA/ Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2005/017003 |

C (Continuation). DOCUMENTS CONSIDERED TO BE RELEVANT

| Category* | Citation of document, with indication, where appropriate, of the relevant passages | Relevant to claim No. |
| --- | --- | --- |
| X | WO 03/069683 A (Sony Corp.),<br>21 August, 2003 (21.08.03),<br>& JP 2003-243686 A      & JP 2003-282910 A<br>& EP 1475842 A      & US 2005/0116143 A | 1 |
| X | EP 112029 A (Energy Conversion Devices),<br>09 November, 1983 (09.11.83),<br>& AU 2094983 A      & JP 59-99780 A<br>& BR 8306143 A      & US 4485264 A<br>& ES 282418 U      & CA 1212170 A<br>& MX 159088 A      & IN 165521 A<br>& KR 9106677 B | 1 |
| X | WO 02/084044 A (Lambey),<br>24 October, 2002 (24.10.02),<br>& FR 2823527 A      & CA 2443783 A<br>& EP 1379740 A      & US 2004/0055633 A<br>& JP 2004-523681 A | 1 |
| Y | DE 3700792 A (Hoegl),<br>21 July, 1988 (21.08.88),<br>& EP 275006 A      & JP 63-232467 A<br>& US 4913744 A | 1 |
| Y | US 5721462 A (Shanks),<br>24 February, 1998 (24.02.98),<br>(Family: none) | 1 |
| A | A. ISHIBASHI et al., "A crossroad where<br>Top-down meets Bottom-up", December, 2003,<br>Abstract of RIES Hokudai Symposium, Vol.5,<br>pages 44 to 45 | 1 |

Form PCT/ISA/210 (continuation of second sheet) (April 2005)

## INTERNATIONAL SEARCH REPORT

| International application No. |
|---|
| PCT/JP2005/017003 |

---

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III      Observations where unity of invention is lacking (Continuation of item 3 of first sheet)**

This International Searching Authority found multiple inventions in this international application, as follows:

```
See extra sheet.
```

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:   1

**Remark on Protest**
the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (April 2005)

**INTERNATIONAL SEARCH REPORT**

International application No.

PCT/JP2005/017003

Continuation of Box No.III of continuation of first sheet(2)

(1) This application has 19 claims including 11 independent claims
as follows:
claims 1, 2, 3, 4: function element
claim 5: storage element
claim 6: magnetic storage element
claim 7: solar cell
claim 8: catalyst reaction device
claims 9-16: photoelectric conversion element
claims 17-19: light emitting element
claim 20: clean unit

(2) The Description (p. 21-50) explains the following inventions:
first to fourth inventions: function element
fifth invention: storage element
sixth invention: magnetic storage element
seventh invention: solar cell
eighth invention: catalyst reaction device
ninth invention: photoelectric conversion element
tenth invention: light emitting element
eleventh, fourteenth, seventeenth, twentieth, twenty third, twenty
eighth, thirtieth, thirty second invention: function element
twelfth, fifteenth, eighteenth, twenty first, twenty fourth, thirty
third invention: function element manufacturing method
thirteenth, sixteenth, nineteenth, twenty second, twenty fifth,
thirty fourth invention: function system
twenty sixth, twenty seventh, twenty ninth, thirty first invention:
function material
thirty fifth invention: clean unit
thirty sixth to forty third, forty fifth to forty seventh invention;
clean unit system
forty fourth invention: element manufacturing method using the clean
unit system
Furthermore, the Description (p. 53 and after) describes first to
twenty seventh embodiments separately from the first to forty seventh
inventions given above.

(3) Accordingly, this application cannot appropriately grasp the
prior art for each of the claims (PCT Articles 5, 6, PCT Rule 5.1(ii),
PCT guideline 4.05), the technical problem of the invention (PCT Articles
5, 6, PCT Rule 5.1(iii), PCT guideline 4.06), support by embodiments
(PCT Articles 5, 6, PCT Rule 5.1(v), PCT guideline 4.10-4.13). This
disables recognition of the technical feature common to the claims (PCT
Rule 13.2, PCT guideline 10.01-10.10).

(4) As has been described above, it is impossible to appropriately
count the number of inventions. Accordingly, assuming the number of
the independent claims as the number of inventions, payment of additional
fee is required. The applicant has been asked to clarify the problem
(3) but no response has been received. Thus, only claim 1 has been
interpreted as the first invention.

Form PCT/ISA/210 (extra sheet) (April 2005)

## REFERENCES CITED IN THE DESCRIPTION

### Patent documents cited in the description

- JP 2000216499 A
- WO 0235616 A
- JP 3557442 B

### Non-patent literature cited in the description

- **R.R. LLINAS.** The Biology of the Brain. W.H. Freeman & Company, 1989, 94
- **S. WOLFRAM.** A New Kind of Science. Wolfram Media Inc, 2002, 51-81
- **P. NEMETHY ; P. ODDONE ; N. TOGE ; A. ISHIBASHI.** *Nuclear Instruments and Methods,* 1983, vol. 212, 273-280
- Lecture Symposium 2002 Spring ''The Forefront of Microscopic Vibration Spectroscopy. **FUTAMATA et al.** Lecture Papers. Spectroscopical Society of Japan, 20-23
- **A. ISHIBASHI.** MOCVD-grown Atomic Layer Superlattices, Spectroscopy of Semiconductor Microstructures. Plenum Press, 1989
- **SHIRO HARUYAMA.** Electrochemistry for Surface Engineers. Maruzen, 2001, 112
- New Development of Practical Polymeric Resist Materials, Their Applications as Photopolymers. CMC Shuppan, 1996
- **Y. CHEN ; D.A.A. OHLBERG ; X. LI ; D.R. STEWART ; R.S. WILLIAMS ; J.O. JEPPESEN ; K.A. NIELSEN ; J.F. STODDART ; D.L. OLYNICK ; E. ANDERSON.** Nanoscale Molecular Switch Devices Fabricated by Imprint Lithography. *Appl. Phys. Lett.,* 2003, vol. 82, 1610
- *Jpn. J. Appl. Phys.,* 2003, vol. 42, 1246-1249
- **D. J. FRIEDMAN ; J. F. GEISZ ; S. R. KURTZ ; J. M. OLSON.** *NREL/CP-520-23874,* July 1998